(19) Europäisches Patentamt
European Patent Office
Office européen des brevets

(11) EP 2 652 082 B1

(12) **EUROPÄISCHE PATENTSCHRIFT**

(45) Veröffentlichungstag und Bekanntmachung des Hinweises auf die Patenterteilung:
**20.12.2017 Patentblatt 2017/51**

(21) Anmeldenummer: **11788044.3**

(22) Anmeldetag: **17.11.2011**

(51) Int Cl.:
***C09K 11/06*** (2006.01) ***H01L 51/50*** (2006.01)
***H01L 51/00*** (2006.01) ***B82Y 10/00*** (2011.01)
***H01L 51/05*** (2006.01) ***H01L 51/42*** (2006.01)

(86) Internationale Anmeldenummer:
**PCT/EP2011/005803**

(87) Internationale Veröffentlichungsnummer:
**WO 2012/079673 (21.06.2012 Gazette 2012/25)**

(54) **ORGANISCHE ELEKTROLUMINESZENZVORRICHTUNG**
ORGANIC ELECTROLUMINESCENT DEVICE
DISPOSITIF ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.12.2010 DE 102010054525**

(43) Veröffentlichungstag der Anmeldung:
**23.10.2013 Patentblatt 2013/43**

(73) Patentinhaber: **Merck Patent GmbH**
**64293 Darmstadt (DE)**

(72) Erfinder:
- **PAN, Junyou**
  **60320 Frankfurt am Main (DE)**
- **SCHULTE, Niels**
  **65779 Kelkheim (DE)**

(56) Entgegenhaltungen:
**EP-A1- 2 348 314** **WO-A1-03/102109**
**DE-A1- 10 311 767** **GB-A- 2 415 960**
**JP-A- 2007 269 710** **US-A1- 2007 134 514**
**US-A1- 2010 133 992**

- **CHENG GANG ET AL: "White organic light-emitting devices using a phosphorescent sensitizer", APPLIED PHYSICS LETTERS, AIP, AMERICAN INSTITUTE OF PHYSICS, MELVILLE, NY, US, Bd. 82, Nr. 24, 16. Juni 2003 (2003-06-16) , Seiten 4224-4226, XP012034359, ISSN: 0003-6951, DOI: 10.1063/1.1584075**
- **VanAllan, Reynolds, et al: INSTITUTE OF ENERGY PROBLEMS OF CHEMICAL PHYSICS, RAS J. Org. Chem., vol. 27 1962, 1962, pages 1659-1664, Retrieved from the Internet: URL:http://webbook.nist.gov/cgi/cbook.cgi?Spec=C135671&Index=0&Type=UVVis&Large=on [retrieved on 2014-07-07]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung betrifft Verbindungen der allgemeinen Formel $(S-A)_n-T$ nach Anspruch 1, bei denen die Gruppe S über eine bivalente Gruppe A mit einer phosphoreszierenden Gruppe verknüpft ist, deren Verwendung in einer elektronischen Vorrichtung nach Anspruch 10, sowie eine Formulierung und eine elektronische Vorrichtung nach Anspruch 11, die die neuen Verbindungen enthalten.

Elektronische Vorrichtungen, welche organische, metallorganische und/oder polymere Halbleiter enthalten, werden immer häufiger in kommerziellen Produkten verwendet oder stehen kurz vor der Markteinführung. Als Beispiele seien hier Ladungstransportmaterialien auf organischer Basis (i. d. R. Lochtransporter auf Triarylamin-Basis) in Kopiergeräten und organische oder polymere Leuchtdioden (OLEDs oder PLEDs) in Anzeige- und Displayvorrichtungen oder organische Photorezeptoren in Kopierern genannt. Auch organische Solarzellen (O-SC), organische Feldeffekt-Transistoren (O-FET), organische Dünnfilm-Transistoren (O-TFT), organische Schaltelemente (O-IC), organische optische Verstärker oder organische Laserdioden (O-Laser) sind in einem fortgeschrittenen Entwicklungsstand und können in der Zukunft große Bedeutung erlangen.

Viele dieser elektronischen bzw. opto-elektronischen Vorrichtungen weisen unabhängig von dem jeweiligen Verwendungszweck folgenden allgemeinen Schichtaufbau auf, der für die jeweilige Anwendung angepasst werden kann:

(1) Substrat,
(2) Elektrode, häufig metallisch oder anorganisch, aber auch aus organischen bzw. polymeren leitfähigen Materialien;
(3) Ladungsinjektionsschicht bzw. Zwischenschicht zum Ausgleich von Unebenheiten der Elektrode ("planarisation layer"), häufig aus einem leitfähigen, dotierten Polymer,
(4) Organische Halbleiter,
(5) evtl. eine weitere Ladungstransport- bzw. Ladungsinjektions- bzw. Ladungsblockierschicht,
(6) Gegenelektrode, Materialien wie unter (2) genannt,
(7) Verkapselung.

Die obige Anordnung stellt den allgemeinen Aufbau einer optoelektronischen Vorrichtung dar, wobei verschiedene Schichten zusammengefasst werden können, so dass im einfachsten Fall eine Anordnung aus zwei Elektroden, zwischen denen sich eine organische Schicht befindet, resultiert. Die organische Schicht erfüllt in diesem Fall alle Funktionen, einschließlich der Emission von Licht. Ein derartiges System ist beispielsweise in der WO 9013148 A1 auf der Basis von Poly-(p-phenylenen) beschrieben.

Ein Problem, das sich in einem derartigen "Dreischichtsystem" ergibt, ist jedoch die fehlende Möglichkeit, die einzelnen Bestandteile in unterschiedlichen Schichten bezüglich ihrer Eigenschaften zu optimieren, wie es beispielsweise bei SMOLEDs ("small-molecule OLEDs") durch einen mehrschichtigen Aufbau einfach gelöst ist. Eine "small molecule OLED" besteht beispielsweise aus einer oder mehreren organischen Lochinjektionsschichten, Lochtransportschichten, Emissionsschichten, Elektronentransportschichten und Elektroneninjektionsschichten sowie einer Anode und einer Kathode, wobei sich das ganze System gewöhnlich auf einem Glassubstrat befindet. Ein Vorteil einer solchen Mehrlagenstruktur besteht darin, dass verschiedene Funktionen der Ladungsinjektion, des Ladungstransports und der Emission in die verschiedenen Schichten aufgeteilt und somit die Eigenschaften der jeweiligen Schichten separat modifiziert werden können.

Das Aufbringen der Schichten in SMOLED-Vorrichtungen erfolgt gewöhnlich durch Aufdampfen in einer Vakuumkammer. Dieses Verfahren ist jedoch aufwändig und somit teuer und insbesondere für große Moleküle, wie beispielsweise Polymere, aber auch für viele kleine Moleküle, die sich unter den Aufdampfbedingungen häufig zersetzen, ungeeignet.

Vorteilhaft ist deshalb die Aufbringung von Schichten aus Lösung, wobei sowohl kleine Moleküle, als auch Oligomere oder Polymere aus Lösung prozessiert werden können.

Im letzten Jahrzehnt kam es zu einer großen Leistungssteigerung hinsichtlich der Phosphoreszenz in SMOLEDs, insbesondere seit dem ersten Bericht von Forrest in Nature (London) (1998), 395, p. 151. Allerdings weisen OLEDs, die phosphoreszierende Emitterverbindungen enthalten, immer noch einige Nachteile auf. Ein Nachteil ist der sogenannte "Roll-off" Effekt. Wegen der sogenannten Triplett-Triplett-Annihilation sinkt die Effizienz der phosphoreszierenden Emission bei hohen Anregungsdichten. Deshalb sind fluoreszierende Emitterverbindungen bei vielen Anwendungen mehr erwünscht, bei denen eine hohe Helligkeit erforderlich ist. Das genannte Probleme konnte bisher durch sogenannte "Phosphorescence sensitized fluorescence" nur teilweise gelöst werden. Über ein erstes Beispiel für ein hocheffizientes fluoreszierendes SMOLED wurde von Forrest et al. in Nature (London) 403[6771], 750-753. (2000) berichtet, wobei ein Singulett-Emitter (DCM2) durch einen phosphoreszierenden Metallkomplex $Ir(ppy)_3$ in dem gleichen Host CPB aber in separaten Schichten sensibilisiert ist. Gewöhnlich wird angenommen, dass in diesem Fall ein Energietransfer zwischen dem Singulett-Emitter und dem phosphoreszierenden Metallkomplex nach dem Förster-Transfer-Mechanismus stattfindet.

Es ist besonderes erwünscht, diese Effekte auch in einer einzigen Schicht zu realisieren, insbesondere indem diese Schicht aus Lösung prozessiert wird.

Im herkömmlichen Verfahren zur OLED-Herstellung, sowohl durch Abscheidung aus der Gasphase oder lösungsprozessiert, ist es schwierig die Verteilung der einzelnen Komponenten zu kontrollieren. Die Komponenten verteilen sich gewöhnlich statistisch. Für einige physikalische Eigenschaften solcher Systeme ist dies unerwünscht, beispielsweise bei der "Phosphorescence sensitized fluorescence ". Hierbei wird auf ähnliche Weise wie beim sogenannten Förster-Energietransfer oder dem Dexter-Energietransfer Energie von der phosphoreszierenden Emitterverbindung auf die fluoreszierende Emitterverbindung übertragen.

Die Förster-Energietransferrate kann beispielsweise theoretisch nach folgender Gleichung dargestellt werden:

$$\Gamma_{DA} \propto 1/R^6,$$

wobei R den Abstand zwischen Donor und Akzeptor darstellt. Dieser Abstand wird gewöhnlich auch als der Förster-Radius bezeichnet. Um einen effizienten Energietransfer, z.B. gemäß Förster oder Dexter zu ermöglichen, ist es somit notwendig den Donor und Akzeptor, das heißt die beiden Verbindungen, die fluoreszierende Emitterverbindung und die phosphoreszierende Emitterverbindung, so nahe wie möglich zueinander zu positionieren, vorteilhafterweise innerhalb des sogenannten Förster-Radius.

Dadurch, dass sich die beiden Emitterverbindungen gewöhnlich statistisch verteilen, ist der notwendige geringe Abstand der beiden Emittermoleküle voneinander (Donor und Akzeptor) nicht im vollen Umfang gewährleistet.

Ein weiteres großes Problem bei lösungsbasierten SMOLEDs ist die Filmbildungseigenschaft. Häufig sind die verwendeten Materialien sehr gut löslich in einem Lösungsmittel und können beispielsweise durch Tintenstrahldruck auf das Substrat aufgebracht werden. Viele Materialien zeigen hierbei jedoch keine guten Filmbildungseigenschaften, verursacht durch die hohe Mobilität der kleinen Moleküle im Lösungsmittel.

US 2010/133992 A1 offenbart phosphoreszierende Polymere und deren Vorstufen, die aus einem phosphoreszierenden Metallkomplex und einem Phenoxazin aufgebaut sein können.

Die Aufgabe der vorliegenden Erfindung bestand deshalb in der Bereitstellung von neuen Verbindungen, bei denen zwei Moleküleinheiten den notwendigen geringen Abstand aufweisen, der für einen effizienten Energietransfer zwischen den Einheiten notwendig ist, so dass keine statistische Verteilung der beiden wechselwirkenden Einheiten in einer Schicht einer elektronischen Vorrichtung vorliegen kann.

Die vorliegende Erfindung stellt hierfür eine Verbindung der folgenden Formel (1) bereit:

(S-A)n-T Formel (1)

, wobei die verwendeten Symbole und Indices die folgende Bedeutung.
haben:

S ist bei jedem Auftreten unabhängig voneinander eine monovalente Gruppe, die eine absorbierende Gruppe, die als Farbstoff wirkt, umfasst;

T ist eine n-valente Gruppe, die eine phosphoreszierende Emittereinheit umfasst;

A stellt bei jedem Auftreten unabhängig voneinander eine kovalente Einfachbindung oder eine bivalente Einheit dar;

n ist eine ganze Zahl, die größer oder gleich 1 ist.

Unter einer phosphoreszierenden Emittereinheit wird eine Verbindung verstanden, die Lumineszenz aus einem angeregten Zustand mit höherer Spinmultiplizität (2S + 1) zeigt, wobei die Spinquantenzahl S größer oder gleich 1 ist, wie beispielsweise aus einem angeregten Triplett-Zustand (Triplett-Emitter, S = 1), aus einem MLCT-Mischzustand oder einem Quintett-Zustand (Quintett-Emitter, S = 2). Typischerweise zeigen phosphoreszierende Verbindungen auch längere Abklingzeiten der Lumineszenz im Vergleich zu fluoreszierenden Verbindungen. Als phosphoreszierende Emittereinheiten eignen sich insbesondere Verbindungen, die bei geeigneter Anregung Licht, vorzugsweise im sichtbaren Bereich, emittieren und außerdem mindestens ein Atom der Ordnungszahlen > 38 und < 84, besonders bevorzugt > 56 und < 80 enthalten. Bevorzugt werden als Phosphoreszenz-Emitter Verbindungen, die Kupfer, Molybdän, Wolfram, Rhenium, Ruthenium, Osmium, Rhodium, Iridium, Palladium, Platin, Silber, Gold oder Europium enthalten, insbesondere Verbindungen, die Iridium, Platin oder Kupfer enthalten. Beispiele der oben beschriebenen Emitter können den Anmeldungen WO 00/7065, WO 01/41512, WO 02/02714, WO 02/15645, EP 1191613, EP 1191612, EP 1191614, WO

05/033244 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind.

Die phosphoreszierende Emittereinheit ist vorzugsweise eine Metall-Ligand-Koordinationsverbindung. Es ist dabei bevorzugt, dass A an ein Atom eines Liganden der Metall-Ligand-Koordinationsverbindung T bindet. Hierbei ist vorzugsweise ein H-Atom eines Atoms des Liganden nicht vorhanden und das entsprechende Atom des Liganden bildet an dieser Stelle eine Verknüpfung zu der bivalenten Einheit A.

Die erfindungsgemäße Verbindung der Formel (1) weist durch die kovalente Verknüpfung der Gruppen S und T durch die bivalente Einheit A hervorragende Energietransferraten zwischen den zwei Zentren S und T auf.

Unter dem Begriff "Energietransfer" versteht man in der vorliegenden Erfindung einen physikalischen Prozess, bei dem Energie eines angeregten Farbstoffs (Donor) strahlungsfrei auf einen zweiten Farbstoff (Akzeptor) übertragen wird, wie beispielsweise beim sogenannten Förster-Transfer (siehe T. Förster, "Zwischenmolekulare Energiewanderung und Fluoreszenz", Ann. Physic. (1948) 437, 55) oder Dexter-Transfer (Siehe D. L. Dexter, J. Chem. Phys., (1953) 21, 836).

In einer bevorzugten Ausführungsform der vorliegenden Erfindung fungiert die Gruppe S als Donor, und die Gruppe T als Akzeptor im Sinne des genannten Energietransfers.

In einer weiter bevorzugten Ausführungsform der vorliegenden Erfindung fungiert die Gruppe S als Akzeptor, und die Gruppe T als Donor im Sinne des genannten Energietransfers.

Die Metall-Ligand-Koordinationsverbindung umfasst vorzugsweise ein Metall M, das ein Übergangsmetall, ein Hauptgruppenmetall oder eine Lanthanid ist. Wenn M für ein Hauptgruppenmetall steht, dann steht es bevorzugt für ein Metall der dritten, vierten oder fünften Hauptgruppe, insbesondere für Zinn. Ist M ein Übergangsmetall, dann steht es vorzugsweise für Ir, Ru, Os, Pt, Zn, Cu, Mo, W, Rh, Re, Au und Pd, ganz besonders bevorzugt Ru, Ir, Pt und Cu. Als Lanthanid ist Eu bevorzugt.

Bevorzugt sind Verbindungen gemäß Formel (1), in denen M für ein Übergangsmetall, insbesondere für ein tetrakoordiniertes, ein pentakoordiniertes oder ein hexakoordiniertes Übergangsmetall steht, besonders bevorzugt ausgewählt aus der Gruppe bestehend aus Chrom, Molybdän, Wolfram, Rhenium, Ruthenium, Osmium, Rhodium, Iridium, Nickel, Palladium, Platin, Kupfer, Silber und Gold, insbesondere Molybdän, Wolfram, Rhenium, Ruthenium, Osmium, Iridium, Platin, Kupfer und Gold. Ganz besonders bevorzugt sind Iridium und Platin. Die Metalle können dabei in verschiedenen Oxidationsstufen vorliegen. Bevorzugt sind dabei die oben genannten Metalle in den Oxidationsstufen Cr(0), Cr(II), Cr(III), Cr(IV), Cr(VI), Mo(0), Mo(II), Mo(III), Mo(IV), Mo(VI), W(0), W(II), W(III), W(IV), W(VI), Re(I), Re(II), Re(III), Re(IV), Ru(II), Ru(III), Os(II), Os(III), Os(IV), Rh(I), Rh(III), Ir(I), Ir(III), Ir(IV), Ni(0), Ni(II), Ni(IV), Pd(II), Pt(II), Pt(IV), Cu(I), Cu(II), Cu(III), Ag(I), Ag(II), Au(I), Au(III) und Au(V); ganz besonders bevorzugt sind Mo(0), W(0), Re(I), Ru(II), Os(II), Rh(III), Ir(III), Pt(II) und Cu(I), insbesondere Ir(III) und Pt(II).

In einer bevorzugten Ausführungsform der Erfindung ist M ein tetrakoordiniertes oder ein hexakoordiniertes Metall.

Die Liganden der Metall-Ligand-Koordinationsverbindung sind vorzugsweise mono-, bi-, tri-, tetra-, penta- oder hexadentate Liganden.

Wenn M ein hexakoordiniertes Metall ist, so bestehen in Abhängigkeit von der Anzahl m der Liganden folgende koordinativen Möglichkeiten:

m = 2: M ist mit zwei tridentaten Liganden oder mit einem tetradentaten und einem bidentaten Liganden oder mit einem pentadentaten und einem monodentaten Liganden koordiniert;

m = 3: M ist mit drei bidentaten Liganden oder mit einem tridentaten, einem bidentaten und einem monodentaten Liganden oder mit einem tetradentaten und zwei monodentaten Liganden koordiniert;

m = 4: M ist mit zwei bidentaten und zwei monodentaten Liganden oder einem tridentaten und drei monodentaten Liganden koordiniert;

m = 5: M ist mit einem bidentaten und vier monodentaten Liganden koordiniert;

m = 6: M ist mit 6 monodentaten Liganden koordinert.

Besonders bevorzugt ist es, wenn M ein hexakoordiniertes Metall, m = 3 und die Liganden jeweils bidentate Liganden sind.

Wenn M ein tetrakoordiniertes Metall ist, so ist die Zähnigkeit der Liganden in Abhängigkeit von m, das die Anzahl der Liganden angibt, folgendermaßen:

m = 2: M ist mit zwei bidentaten Liganden oder mit einem tridentaten und einem monodentaten Liganden koordiniert;

m = 3: M ist mit einem bidentaten und zwei monodentaten Liganden koordiniert;

m = 4: M ist mit vier monodentaten Liganden koordiniert.

Besonders bevorzugt ist es, wenn M ein tetrakoordiniertes Metall, m = 2 und die Liganden bidentate Liganden sind.

Die Liganden der Metall-Ligand-Koordinationsverbindung sind bevorzugt neutrale, monoanionische, dianionische oder trianionische Liganden, besonders bevorzugt neutrale oder monoanionische Liganden. Sie können monodentat, bidentat, tridentat, tetradentat pentadentat oder hexadentat sein, und sind bevorzugt bidentat, weisen also bevorzugt zwei Koordinationsstellen auf.

Des Weiteren ist es erfindungsgemäß bevorzugt, wenn jeweils mindestens ein Ligand der Metall-Ligand-Koordinationsverbindung ein bidentater Ligand ist.

Bevorzugte neutrale, monodentate Liganden der Metall-Ligand-Koordinationsverbindung sind ausgewählt aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden der Metall-Ligand-Koordinationsverbindung sind ausgewählt aus Hydrid, Deuterid, den Halogeniden $F^-$, $Cl^-$, $Br^-$ und $I^-$, Alkylacetyliden, wie z. B. Methyl-$C\equiv C^-$, tert-Butyl-$C\equiv C^-$, Arylacetyliden, wie z. B. Phenyl-$C\equiv C^-$, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, tert-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt $C_1$-$C_{20}$-Alkylgruppen, besonders bevorzugt $C_1$-$C_{10}$-Alkylgruppen, ganz besonders bevorzugt $C_1$-$C_4$-Alkylgruppen. Unter einer Arylgruppe werden auch Heteroarylgruppen verstanden. Diese Gruppen sind wie unten definiert.

Bevorzugte di- bzw. trianionische Liganden der Metall-Ligand-Koordinationsverbindung sind $O^{2-}$, $S^{2-}$, Carbide, welche zu einer Koordination der Form R-C=M führen, Nitrene, welche zu einer Koordination der Form R-N=M führen, wobei R allgemein für einen Substituenten steht, und $N^{3-}$.

Bevorzugte neutrale oder mono- oder dianionische, bidentate oder höherdentate Liganden der Metall-Ligand-Koordinationsverbindung sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2[1-(Phenylimino)ethyl]pyridin, 2[1-(2-Methylphenylimino)ethyl]pyridin, 2[1-(2,6-Di-*iso*-propylphenylimino)ethyl]pyridin, 2[1-(Methylimino)ethyl]pyridin, 2[1-(ethylimino)-ethyl]pyridin, 2[1-(*Iso*-Propylimino)ethyl]pyridin, 2[1-(*Tert*-Butylimino)ethyl]-pyridin, Diminen, wie z. B. 1,2-Bis(methylimino)ethan, 1,2-Bis(ethylimino)-ethan, 1,2-Bis(*iso*-propylimino)ethan, 1,2-Bis(*tert*-butylimino)ethan, 2,3-Bis(methylimino)butan, 2,3-Bis(ethylimino)butan, 2,3-Bis(*iso*-propyl-imino)butan, 2,3-Bis(*tert*-butylimino)butan, 1,2-Bis(phenylimino)ethan, 1,2-Bis(2-methylphenylimino)ethan, 1,2-Bis(2,6-di-*iso*-propylphenylimino)-ethan, 1,2-Bis(2,6-di-*tert*-butylphenylimino)ethan, 2,3-Bis(phenylimino)-butan, 2,3-Bis(2-methylphenylimino)butan, 2,3-Bis(2,6-di-*iso*-propylphenyl-imino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenyl-phosphino)ethan, Bis(diphenylphosphino)propan, Bis(diphenylphos-phino)butan, Bis(dimethylphosphino)methan, Bis(dimethylphosphino)-ethan, Bis(dimethylphosphino)propan, Bis(diethylphosphino)methan, Bis-(diethylphosphino)ethan, Bis(diethylphosphino)propan, Bis(di-*tert*-butyl-phosphino)methan, Bis(di-*tert*-butylphosphino)ethan, Bis(*tert*-butyl-phosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugte tridentate Liganden sind Borate stickstoffhaltiger Heterocyclen, wie z. B. Tetrakis(1-imidazolyl)borat und Tetrakis(1-pyrazolyl)borat.

Bevorzugt sind weiterhin bidentate monoanionische Liganden der Metall-Ligand-Koordinationsverbindung, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann weitere derartige Liganden auswählen. Generell eignet sich dafür besonders die Kombination aus zwei Gruppen, wie sie durch die folgenden Formeln (2) bis (29) dargestellt sind, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet. Der Ligand der Metall-Ligand-Koordinationsverbindung kann dann aus den Gruppen der Formeln (2) bis (29) gebildet werden, indem diese Gruppen jeweils an der durch # gekennzeichneten Position aneinander binden. Die Position, an der die Gruppen an das Metall koordinieren, sind durch * gekennzeichnet.

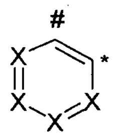
Formel (2)

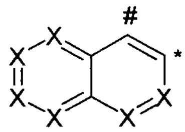
Formel (3)

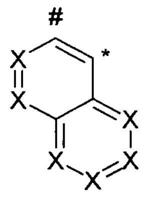
Formel (4)

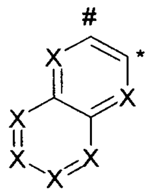
Formel (5)

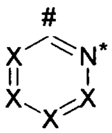
Formel (6)

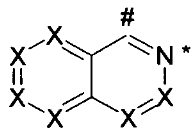
Formel (7)

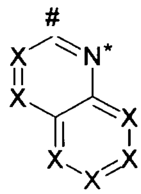
Formel (8)

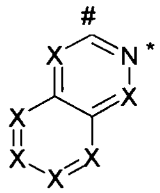
Formel (9)

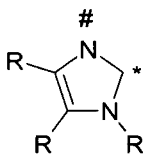
Formel (10)

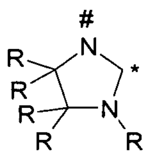
Formel (11)

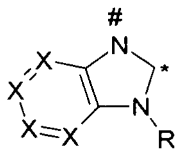
Formel (12)

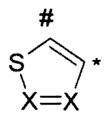
Formel (13)

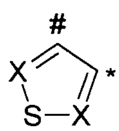
Formel (14)

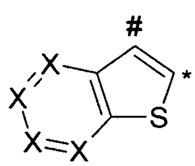
Formel (15)

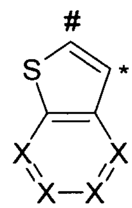
Formel (16)

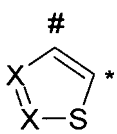
Formel (17)

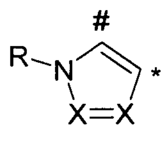
Formel (18)

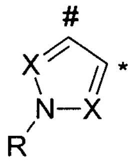
Formel (19)

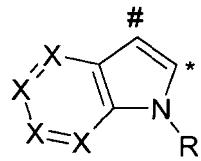
Formel (20)

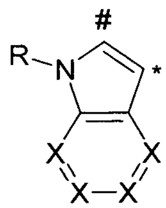
Formel (21)

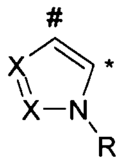
Formel (22)

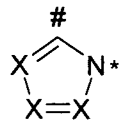
Formel (23)

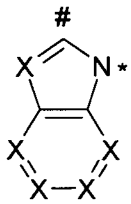
Formel (24)

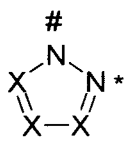
Formel (25)

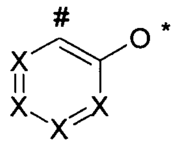
Formel (26)

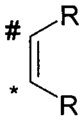
Formel (27)

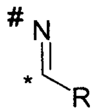
Formel (28)

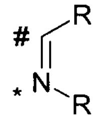
Formel (29)

Dabei ist R bei jedem Auftreten gleich oder verschieden aus der Gruppe ausgewählt, die aus Alkyl(en), Cycloalkyl(en), Alkylsilyl(en), Silyl(en), Arylsilyl(en), Alkylalkoxyalkyl(en), Arylalkoxyalkyl(en), Alkylthioalkyl(en), Phosphin, Phosphinoxid, Sulfon, Alkylensulfon, Sulfoxid und Alkylensulfoxid besteht, wobei die Alkyl(en)gruppe jeweils unabhängig voneinander 1 bis 12 C-Atome aufweist und wobei ein oder mehrere H-Atome durch F, Cl, Br, I, Alkyl oder Cycloalkyl, wobei ein oder mehrere $CH_2$ durch ein Heteroatom, wie NH, O oder S, ersetzt sein können, oder einem aromatischen oder heteroaromatischen Kohlenwasserstoffrest mit 5 bis 20 aromatischen Ringatomen ersetzt sein können. X steht für N oder CH. Besonders bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CH.

Ebenfalls bevorzugte Liganden sind $\eta^5$-Cyclopentadienyl, $\eta^5$-Pentamethyl-cyclopentadienyl, $\eta^6$-Benzol oder $\eta^7$-Cycloheptatrienyl, welche jeweils durch einen oder mehrere Reste R substituiert sein können.

Ebenfalls bevorzugte Liganden sind 1,3,5-cis-Cyclohexanderivate, insbesondere der Formel (30), 1,1,1-Tri(methylen)methanderivate, insbesondere der Formel (31) und 1,1,1-trisubstituierte Methane, insbesondere der Formel (32) und (33),

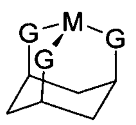
Formel (30)

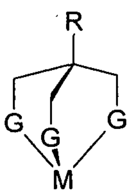
Formel (31)

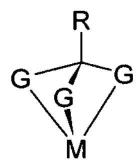
Formel (32)

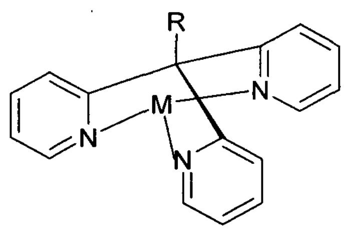
Formel (33)

wobei in den Formeln jeweils die Koordination an das Metall M dargestellt ist, R die oben genannte Bedeutung hat und G, gleich oder verschieden bei jedem Auftreten, für $O^-$, $S^-$, $COO^-$, $P(R)_2$ oder $N(R)_2$ steht.

Die Metall-Ligand-Koordinationsverbindung T kann ein anionischer oder kationischer Komplex sein, ist vorzugsweise aber ein neutraler Komplex, so dass die Verbindung der Formel (1) eine neutrale Verbindung ist, d.h. die Wertigkeit des Metalls M und die Wertigkeit der Liganden der Metall-Ligand-Koordinationsverbindung wird so gewählt, dass sich die Ladung innerhalb einer jeden Koordinationsverbindung ausgleicht.

T ist vorzugsweise ein Donor, vorzugsweise ausgewählt aus der Gruppe von Verbindungen enthaltend die folgenden Liganden

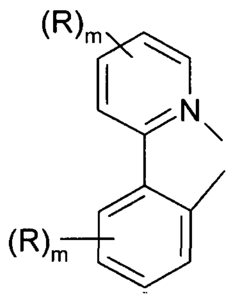

Formel (34)

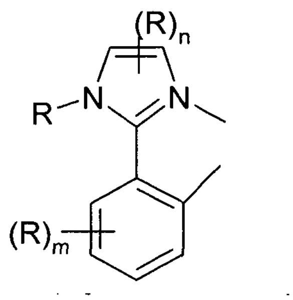

Formel (34a)

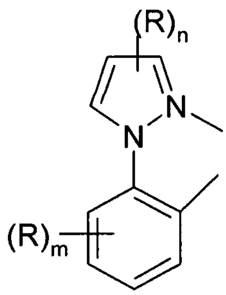

Formel (35)

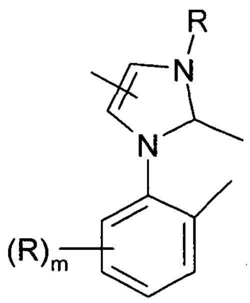

Formel (35a)

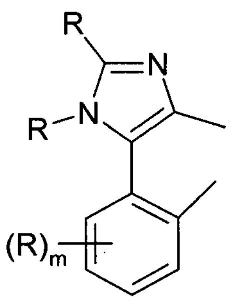

Formel (36)

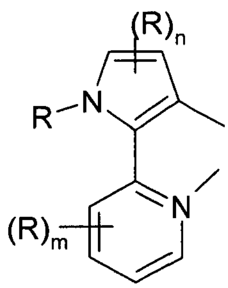

Formel (36a)

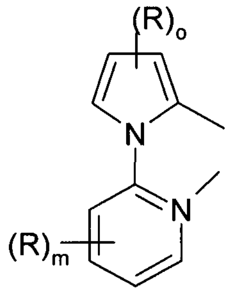

Formel (37)

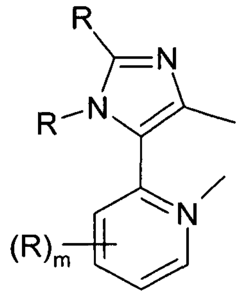

Formel (37a)

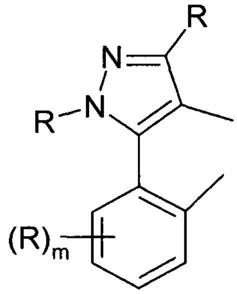

Formel (38)

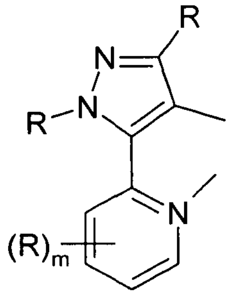

Formel (38a)

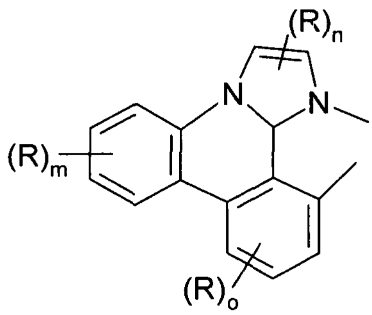

Formel (39)

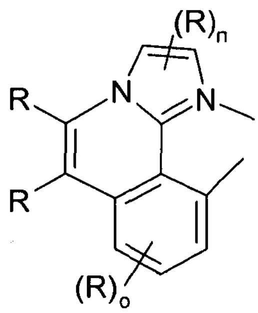

Formel (39a)

wobei:

- R gleich oder verscheiden bei jedem Auftreten ist und die gleiche Bedeutung hat wie der Rest R der Verbindung der Formel (10);
- m ist bei jedem Auftreten unabhängig voneinander 0, 1, 2, 3 oder 4;
- n ist bei jedem Auftreten unabhängig voneinander 0, 1, oder 2;
- o ist bei jedem Auftreten unabhängig voneinander 0, 1, 2 oder 3.

Ganz besonders bevorzugt für die Gruppe T aus der Verbindung der Formel (1) sind die Verbindung aus der Gruppe, die aus den folgenden Einheiten besteht, die gegebenenfalls weiter mit einem oder mehreren Resten R substituiert sein können, wobei die Reste R gleich oder verschieden sein können und die für die Verbindung mit der Formel (10) angegebene Bedeutung haben.

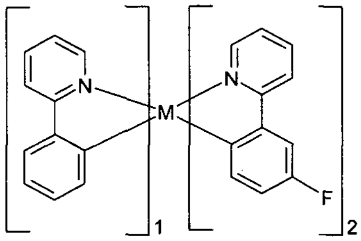

Formel (39b)

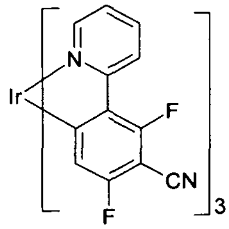

Formel (39c)

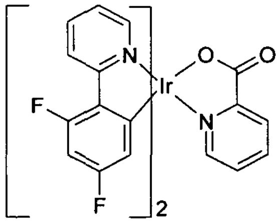

Formel (39d)

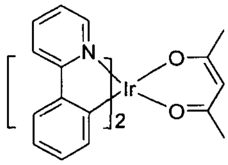

Formel (39e)

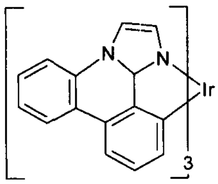

Formel (39f)

,

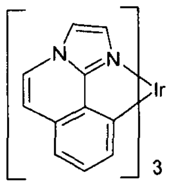

Formel (39g)

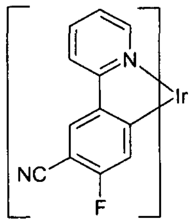

Formel (39h)

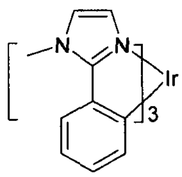

Formel (39i)

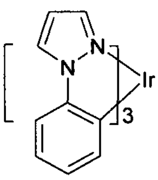

Formel (39j)

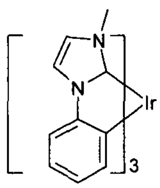

Formel (39k)

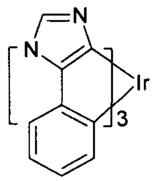

Formel (39l)

In einer weiteren Ausführungsform der vorliegenden Erfindung ist die Gruppe T in der Verbindung der Formel (1) eine Metall-Ligand-Koordinationsverbindung, die als Farbstoff fungiert, und zwar insbesondere als Donor im Sinne des genannten Energietransfers. Generell eignen sich alle Farbstoff-Metall-Ligand-Koordinationsverbindungen, wie sie gemäß dem Stand der Technik für sogenannte "dyesensitized solar cells (DSSCs)" verwendet werden und wie sie dem Fachmann auf dem Gebiet der DSSCs bekannt sind. Diese Farbstoffe sind vorzugsweise ausgewählt aus der Gruppe bestehend aus Polypyridyl-Komplexen von Übergangsmetallen, ganz bevorzugt solche enthaltend Ruthenium, Osmium und Kupfer. In einer weiteren bevorzugten Ausführungsform der vorliegenden Erfindung hat der Farbstoff, der ein Metallkomplex ist, die allgemeine Formel $ML^2(X)_2$, wobei L bevorzugt ausgewählt ist aus der Gruppe bestehend aus 2,2'-Bipyridyl-4,4'-dicarbonsäuren und wobei M ein Übergangsmetall ist, das bevorzugt ausgewählt ist aus der Gruppe bestehend aus Ru, Os, Fe, V and Cu und wobei X ausgewählt ist aus der Gruppe bestehend aus Halogeniden, Cyaniden, Thiocyanaten, Acetylacetonaten, Thiacarbamaten oder Wasser-Substituenten. Solche Metallkomplexe sind beispielsweise in J. Phys. Chem. C 09, 113, 2966-2973, US 2009/000658, WO 2009/107100, WO 2009/098643, US 6245988, WO 2010/055471, JP 2010-084003, EP 1622178, WO 98/50393, WO 95/29924, WO 94/04497, WO 92/14741, WO 91/16719 offenbart.

Beispiele für bevorzugte phosphoreszierende Emittereinheiten sind in der folgenden Tabelle aufgeführt:

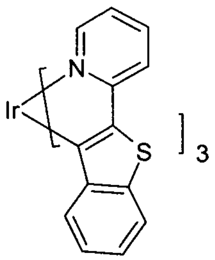

Formel (40)

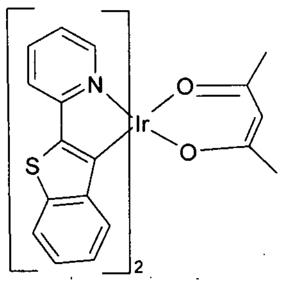

Formel (41)

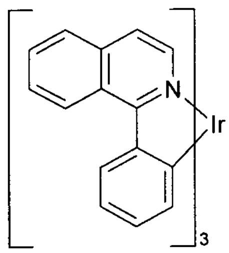

Formel (42)

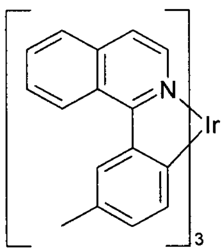

Formel (43)

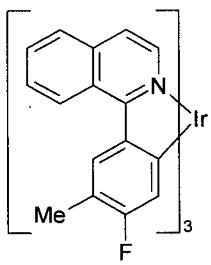

Formel (44)

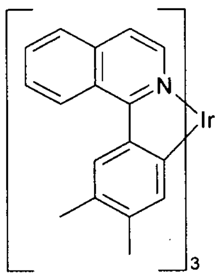

Formel (45)

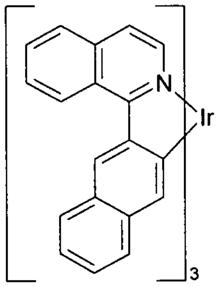

Formel (46)

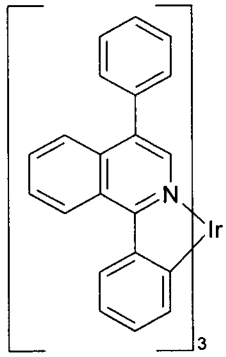

Formel (47)

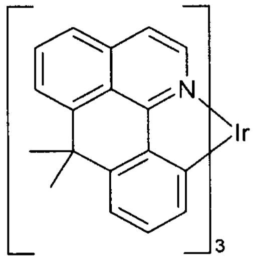

Formel (48)

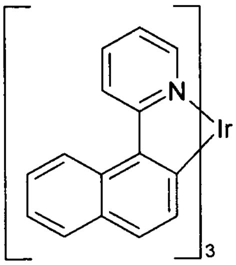

Formel (49)

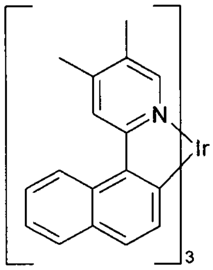

Formel (50)

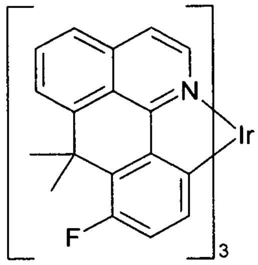

Formel (51)

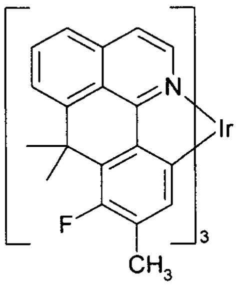

Formel (52)

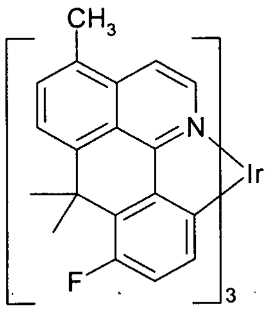

Formel (53)

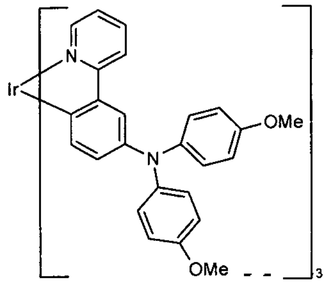

Formel (54)

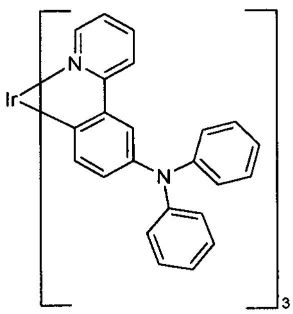

Formel (55)

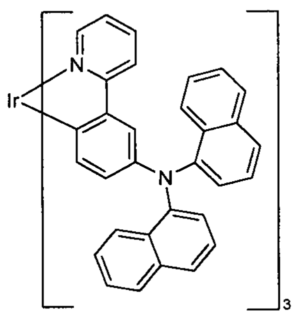

Formel (56)

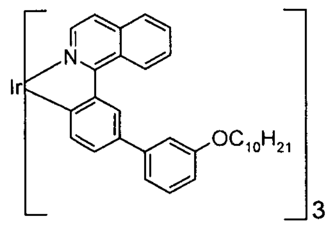

Formel (57)

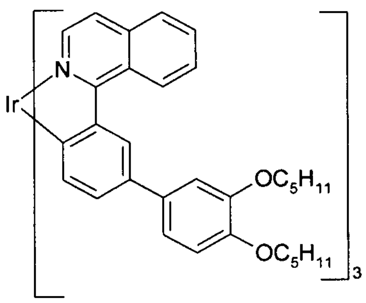

Formel (58)

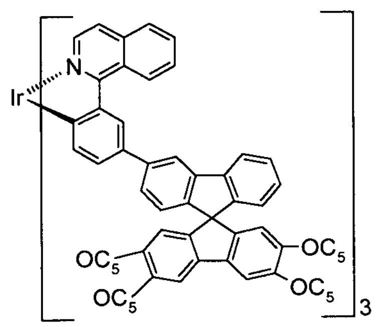

Formel (59)

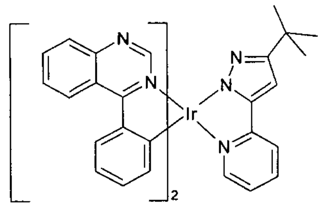

Formel (60)

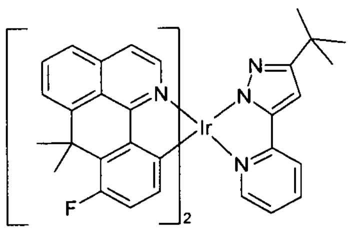

Formel (61)

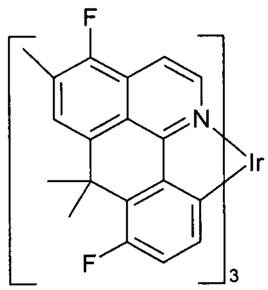

Formel (62)

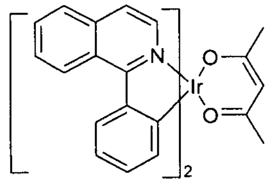

Formel (63)

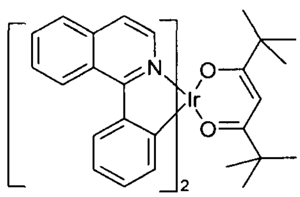

Formel (64)

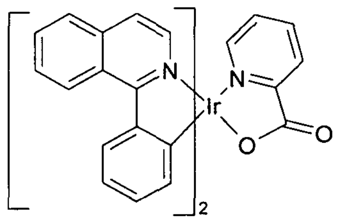

Formel (65)

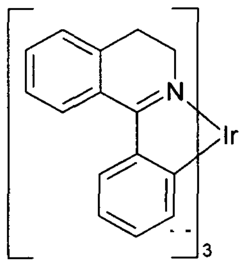

Formel (66)

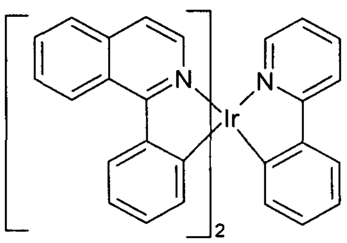

Formel (67)

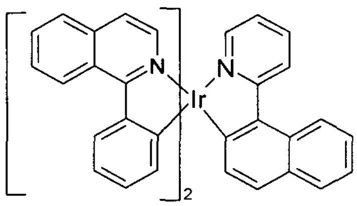

Formel (68)

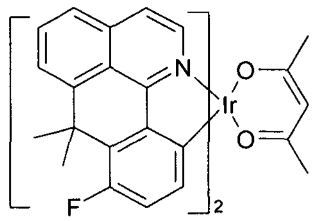

Formel (69)

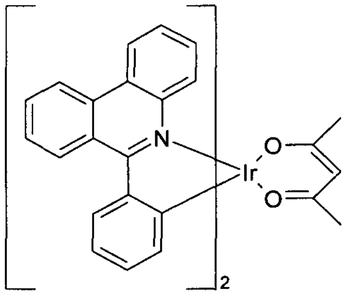

Formel (70)

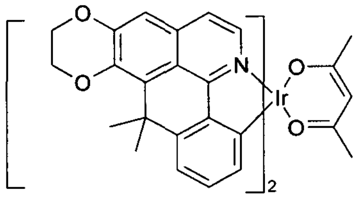

Formel (71)

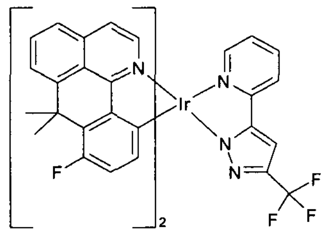

Formel (72)

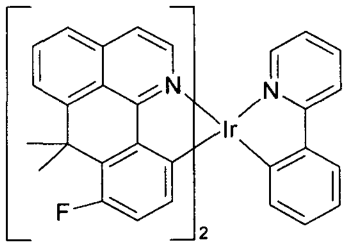

Formel (73)

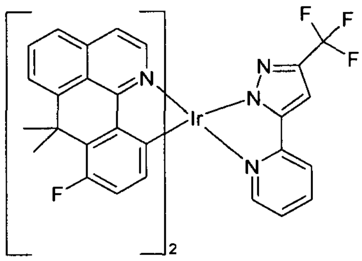

Formel (74)

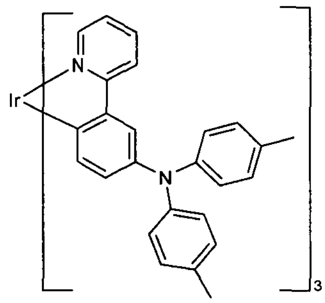

Formel (75)

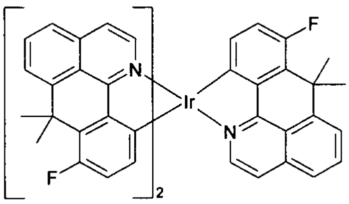

Formel (76)

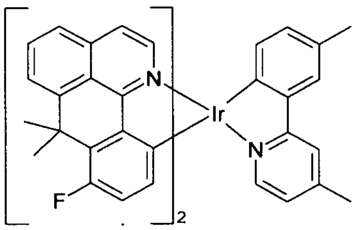

Formel (77)

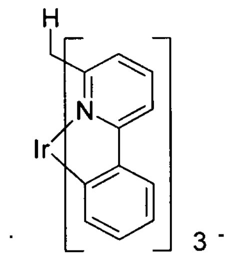

Formel (78)

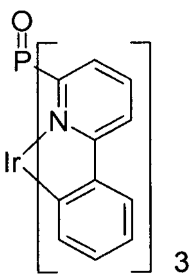

Formel (79)

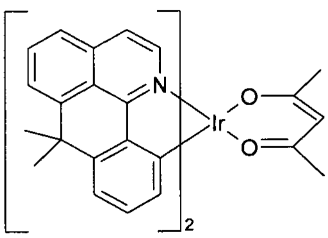

Formel (80)

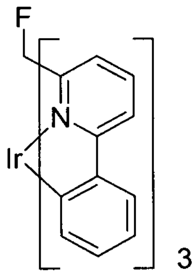

Formel (81)

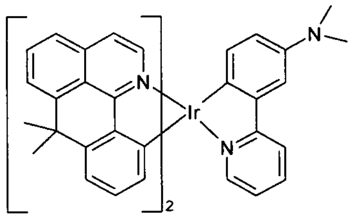

Formel (82)

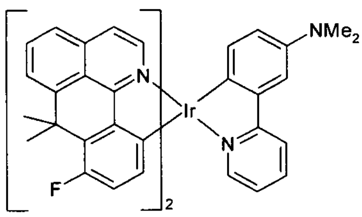

Formel (83)

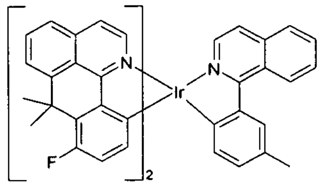

Formel (84)

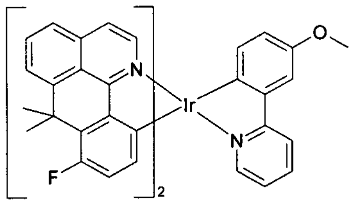

Formel (85)

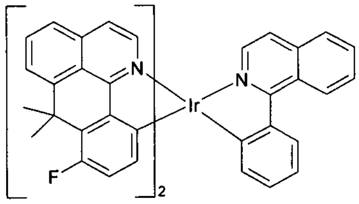

Formel (86)

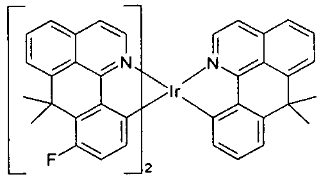

Formel (87)

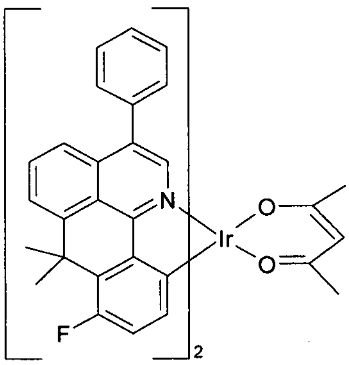

Formel (88)

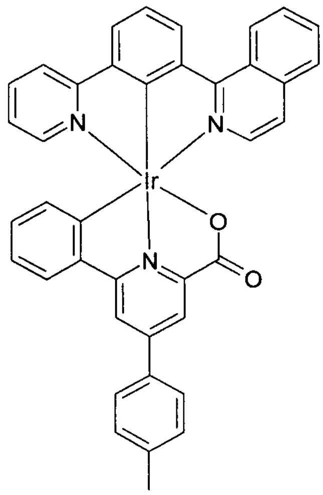

Formel (89)

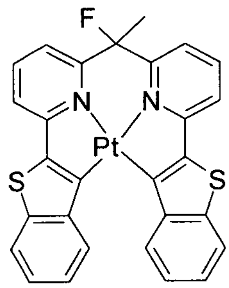

Formel (90)

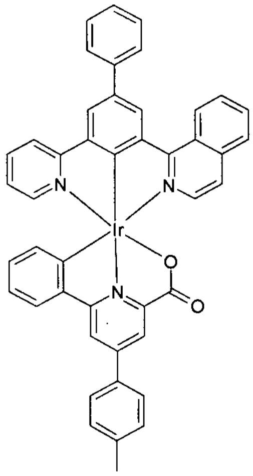

Formel (91)

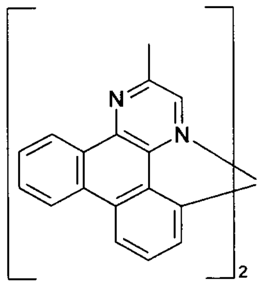

Formel (92)

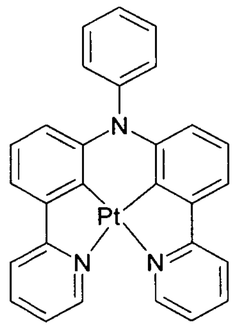

Formel (93)

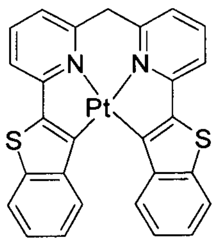

Formel (94)

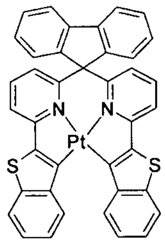

Formel (95)

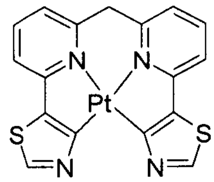

Formel (96)

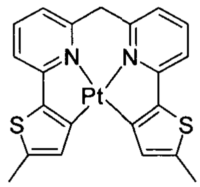

Formel (97)

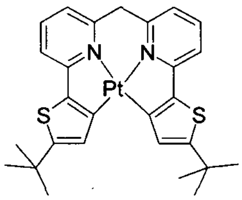

Formel (98)

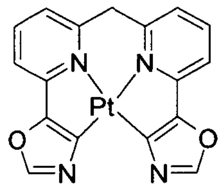

Formel (99)

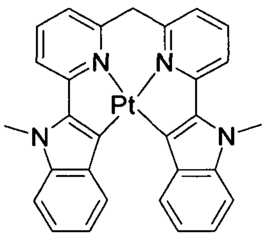

Formel (100)

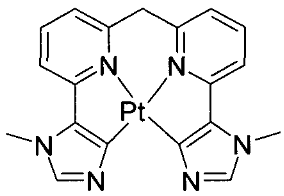

Formel (101)

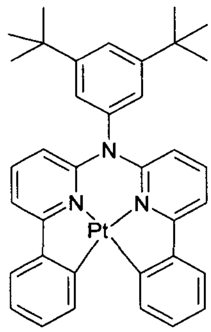

Formel (102)

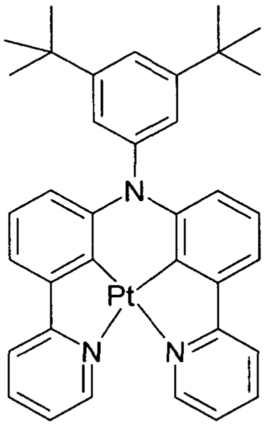

Formel (103)

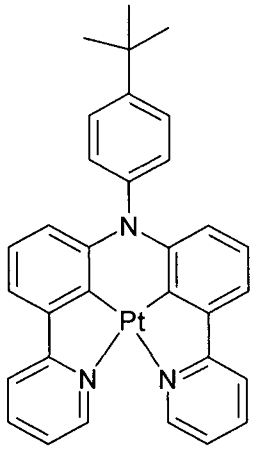

Formel (104)

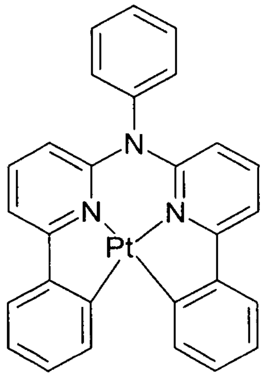

Formel (105)

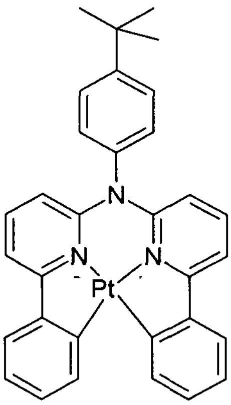

Formel (106)

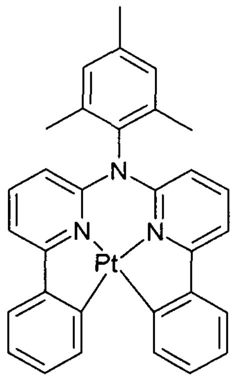

Formel (107)

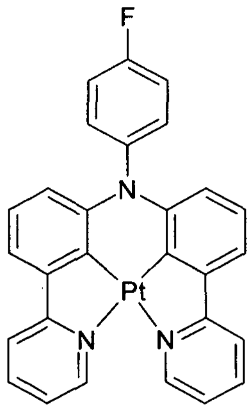

Formel (108)

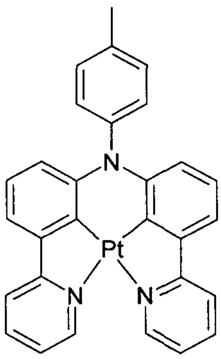

Formel (109)

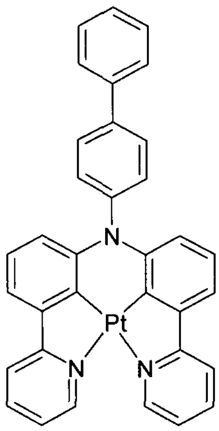

Formel (110)

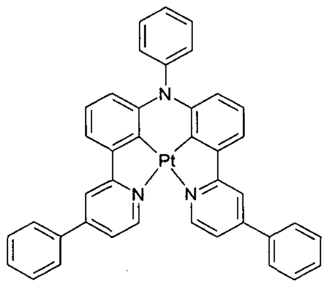

Formel (111)

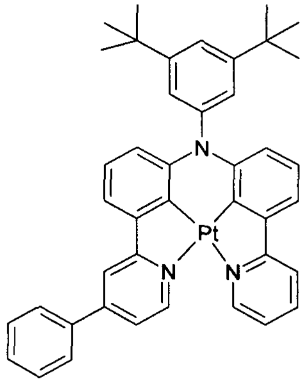

Formel (112)

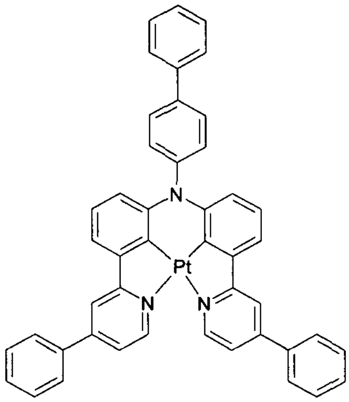

Formel (113)

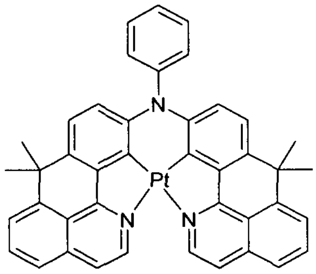

Formel (114)

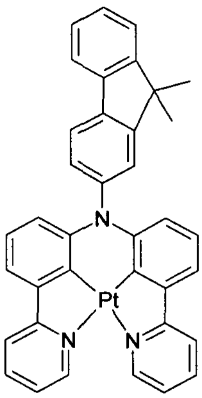

Formel (115)

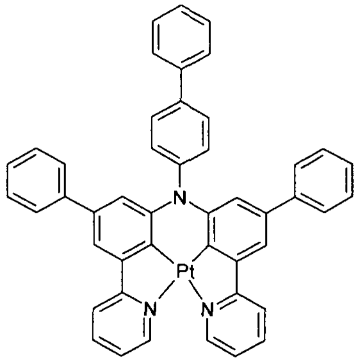

Formel (116)

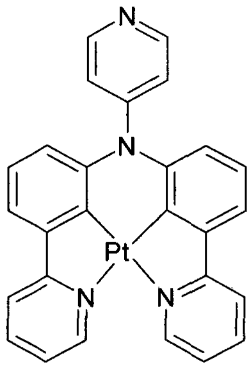

Formel (117)

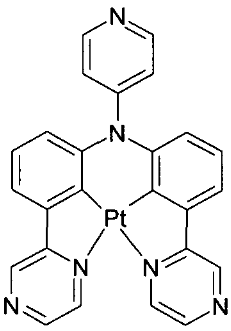

Formel (118)

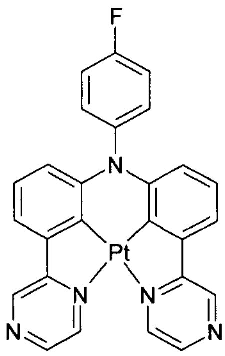

Formel (119)

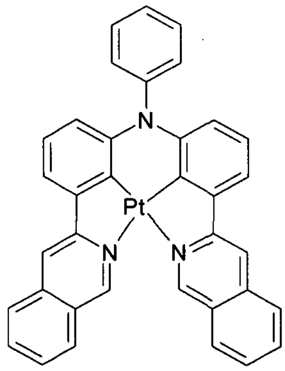

Formel (120)

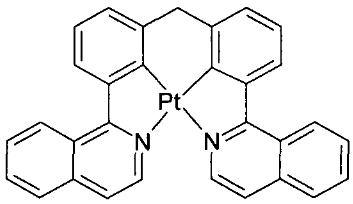

Formel (121)

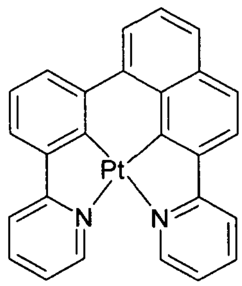

Formel (122)

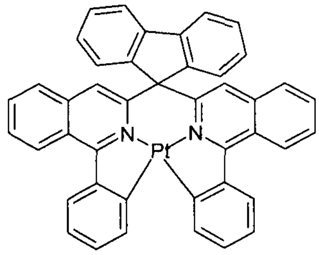

Formel (123)

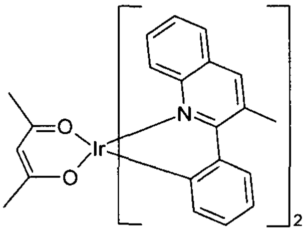

Formel (124)

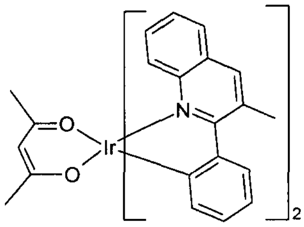

Formel (125)

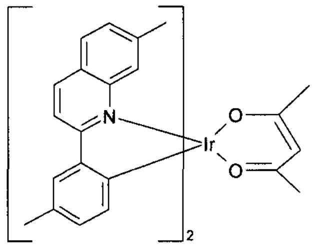

Formel (126)

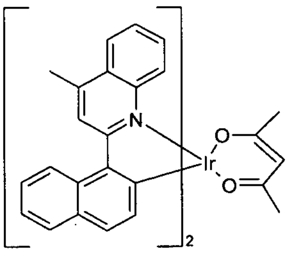

Formel (127)

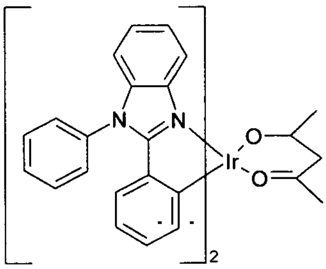

Formel (128)

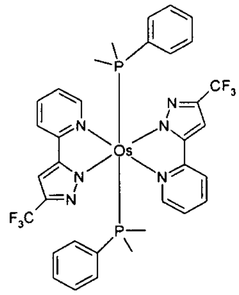

Formel (129)

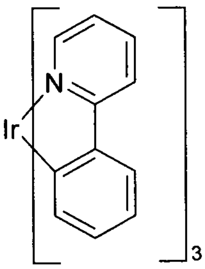

Formel (130)

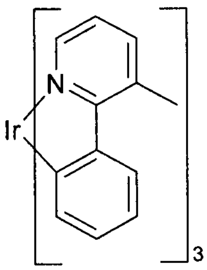

Formel (131)

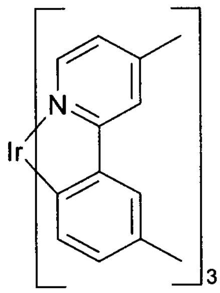

Formel (132)

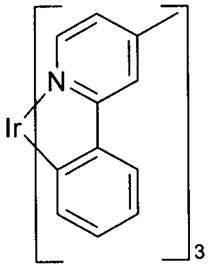

Formel (133)

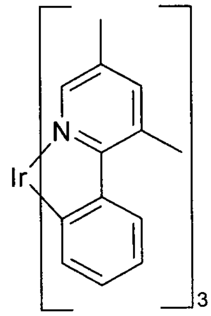

Formel (134)

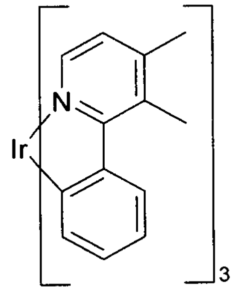

Formel (135)

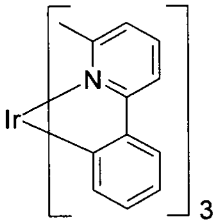

Formel (136)

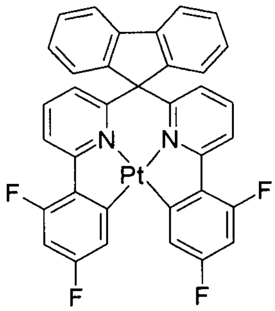

Formel (137)

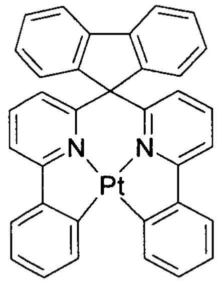

Formel (138)

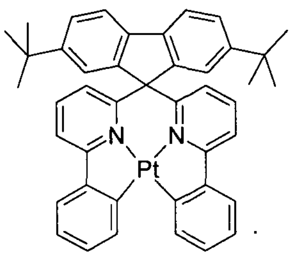

Formel (139)

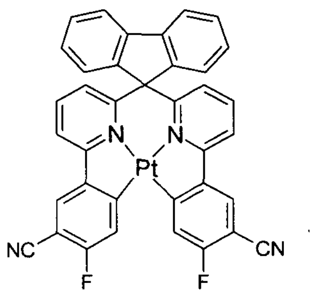

Formel (140)

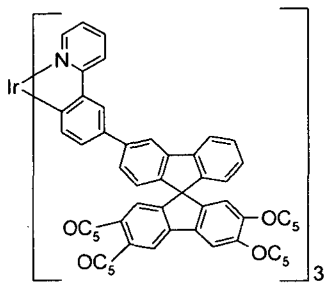

Formel (141)

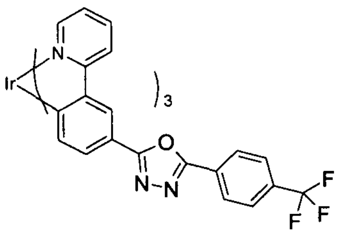

Formel (142)

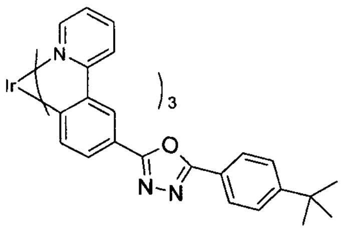

Formel (143)

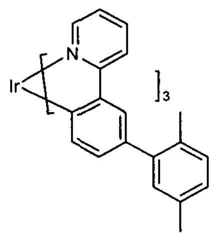

Formel (144)

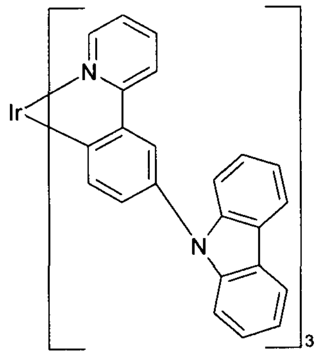

Formel (145)

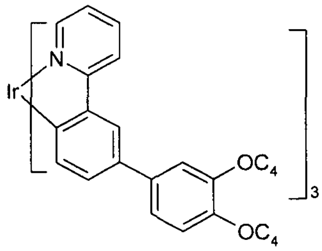

Formel (146)

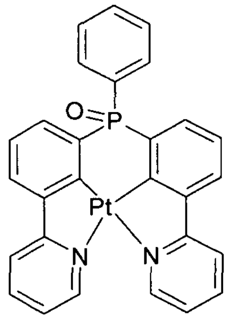

Formel (147)

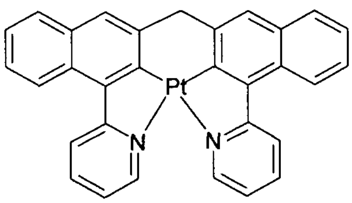

Formel (148)

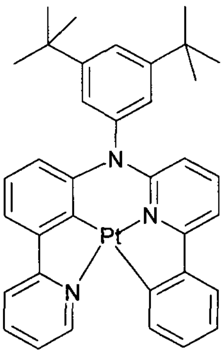

Formel (149)

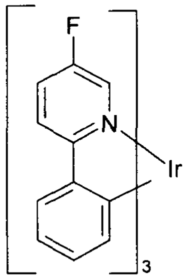

Formel (150)

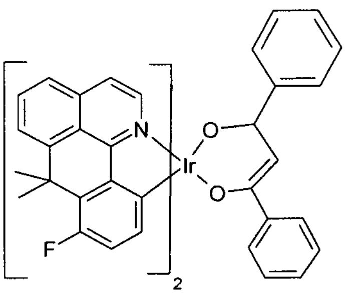

Formel (151)

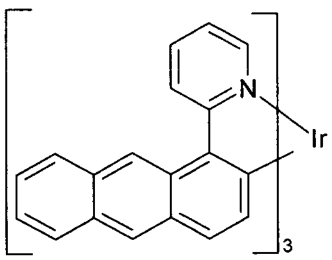

Formel (152)

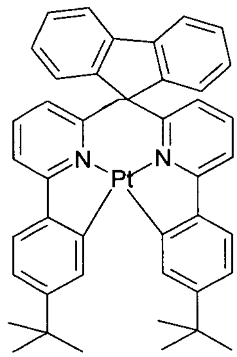

Formel (153)

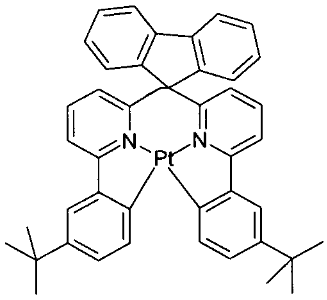

Formel (154)

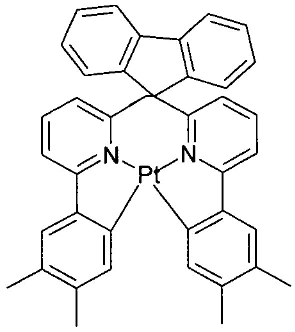

Formel (155)

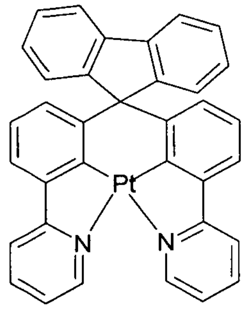

Formel (156)

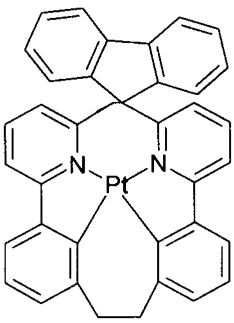

Formel (157)

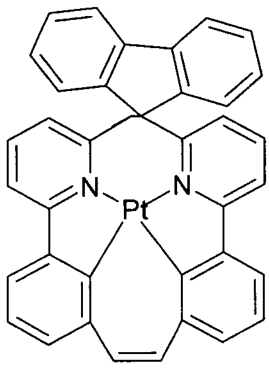

Formel (158)

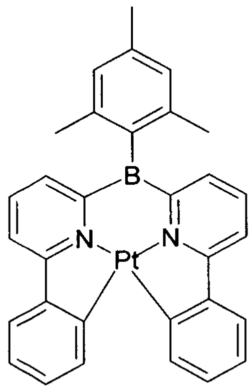

Formel (159)

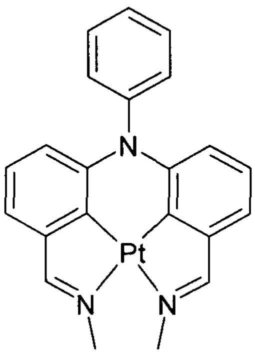

Formel (160)

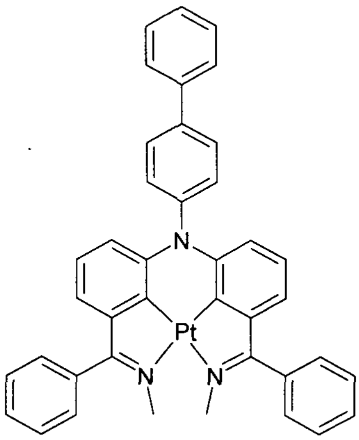

Formel (161)

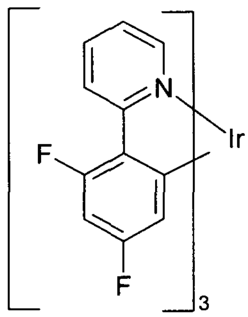

Formel (162)

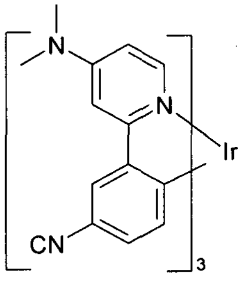

Formel (163)

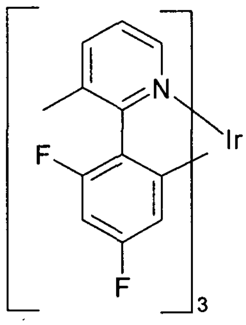

Formel (164)

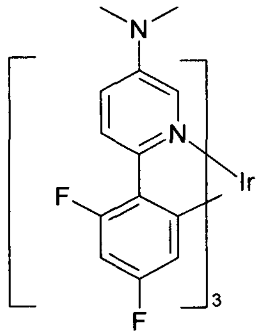

Formel (165)

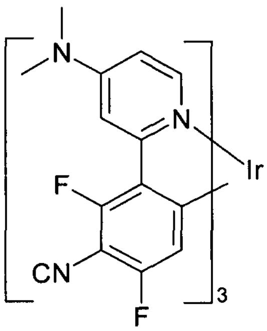

Formel (166)

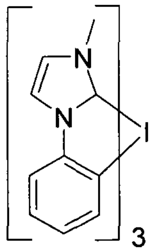

Formel (167)

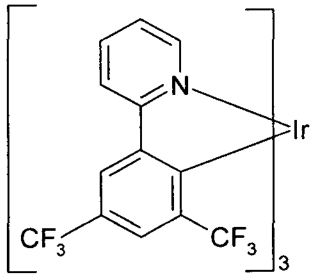

Formel (168)

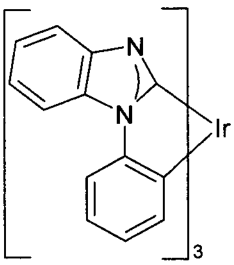

Formel (169)

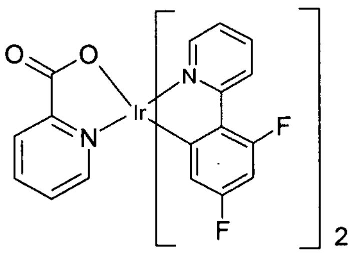

Formel (170)

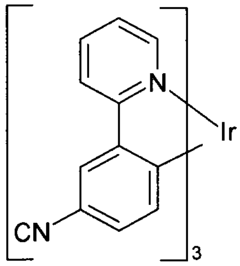

Formel (171)

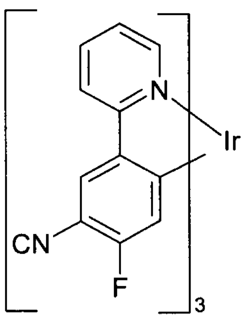

Formel (172)

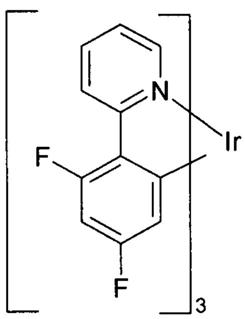

Formel (173)

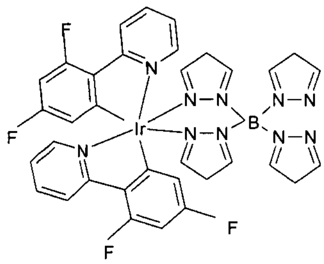

Formel (174)

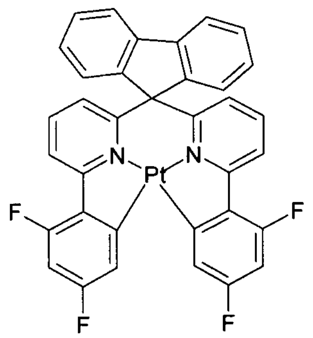

Formel (175)

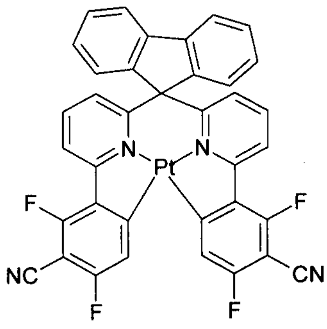

Formel (176)

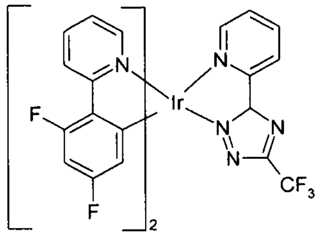

Formel (177)

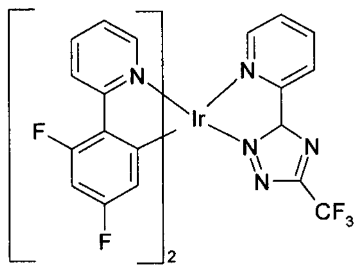

Formel (178)

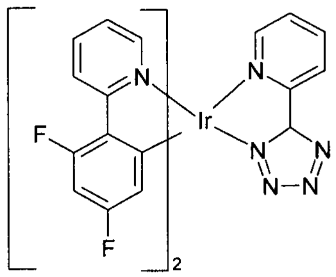

Formel (179)

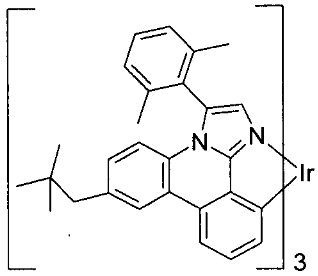

Formel (180)

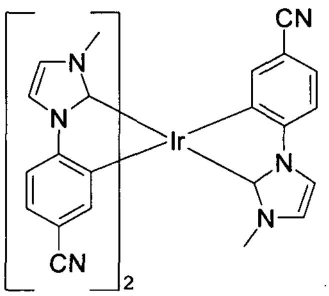

Formel (181)

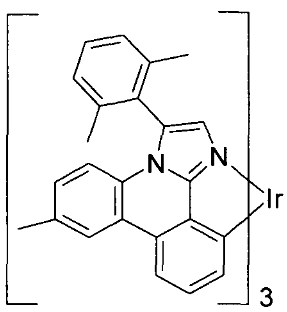

Formel (182)

Die zuvor aufgelisteten Beispiele für eine phosphoreszierende Emittereinheit stellen hierbei die oben genannte Gruppe T dar und werden in Abhängigkeit von dem Index n an eine oder mehrere Gruppen A gebunden. Die Bindung findet statt, indem ein oder mehrere Wasserstoffatome an den Liganden nicht vorhanden sind und an dieser Stelle die Bindung zu der/den Gruppe(n) A stattfindet.

Die Gruppe S kann auch eine monovalente Gruppe sein, die eine fluoreszierende Emittereinheit enthält bzw. daraus besteht.

Eine fluoreszierende Emittereinheit ist allgemein betrachtet eine Einheit, die Licht, vorzugsweise im sichtbaren Bereich, aus einem angeregten Singulett-Zustand emittiert.

Die fluoreszierende Emittereinheit umfasst vorzugsweise die folgenden Verbindungen: mono- oder polycyclische aromatische oder heteroaromatischen Ringsysteme mit 5 bis 60 aromatischen Ringatomen oder auch Tolan-, Stilben- oder Bisstyrylarylenderivate, die jeweils mit einem oder mehreren Resten R substituiert sein können. Besonders bevorzugt ist dabei der Einbau von 1,4-Phenyl, 1,4-Naphthyl, 1,4- oder 9,10-Anthryl, 1,6-, 2,7- oder 4,9-Pyrenyl, 3,9- oder 3,10-Perylenyl, 4,4'-Biphenylyl, 4,4"-Terphenylyl, 4,4-Bi-1,1'-naphthylyl, 4,4'-Tolanyl, 4,4'-Stilbenyl, 4,4"-Bisstyrylaryl, Benzothiadiazolyl, Chinoxalinyl, Phenothiazinyl, Phenoxazinyl, Dihydrophenazinyl, Bis(thiophenyl)aryl, Oligo(thiophenyl), Phenazinyl, Rubrenyl, Pentacenyl, Squarinyl und Chinacridonyl, die vorzugsweise substituiert sind, oder vorzugsweise konjugierte Push-Pull-Systeme (Systeme, die mit Donor- und Akzeptorsubstituenten substituiert sind, oder

Systeme wie Squarine oder Chinacridone, die vorzugsweise substituiert sind.

Des Weiteren kann S aus der Gruppe ausgewählt sein, die aus Monostyrylaminen, Distyrylaminen, Tristyrylaminen, Tetrastyrylaminen, Styrylphophinen, Styrylethern, Arylaminen, Indenofluorenaminen, Indenofluorendiaminen und deren Derivaten besteht.

Im Prinzip kann jede organische fluoreszierende Emitterverbindung als Einheit S eingesetzt werden, die dem Fachmann auf dem Gebiet von organischen lichtemittierenden Dioden oder organischen lichtemittierenden elektrochemischen Zellen bekannt ist.

Die Einheit S in der Formel (1) kann vorzugsweise unter den folgenden ausgewählt werden: Styrylamine-Derivate, Indenofluoren-Derivate, polyaromatische Verbindungen, Anthracen-Derivate, Tetracen-Derivate, Xanthen-Derivate, Perylen-Derivate, Phenylen-Derivate, Fluoren-Derivate, Arylpyren-Derivate, Arylenvinylen-Derivate, Rubren-Derivate, Coumarin-Derivate, Rhodamin-Derivate, Quinacridon-Derivate, Dicyanomethylenpyran-Derivate, Thiopyran, Polymethin-Derivate, Pyrylium und Thiapyrylium Salze, Periflanthen-Derivate, Indenoperylen-Derivate, Bis(azinyl)iminboron-Verbindungen, Bis(azinyl)methin-Verbindungen, Carbostyryl-Verbindungen, Monostyrylamine, Distyrylamine, Tristyrylamine, Tetrastyrylamine, Styrylphosphine, Styrylether, Arylamine, Indenofluorenamine und Indenofluorendiamine, Benzoindenofluorenamine, Benzoindenofluorendiamine, Dibenzoindenofluorenamine, Dibenzoindenofluorendiamine, substituierte oder unsubstituierte Tristilben-amine, Distyrylbenzol und Distyrylbiphenyl-Derivate, Triarylamine, Naphthalen-Derivate, Anthracen-Derivate, Tetracen-Derivate, Fluoren-Derivate, Periflanthen-Derivate, Indenoperylen-Derivate, Phenanthren-Derivate, Perylen-Derivate, Pyren-Derivate, Chrysen-Derivate, Decacyclen-Derivate, Coronen-Derivate, Tetraphenylcyclopentadien-Derivate, Pentaphenylcyclopentadien-Derivate, Fluoren-Derivate, Spirofluoren-Derivate, Pyran-Derivate, Oxazon-Derivate, Benzoxazol-Derivate, Benzothiazol-Derivate, Benzimidazol-Derivate, Pyrazin-Derivate, Zimtsäureester, Diketopyrrolopyrrol-Derivate, und Acridon-Derivate.

Blaue fluoreszierende Emitterverbindungen als Einheit S können vorzugsweise polyaromatische Verbindungen sein, wie beispielsweise 9,10-Di(2-naphthylanthracen) und andere Anthracen-Derivate, Derivate von Tetracen, Xanthen, Perylen, wie beispielsweise 2,5,8,11-Tetra-t-butylperylen, Phenylen, z.B. 4,4'-(Bis(9-ethyl-3-carbazovinylen)-1,1'-biphenyl, Fluoren, Arylpyrene (US 2006/0222886), Arylenvinylene (US 5121029, US 5130603), Derivate von Rubren, Coumarin, Rhodamin, Quinacridon, wie beispielsweise N,N'-Dimethylquinacridon (DMQA), Dicyanomethylenepyran, wie beispielsweise 4-(Dicyanoethylen)-6-(4-dimethylaminostyryl-2-methyl)-4H-pyran (DCM), Thiopyrane, Polymethin, Pyrylium and Thiapyrylium Salze, Periflanthen, Indenoperylen, Bis(azinyl)-iminboron-Verbindungen (US 2007/0092753 A1), Bis(azinyl)methen-Verbindungen und Carbostyryl-Verbindungen.

Weiterhin bevorzugte blaue fluoreszierende Emitterverbindungen als Einheit S können Emitter sein, die in C.H. Chen et al.: "Recent developments in organic electroluminescent materials" Macromol. Symp. 125, (1997), 1-48 und "Recent progress of molecular organic electroluminescent materials and devices" Mat. Sci. and Eng. R, 39 (2002), 143-222 beschrieben werden.

Ein Monostyrylamin ist hierbei eine Verbindung, die eine substituierte oder unsubstituierte Styrylgruppe und wenigstens ein, vorzugsweise aromatisches, Amin enthält. Ein Distyrylamin ist vorzugsweise eine Verbindung, die zwei substituierte oder unsubstituierte Styrylgruppen und wenigstens ein, vorzugsweise aromatisches, Amin enthält. Ein Tristyrylamin ist vorzugsweise eine Verbindung, die drei substituierte oder unsubstituierte Styrylgruppen und wenigstens ein, vorzugsweise aromatisches, Amin enthält. Ein Tetrastyrylamin ist vorzugsweise eine Verbindung, die vier substituierte oder unsubstituierte Styrylgruppen und wenigstens ein, vorzugsweise aromatisches, Amin enthält. Besonders bevorzugt ist die Styrylgruppe ein Stilben, das weiterhin substituiert sein kann. Die erfindungsgemäß einsetzbaren entsprechenden Phosphine and Ethers werden analog zu den Aminen definiert. Für den Zweck dieser Erfindung bedeutet Arylamin oder aromatisches Amin eine Verbindung, die drei substituierte oder unsubstituierte aromatische oder heteroaromatische Ringsysteme enthält, die direkt an ein Stickstoffatom gebunden sind. Wenigstens eines dieser aromatischen oder heteroaromatischen Ringsysteme kann ein kondensierter Ring sein. Bevorzugt Beispiele hierfür sind aromatische Anthracen-Amine, aromatische Anthracen-Diamine, aromatische Pyren-Amine, aromatische Pyren-Diamine, aromatische Chrysen-Amine und aromatische Chrysen-Diamine. Ein aromatisches Anthracen-Amin kann eine Verbindung sein, in der eine Diarylamingruppe direkt an eine Anthracengruppe, vorzugsweise in der Position 9, gebunden ist. Ein aromatisches Anthracen-Diamin kann eine Verbindung sein, in der zwei Diarylamingruppen direkt an eine Anthracengruppe, vorzugsweise in den Positionen 9 und 10 gebunden sind. Aromatische Pyren-Amine, Pyren-Diamine, Chrysen-Amine und Chrysen-Diamine werden analog dazu definiert, worin die Diarylamingruppen am Pyren vorzugsweise in der Position 1 oder in den Positionen 1 und 6 gebunden sind.

Weiterhin bevorzugte fluoreszierende Emitterverbindungen sind Indenofluoren-Amine und Indenofluoren-Diamine, z.B. gemäß WO 2006/122630, Benzoindenofluoren-Amine und Benzoindenofluoren-Diamine, z.B. gemäß WO 2008/006449, und Dibenzoindenofluoren-Amine und Dibenzoindenofluoren-Diamine, z.B. gemäß WO 2007/140847.

Beispiele für weitere einsetzbare fluoreszierende Emitterverbindungen aus der Klasse der Styrylamine sind substituierte oder unsubstituierte Tristilben-Amine oder solche, die in WO 2006/000388, WO 2006/058737, WO 2006/000389, WO 2007/065549 und WO 2007/115610 beschrieben sind. Distyrylbenzen- und Distyrylbiphenyl- Derivate werden in US 5121029 beschrieben. Weitere Styrylamine können in US 2007/0122656 A1 gefunden werden. Besonders

bevorzugte Styrylamine und Triarylamine sind die Verbindungen der Formeln (183) to (188) und solche, die in US 7250532 B2, DE 102005058557 A1, CN 1583691 A, JP 08053397 A, US 6251531 B1, und US 2006/210830 A offenbart sind.

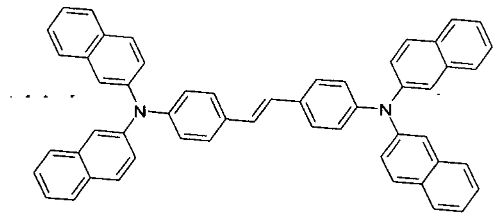

Formel (183)

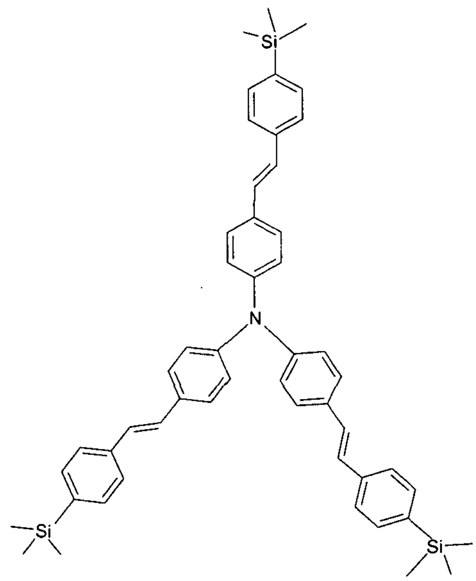

Formel (184)

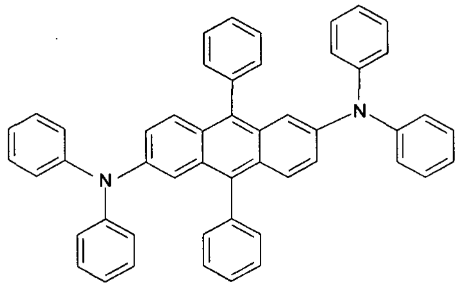

Formel (185)

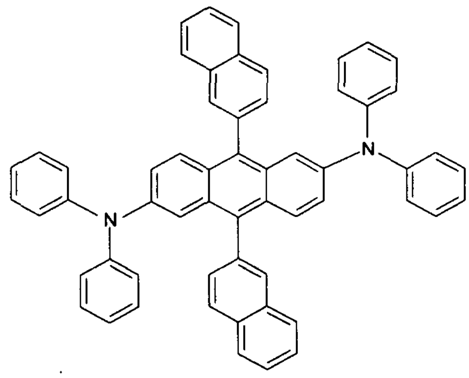

Formel (186)

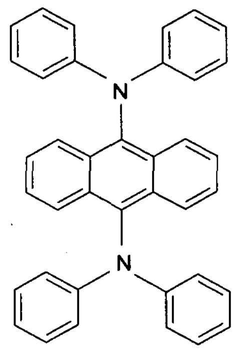

Formel (187)

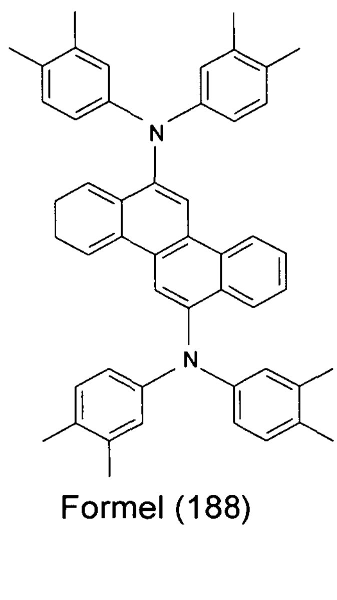

Formel (188)

Weiterhin bevorzugte fluoreszierende Emitterverbindungen können aus der Gruppe der Triarylamine wie in EP 1957606 A1 und US 2008/0113101 A1 offenbart entnommen werden.

Weiterhin bevorzugte fluoreszierende Emitterverbindungen können aus den Derivaten des Naphthalens, Anthracens, Tetracens, Fluorens, Periflanthens, Indenoperylens, Phenanthrens, Perylens (US 2007/0252517 A1), Pyrens, Chrysens, Decacyclens, Coronens, Tetraphenylcyclopentadiens, Pentaphenylcyclopentadiens, Fluorens, Spirofluorens, Rubrens, Coumarins (US 4769292, US 6020078, US 2007/0252517 A1), Pyrans, Oxazons, Benzoxazols, Benzothiazols, Benzimidazols, Pyrazins, Zimtsäureesters, Diketopyrrolopyrrols, Acridons und Quinacridons (US 2007/0252517 A1) ausgewählt werden.

Unter den Anthracen-Verbindungen sind die 9,10-substituierten Anthracene, wie z.B. das 9,10-Diphenylanthracen und 9,10-Bis(phenyl-ethynyl)anthracen, bevorzugt. Auch 1,4-Bis(9'-ethynylanthracenyl)benzol kann als fluoreszierende Emitterverbindung bevorzugt sein.

Geeignete fluoreszierende Emitter-Einheiten sind weiterhin die in der folgenden Tabelle abgebildeten Strukturen, sowie die in JP 06/001973, WO 2004/047499, WO 2006/098080, WO 2007/065678, US 2005/0260442 und WO 2004/092111 offenbarten Strukturen.

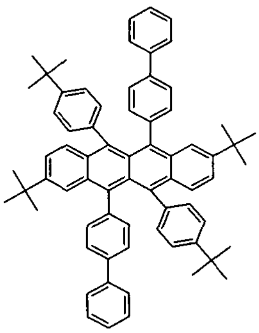
Formel (189)

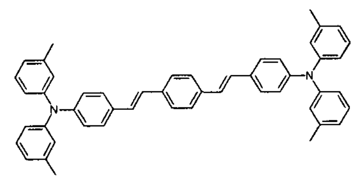
Formel (190)

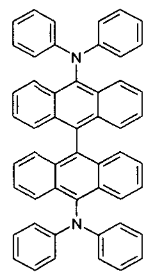
Formel (191)

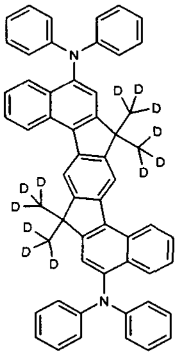
Formel (192)

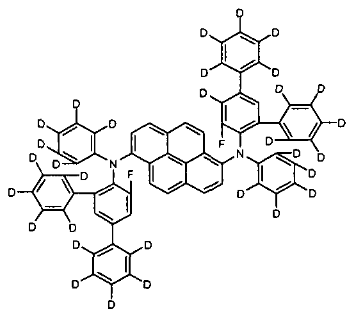
Formel (193)

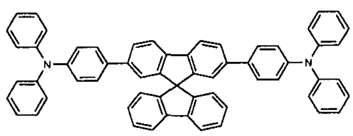
Formel (194)

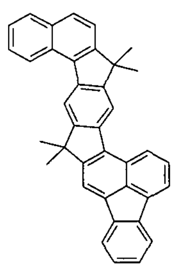
Formel (195)

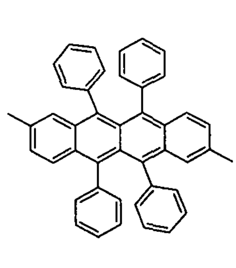
Formel (196)

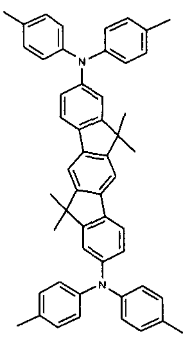
Formel (197)

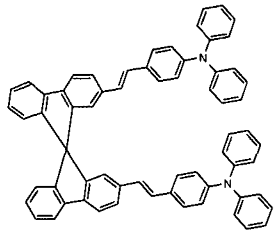

Formel (198)

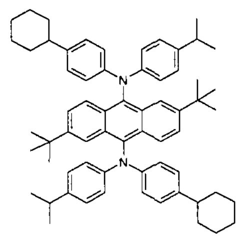

Formel (199)

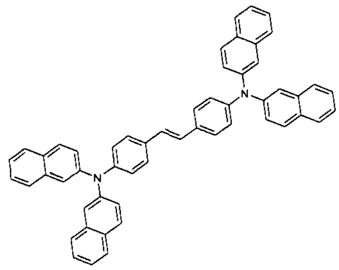

Formel (200)

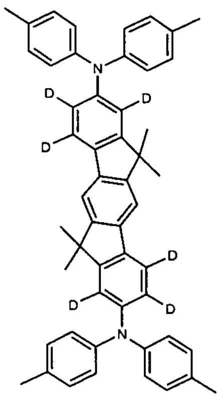

Formel (201)

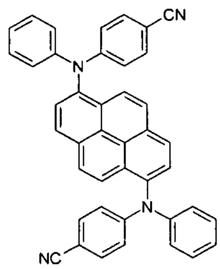

Formel (202)

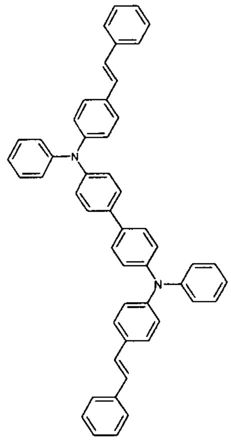

Formel (203)

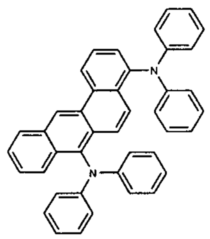

Formel (204)

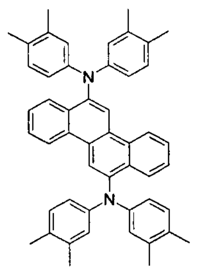

Formel (205)

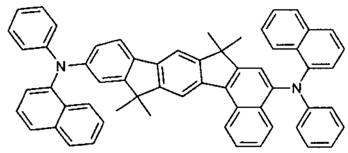

Formel (206)

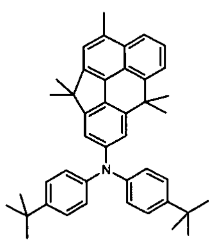

Formel (207)

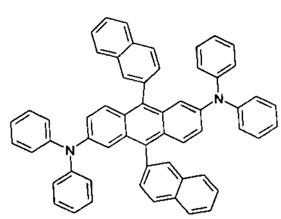

Formel (208)

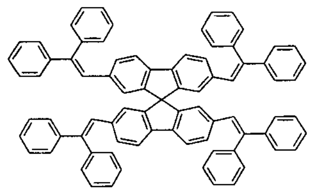

Formel (209)

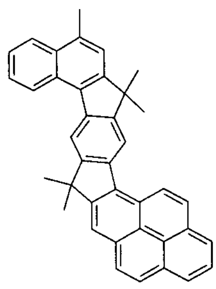

Formel (210)

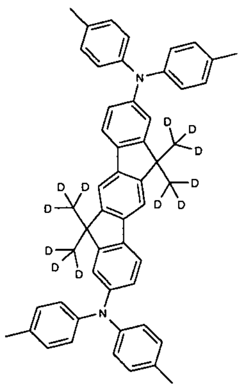

Formel (211)

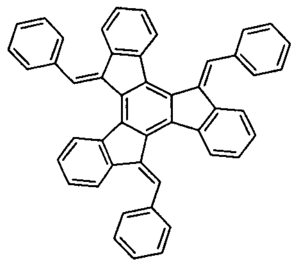

Formel (212)

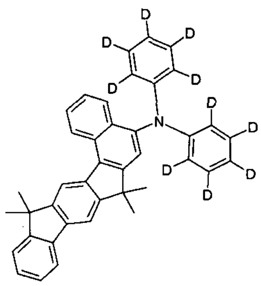

Formel (213)

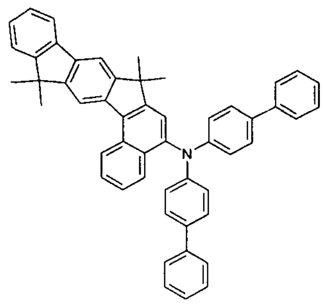

Formel (214)

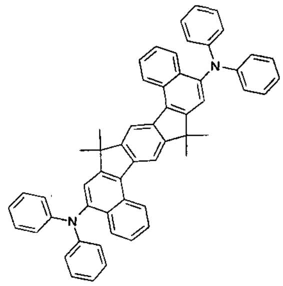

Formel (215)

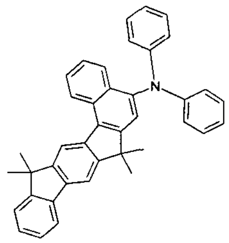

Formel (216)

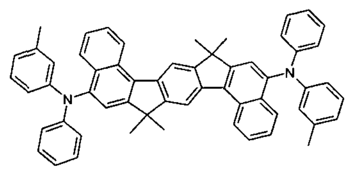

Formel (217)

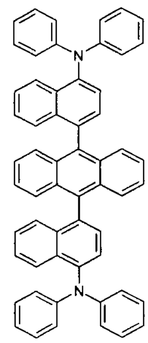

Formel (218)

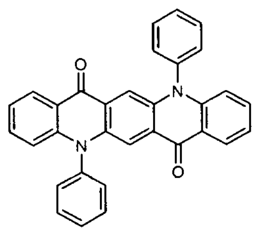

Formel (219)

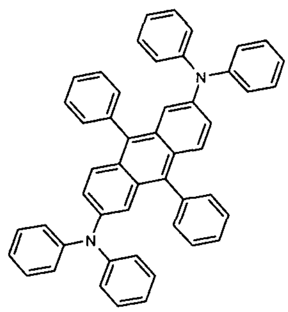

Formel (220)

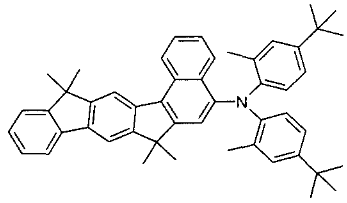

Formel (221)

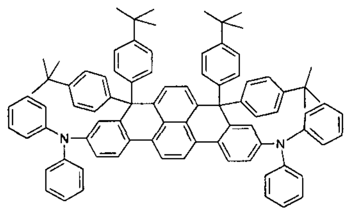

Formel (222)

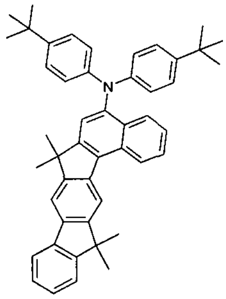

Formel (223)

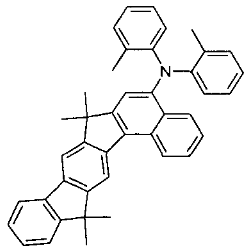

Formel (224)

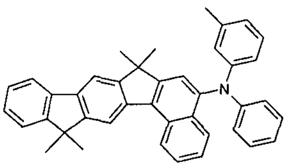

Formel (225)

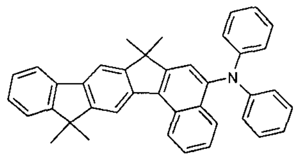

Formel (226)

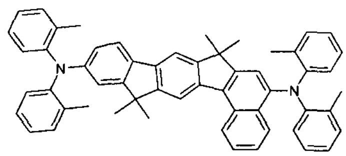

Formel (227)

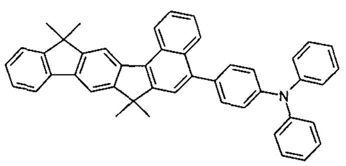

Formel (228)

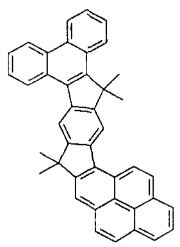

Formel (229)

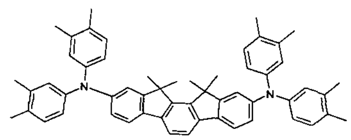

Formel (230)

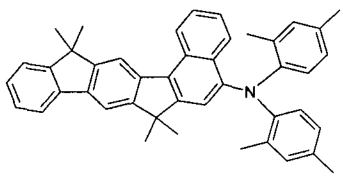

Formel (231)

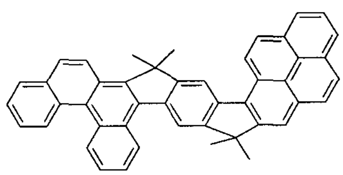

Formel (232)

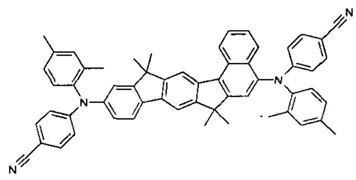

Formel (233)

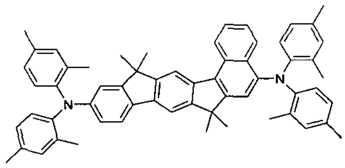

Formel (234)

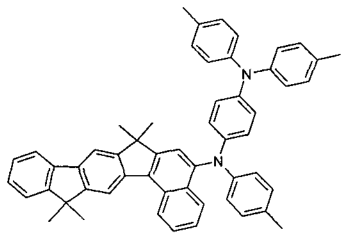

Formel (235)

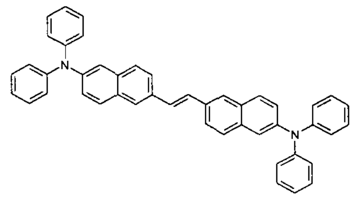

Formel (236)

In der vorliegenden Erfindung ist die Gruppe S der Verbindung der Formel (1) eine absorbierende Gruppe, die als Farbstoff funktioniert, und zwar insbesondere als Akzeptor im Sinne des genannten Energietransfers. Generell eignen sich alle organischen Farbstoffe, wie sie gemäß dem Stand der Technik für "organic solar cells (OPVs)" verwendet

werden und wie sie dem Fachmann auf dem Gebiet der OPVs bekannt sind.

Besonders bevorzugte Beispiele für die Gruppe S für die Verwendung der Verbindung der Formel (1) in Solarzellen sind die folgenden:

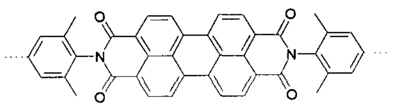

Formel (237)

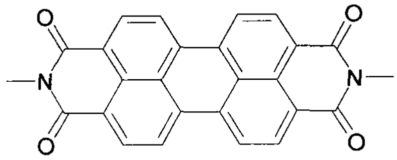

Formel (238)

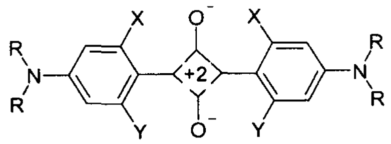

Formel (239)

wobei

R bei jedem Auftreten gleich oder verschieden ein Rest ist, der bereits oben für Formel (10) definiert wurde; und

X und Y bei jedem Auftreten gleich oder verschieden ein Rest ist, ausgewählt aus H, Halogen, Alkyl, Alkoxyalkyl, Alkylsilyl, Silyl, Alkylalkoxyalkyl Gruppen.

Die bivalente Einheit A ist vorzugsweise eine konjugierte oder konjugationsunterbrechende Einheit. Besonders bevorzugt ist die Einheit A eine konjugationsunterbrechende Einheit. Dies hat den Vorteil, dass die Energietransferraten zwischen den Gruppen T und S erhöht ist, ohne die elektronischen Eigenschaften von T und/oder S zu ändern.

Die konjugierte Einheit ist vorzugsweise ein substituiertes oder unsubstituiertes mono- oder polycyclisches aromatisches oder heteroaromatisches Ringsystem mit 5 bis 60 aromatischen Ringatomen. Unter einer konjugationsunterbrechenden Einheit wird eine Einheit verstanden, die die Konjugation stört bzw. vorzugsweise unterbricht, d.h. eine mögliche Konjugation der an A bindenden Liganden wird gestört bzw. vorzugsweise unterbrochen. Unter Konjugation versteht man in der Chemie die Überlappung eines $\pi$-Orbitals ($\pi$=PI) mit einem p-Orbital eines $sp^2$-hybridisierten (Kohlenstoff-)Atoms oder weiteren $\pi$-Orbitalen. Im Gegensatz dazu versteht man im Sinne dieser Anmeldung unter einer konjugationsunterbrechenden Einheit eine Einheit, die eine solche Überlappung stört bzw. vorzugsweise völlig unterbindet. Dies kann beispielsweise durch eine Einheit erfolgen, bei der die Konjugation durch mindestens ein $sp^3$-hybridisiertes Atom, bevorzugt Kohlenstoff, gestört wird. Ebenso kann die Konjugation durch ein nicht $sp^3$-hybridisiertes Atom gestört sein, beispielsweise durch N, P oder Si.

Die konjugationsunterbrechende Einheit ist vorzugsweise aus der Gruppe ausgewählt, die aus linearem oder verzweigtem $C_{1-12}$-Alkylen, $C_{3-8}$-Cycloalkylen, linearem oder verzweigten Mono-($C_{1-12}$-alkyl)-silylen, linearem oder verzweigten Di-($C_{1-12}$-alkyl)-silylen, linearem oder verzweigtem Tri-($C_{1-12}$-alkyl)-silylen, einer Silylengruppe, die mit ein, zwei oder drei mono- oder polycyclischen aromatischen oder heteroaromatischen Ringsystemen mit 5 bis 60 aromatischen Ringatomen substituiert ist, linearem oder verzweigtem $Si_{1-5}$-silylen, linearem oder verzweigtem $C_{1-12}$-Alkyl-oxy-$C_{1-12}$-alkylen, linearem oder verzweigtem Aryl-C-$_{1-12}$-Alkyl-oxy-$C_{1-12}$-alkylen, wobei Aryl ein mono- oder polycylisches aromatisches oder heteroaromatisches Ringsystem mit 5 bis 60 aromatischen Ringatomen ist, linearem oder verzweigtem $C_{1-12}$-Alkyl-thio-$C_{1-12}$-alkylen, Sulfon, linearem oder verzweigtem $C_{1-12}$-Alkylensulfon, Sulfoxid und linearem oder verzweigtem $C_{1-12}$-Alkylensulfoxid besteht, wobei ein oder mehrere H-Atome der genannten Gruppen durch F, Cl, Br, I, einem weiteren $C_{1-12}$-Alkyl oder $C_{3-8}$-Cycloalkyl, wobei ein oder mehrere $CH_2$-Gruppen des Alkyl oder Cycloalkyl durch Heteroatome, wie NH, O oder S, ersetzt sein können, oder einem mono- oder polycylischen aromatischen oder heteroaromatischen Ringsystemen mit 5 bis 60 aromatischen Ringatomen ersetzt sein können, und wobei ein oder mehrere $CH_2$-Gruppen der genannten Gruppen, die A darstellen, durch ein bivalentes mono- oder polycyclisches aromatisches oder heteroaromatisches Ringsystem mit 5 bis 60 aromatischen Ringatomen ersetzt sein können, mit der Maßgabe,

dass die bivalente Einheit A über jedes denkbare Atom der Einheit an die Gruppen S und T binden kann.

Besonders bevorzugt bedeutet A ein lineares oder verzweigtes $C_{1-12}$-Alkylen oder $C_{1-12}$-Alkyl-oxy-$C_{1-12}$-alkylen, wobei ein oder mehrere H-Atome durch F ersetzt sein können.

Des Weiteren ist es bevorzugt, dass A ein $C_{1-12}$-Alkylen oder $C_{3-8}$-Cycloalkylen ist, das mit zwei bivalenten mono- oder polycyclischen aromatischen oder heteroaromatischen Ringsystemen mit 5 bis 60 aromatischen Ringatomen substituiert ist, und die Bindung zu S über ein aromatisches Atom des einen Ringsystems und die Bindung zu T über ein aromatisches Atom des anderen Ringsystems stattfindet.

Weiter bevorzugt entspricht A einer bivalenten Einheit der allgemeinen Formeln (240) bis (254),

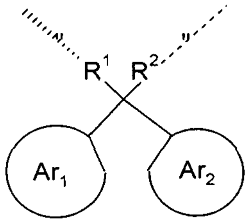

Formel (240)

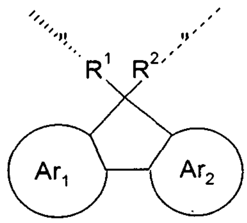

Formel (241)

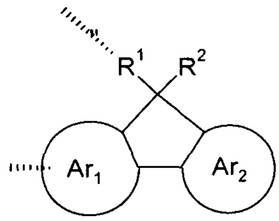

Formel (242)

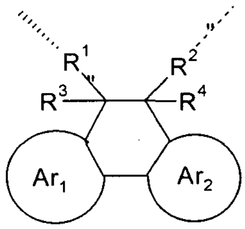

Formel (243)

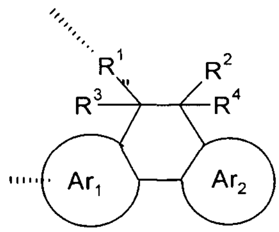

Formel (244)

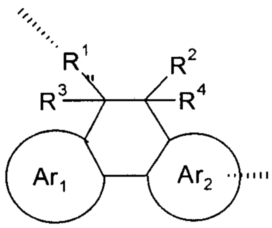

Formel (245)

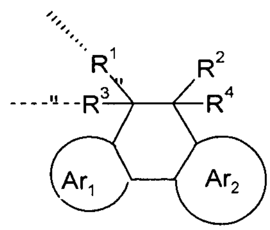

Formel (246)

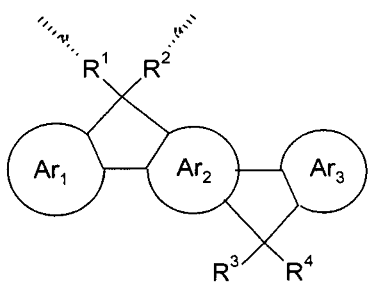

Formel (247)

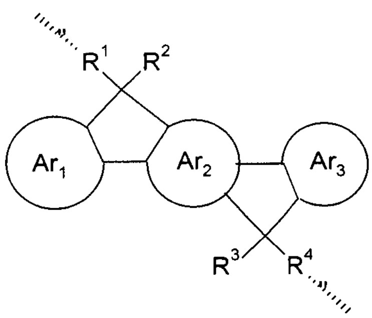

Formel (248)

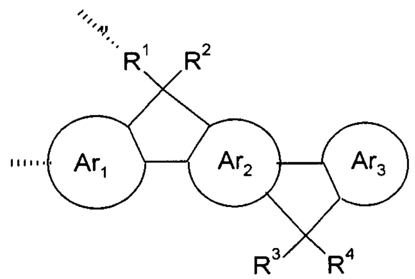

Formel (249)

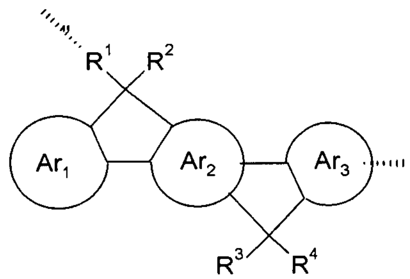

Formel (250)

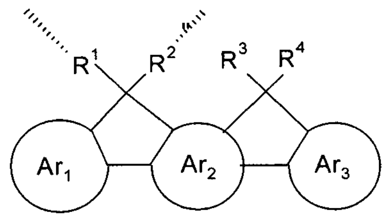

Formel (251)

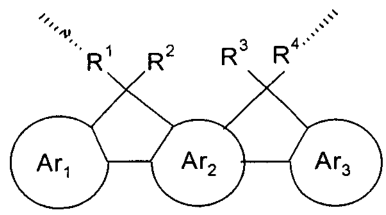

Formel (252)

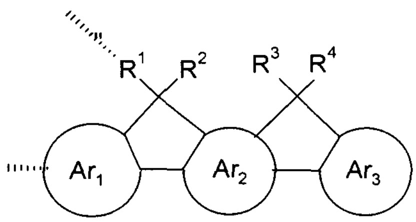

Formel (253)

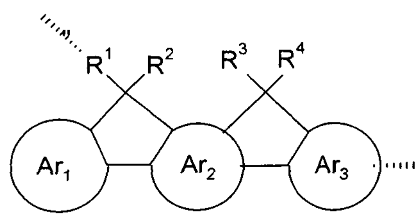

Formel (254)

wobei $Ar_1$, $Ar_2$ und $Ar_3$ jeweils unabhängig voneinander eine mono- oder polycyclische aromatische oder heteroaromatische Einheit mit 5 bis 60 Ringatomen bedeuten, zwei der Reste $R^1$ bis $R^4$ bzw. einer der Reste $R^1$ bis $R^4$ und eine der Gruppen $Ar_1$, $Ar_2$ und $Ar_3$ eine Bindung zu den Liganden $L^1$ bzw. $L^2$ der Verbindung der allgemeinen Formel (1) aufweisen, und wobei $R^1$, $R^2$, $R^3$ und $R^4$ jeweils unabhängig voneinander Alkyl(en), Cycloalkyl(en), Alkylsilyl(en), Silyl(en), Arylsilyl(en), Alkylalkoxyalkyl(en), Arylalkoxyalkyl(en), Alkylthioalkyl(en), Phosphin, Phosphinoxid, Sulfon, Alkylensulfon, Sulfonoxid, Alkylensulfonoxid bedeuten, wobei die Alkylengruppe jeweils unabhängig voneinander 1 bis 12 C-Atome aufweist und wobei ein oder mehrere H-Atome durch F, Cl, Br, I, Alkyl oder Cycloalkyl, wobei ein oder mehrere $CH_2$ durch ein Heteroatom, wie NH, O oder S ersetzt sein können, oder einem aromatischen oder heteroaromatischen Kohlenwasserstoffrest mit 5 bis 20 aromatischen Ringatomen ersetzt sein können.

Die Substituenten $R^1$ bis $R^4$ können am jeweiligen $Ar_1$, $Ar_2$ oder $Ar_3$ entweder zueinander benachbart sein oder es können ein oder mehrere Ringatome dazwischen liegen. Die Atome, an denen die Substituenten $R^1$ bis $R^4$ gebunden sind, sind vorzugsweise Ringatome der aromatischen oder heteroaromatischen Einheit.

Bevorzugt für A sind insbesondere die folgenden Strukturen:

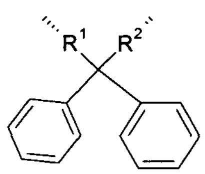

Formel (255)

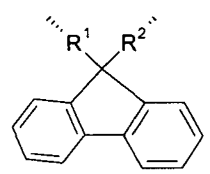

Formel (256)

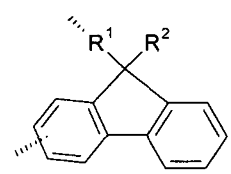

Formel (257)

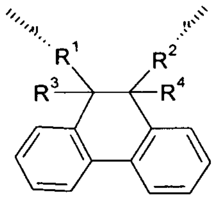

Formel (258)

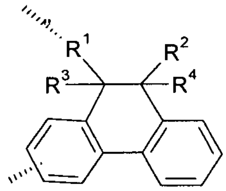

Formel (259)

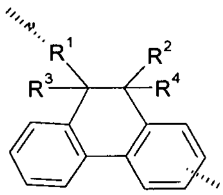

Formel (260)

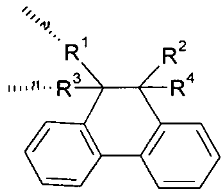

Formel (261)

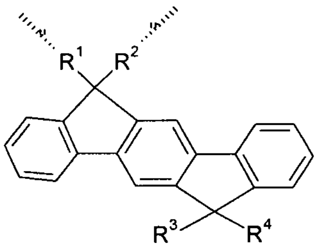

Formel (262)

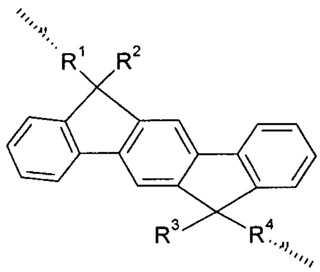

Formel (263)

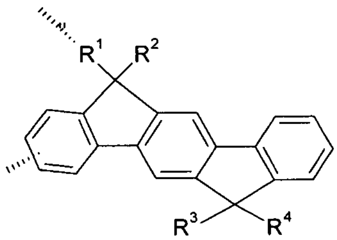

Formel (264)

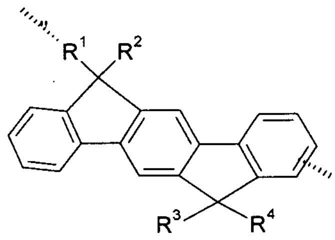

Formel (265)

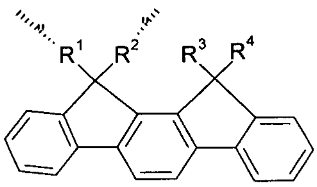

Formel (266)

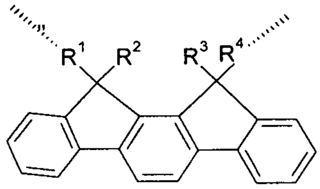

Formel (267)

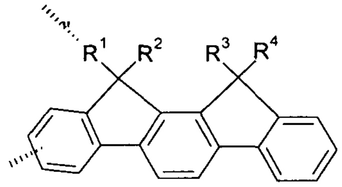

Formel (268)

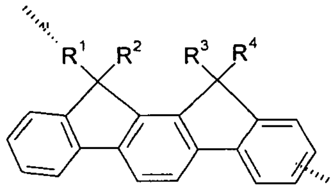

Formel (269)

wobei die Symbole und Indices die bei den Strukturen (240) bis (254) angegebene Bedeutung haben.

Bevorzugt für A sind insbesondere die folgenden Strukturen, wie beispielsweise in DE 102009023156.0 offenbart:

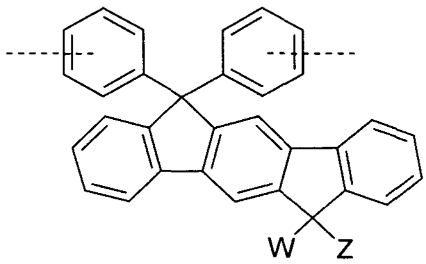

Formel (270)

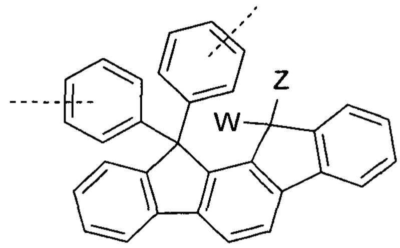

Formel (271),

worin die gestrichelten Linien Bindungen zu den Gruppen S und T darstellen und W und Z unabhängig voneinander aus der Gruppe ausgewählt sind, die aus H, F, $C_{1-40}$-Alkyl, $C_{2-40}$-Alkenyl, $C_{2-40}$-Alkinyl, einem substituierten oder unsubstituierten aromatischen oder heteroaromatischen Kohlenwasserstoffrest mit 5 bis 60 Ringatomen besteht.

Der Parameter n ist vorzugsweise 1, 2, 3, 4 oder 5, besonders bevorzugt 1, 2 oder 3, noch stärker bevorzugt 1 oder 2 und am bevorzugtesten 1.

Desweiteren ist es bevorzugt, dass eine Emissionsbande der fluoreszierenden Emittereinheit der Verbindung der Formel (1) ein Emissionsmaximum im Wellenlängenbereich von 500 bis 750 nm aufweist Ebenso bevorzugt ist es, dass eine Absorptionsbande der fluoreszierenden Emittereinheit der Verbindung der Formel (1) ein Absorptionsmaximum im Wellenlängenbereich von 400 bis 600 nm aufweist.

Eine Emissionsbande der phosphoreszierenden Emittereinheit der Verbindung der Formel (1) weist vorzugsweise ein Emissionsmaximum im Wellenlängenbereich von 400 bis 600 nm auf.

Vorzugsweise weist eine Absorptionsbande der fluoreszierenden Emittereinheit der Verbindung der Formel (1) mit einer Emissionsbande der phosphoreszierenden Emittereinheit einen überlappenden Wellenlängenbereich weist.

Desweiteren ist es auch bevorzugt, dass eine Emissionsbande der fluoreszierenden Emittereinheit der Verbindung der Formel (1) mit einer Absorptionsbande der phosphoreszierenden Emittereinheit einen überlappenden Wellenlängenbereich aufweist.

Beispiele für erfindungsgemäße Verbindungen der Formel (1) sind die folgenden:

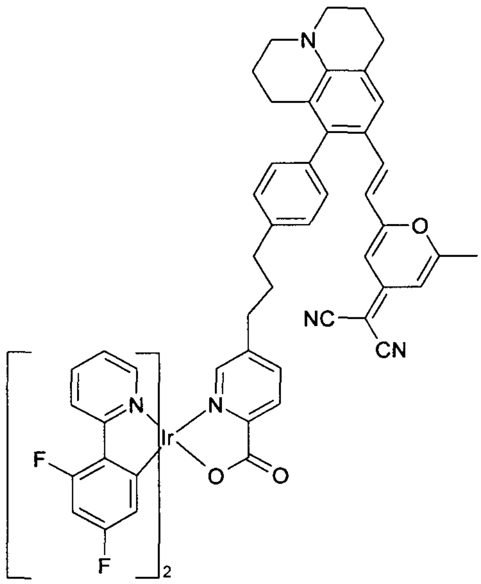

Formel (272)

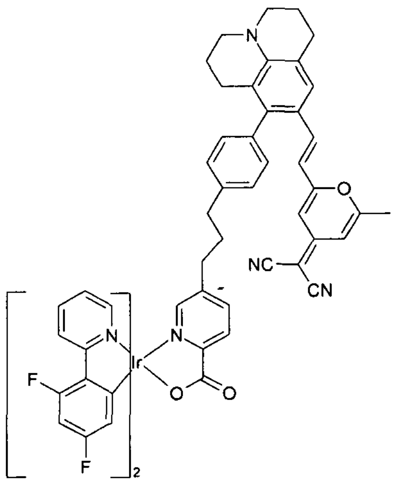

Formel (273)

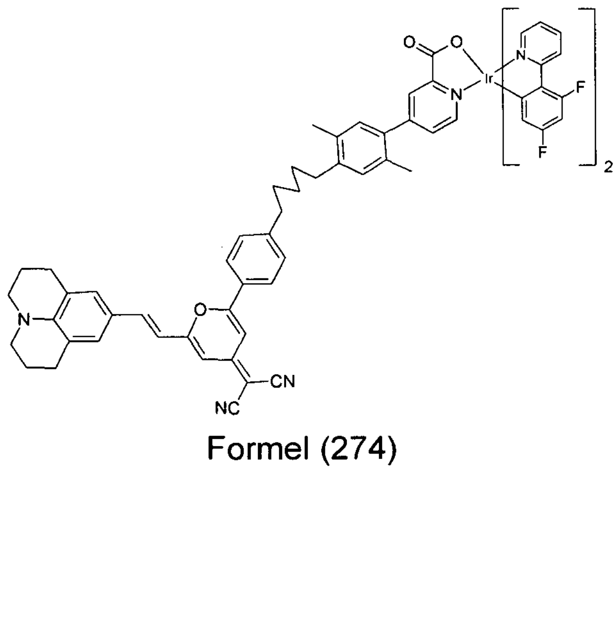

Formel (274)

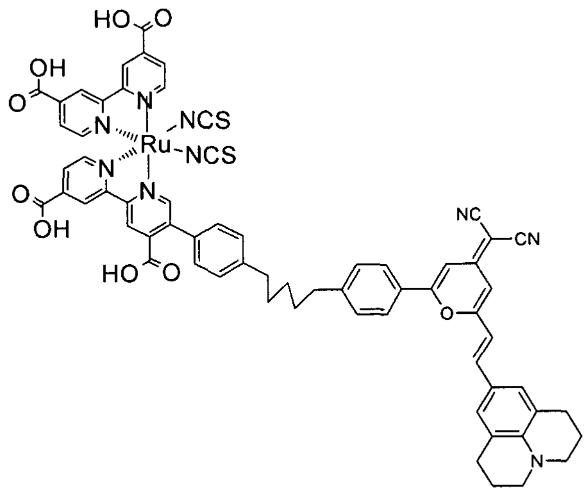

Formel (275)

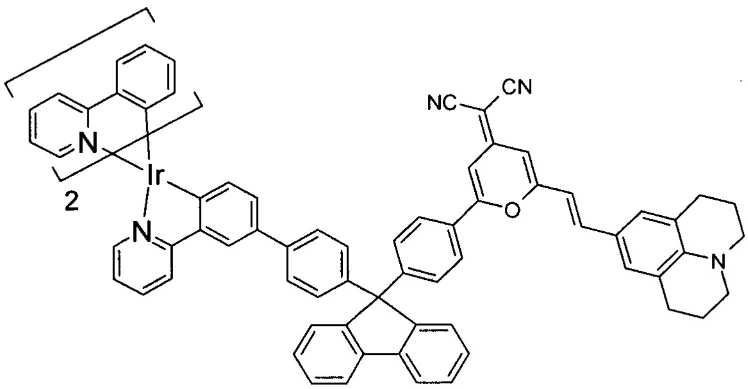

Formel (276)

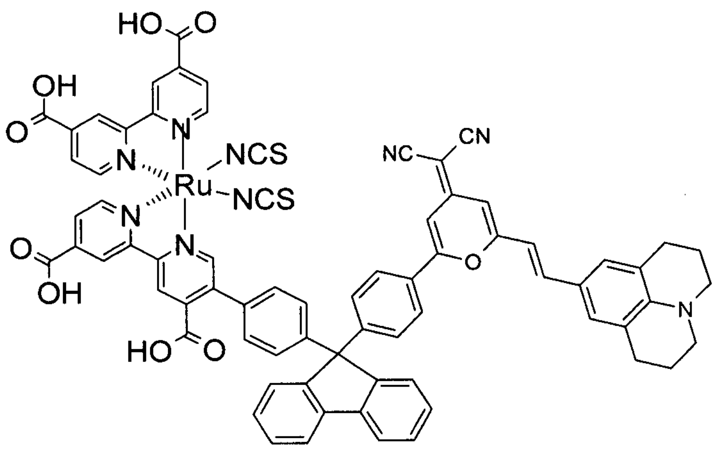

Formel (277)

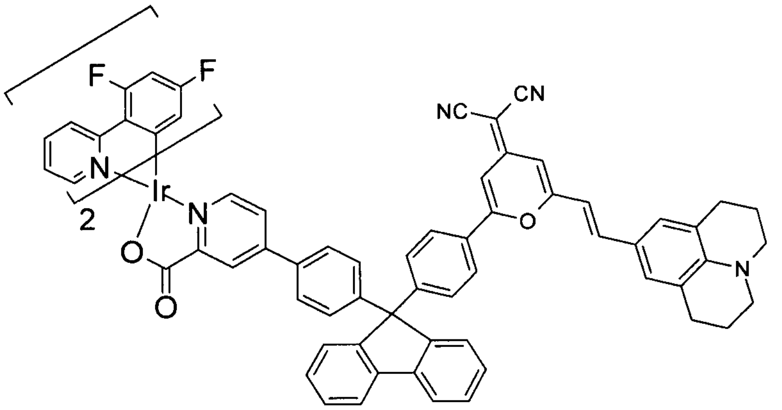

Formel (278)

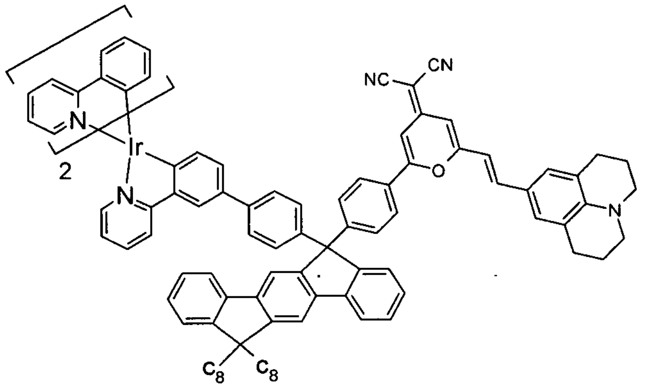

Formel (279)

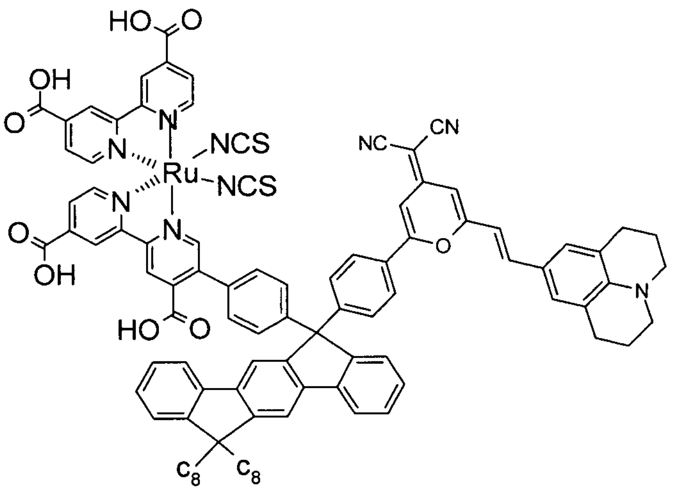

Formel (280)

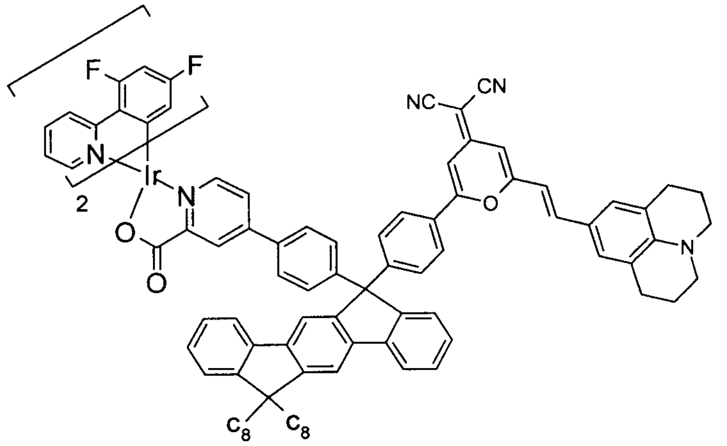

Formel (281)

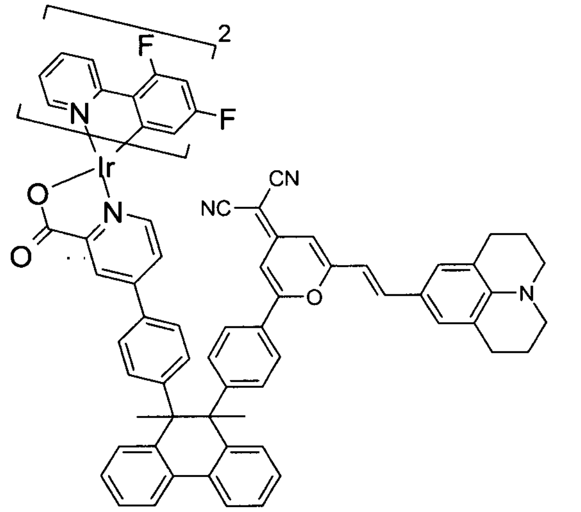

Formel (282)

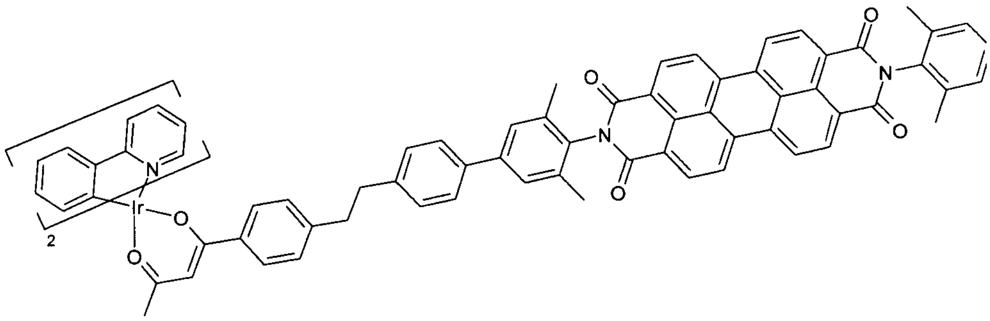

Formel (283)

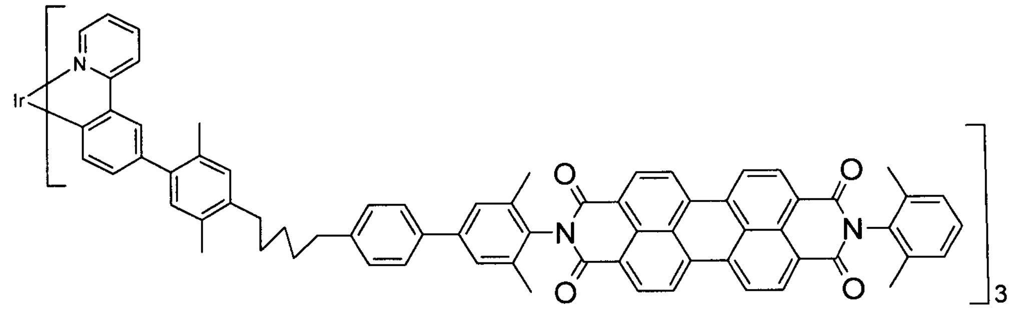

Formel (284)

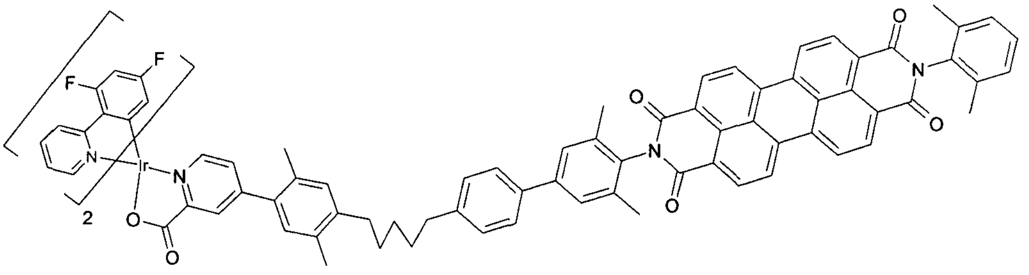

Formel (285)

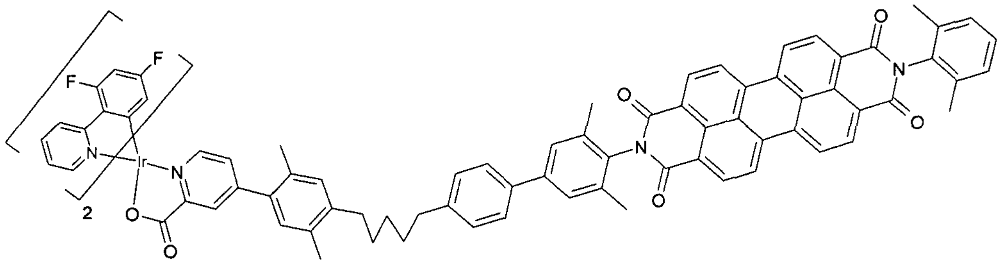

Formel (286)

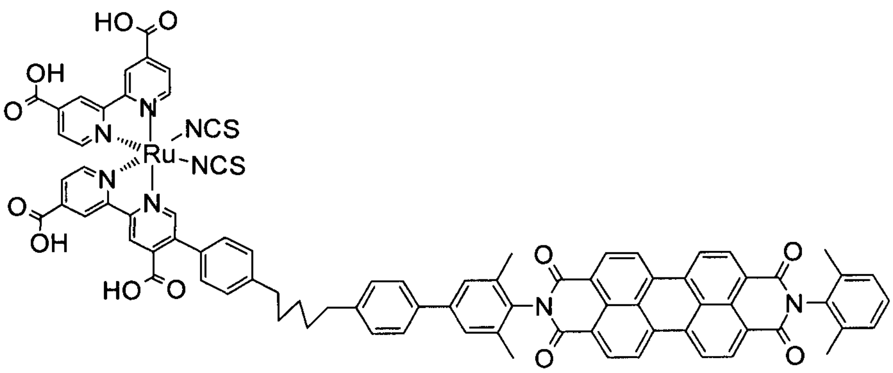

Formel (287)

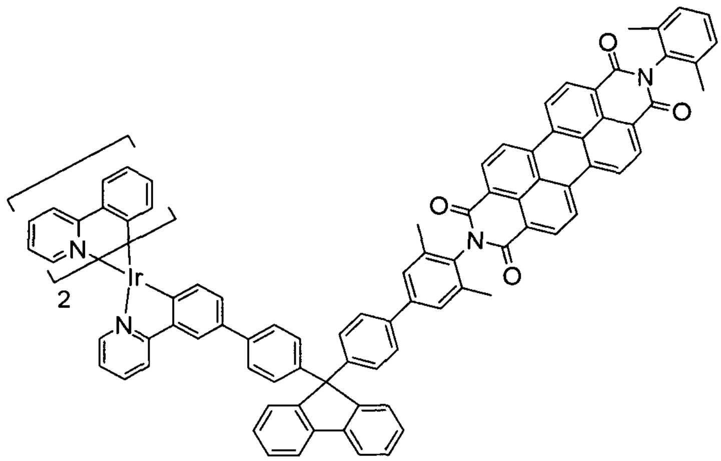

Formel (288)

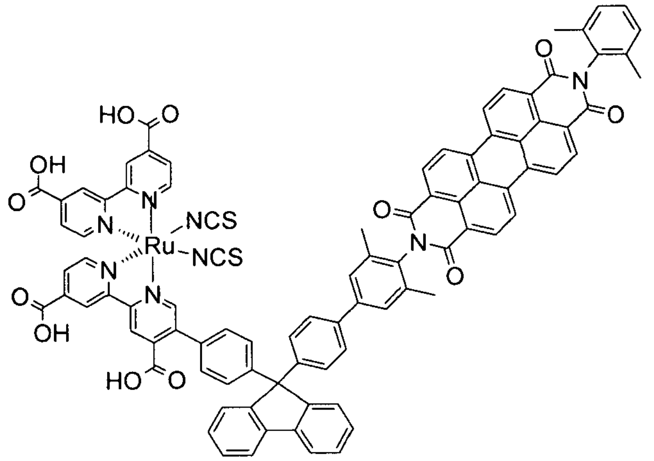

Formel (289)

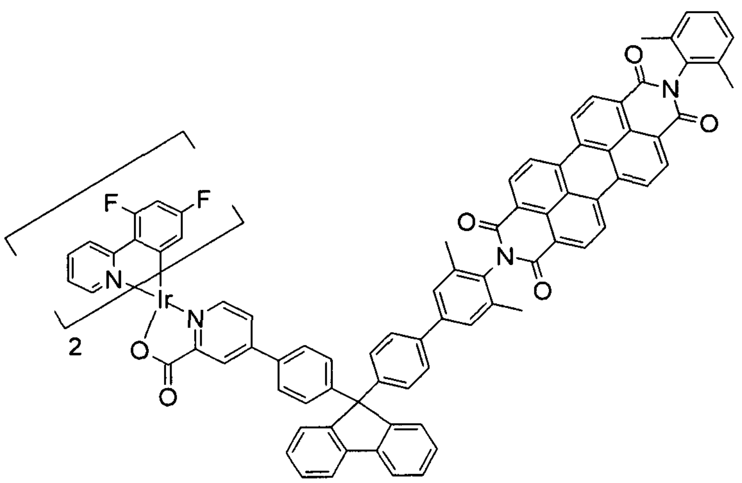

Formel (290)

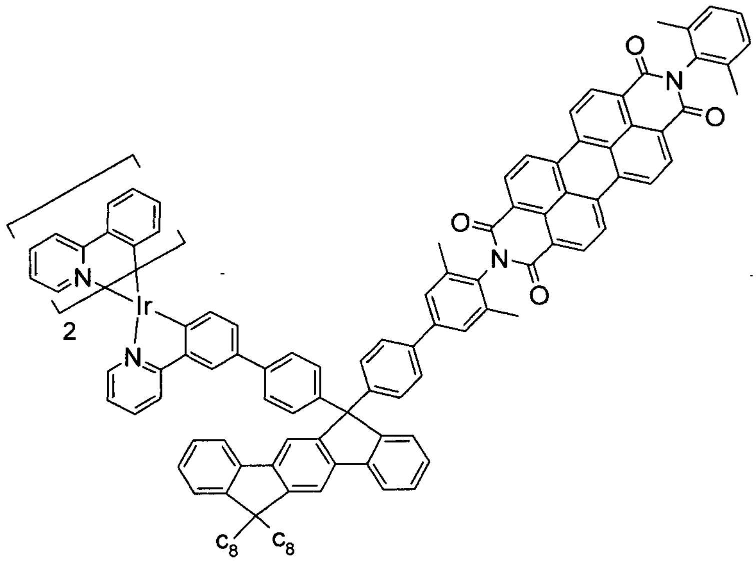

Formel (291)

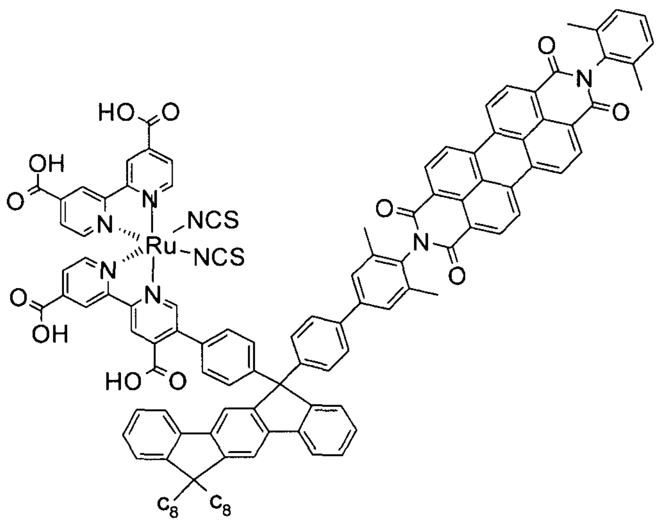

Formel (292)

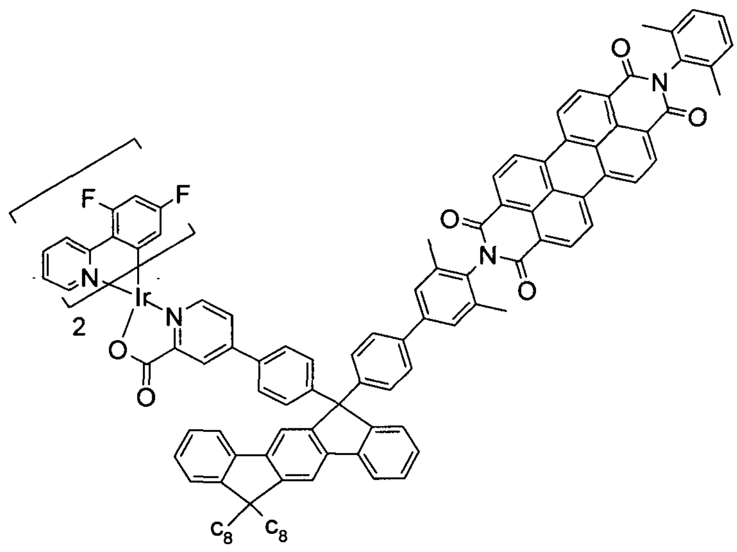

Formel (293)

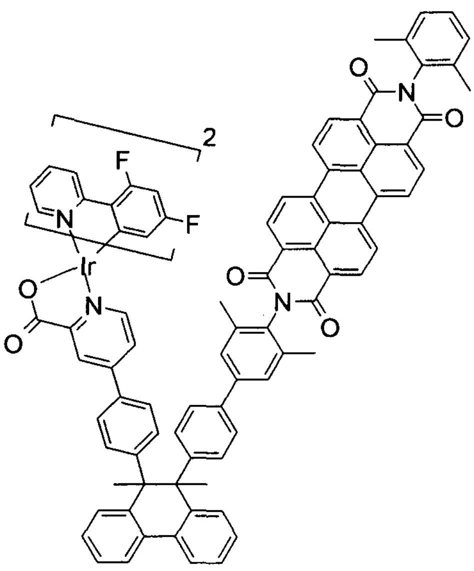

Formel (294)

Unter einem "$C_{1-40}$-Alkyl" werden in der vorliegenden Erfindung vorzugsweise lineare, verzweigte oder cyclische Alkylgruppen verstanden. Die linearen Alkylgruppen haben vorzugsweise 1 bis 6, 1 bis 10 oder 1 bis 40 Kohlenstoffatome. Die verzweigten oder cyclischen Alkylgruppen haben vorzugsweise 3 bis 6, 3 bis 10 oder 3 bis 40 Kohlenstoffatome. Bevorzugt sind Alkylgruppen mit 1 bis 6, bzw. 3 bis 6 Kohlenstoffatomen, besonders bevorzugt 1 bis 3, bzw. 3 Kohlenstoffatomen. Ein oder mehrere Wasserstoffatome an diesen Alkylgruppen können durch ein Fluoratom ersetzt sein. Außerdem können ein oder mehrere der $CH_2$-Gruppen dieser Einheiten durch NR, O oder S ersetzt sein (R ist dabei ein Rest, der aus der Gruppe ausgewählt ist, die aus H und $C_{1-6}$-Alkyl besteht). Wenn eine oder mehrere der $CH_2$-Gruppen durch NR, O oder S ersetzt ist, ist es besonders bevorzugt, dass nur eine dieser Gruppen ersetzt ist; besonders bevorzugt durch ein O-Atom. Beispiele solcher Verbindungen schließen die folgenden ein: Methyl, Ethyl, n-Propyl, i-Propyl, n-Butyl, i-Butyl, s-Butyl, t-Butyl, 2-Methylbutyl, n-Pentyl, s-Pentyl, n-Hexyl, n-Heptyl, n-Octyl, 2-Ethylhexyl, Trifluormethyl, Pentafluorethyl, 2,2,2-Trifluorethyl, Cyclopentyl, Cyclohexyl, Cycloheptyl und Cyclooctyl. Ebenso versteht man unter $C_{1-4}$-Alkyl, $C_{1-10}$-Alkyl und $C_{1-20}$-Alkyl Alkylgruppen wie vorstehend definiert, mit der Maßgabe, dass sie entsprechend weniger Kohlenstoffatome enthalten.

Unter einem "$C_{2-40}$-Alkenyl" versteht man eine lineare Alkenylgruppe mit 2 bis 40 Kohlenstoffatomen oder eine verzweigte oder cyclische Alkenylgruppe mit 3 bis 40 Kohlenstoffatomen. Es ist stärker bevorzugt eine Gruppe mit 2 bzw. 3 bis 20, noch stärker bevorzugt eine Gruppe mit 2 bzw. 3 bis 10 und am stärksten bevorzugt eine Gruppe mit 2

bzw. 3 bis 6 Kohlenstoffatomen. Ein oder mehrere Wasserstoffatome können durch ein Fluoratom ersetzt sein. Außerdem können ein oder mehrere der $CH_2$-Gruppen dieser Einheiten durch NR, O oder S ersetzt sein (R ist dabei ein Rest, der aus der Gruppe ausgewählt ist, die aus H und $C_{1-6}$-Alkyl besteht). Wenn eine oder mehrere der $CH_2$-Gruppen durch NR, O oder S ersetzt ist, ist es besonders bevorzugt, dass nur eine dieser Gruppen ersetzt ist. Beispielhaft können hierfür Ethenyl, Propenyl, Butenyl, Pentenyl, Cyclopentenyl, Hexenyl, Cyclo-hexenyl, Heptenyl, Cycloheptenyl, Octenyl und Cyclooctenyl genannt werden.

Unter einem "$C_{2-40}$-Alkinyl" versteht man eine lineare oder verzweigte Alkinylgruppe mit 2 bis 40 Kohlenstoffatomen. Stärker bevorzugt weist die Alkinylgruppe 2 bis 20, noch stärker bevorzugt 2 bis 10 und am stärksten bevorzugt 2 bis 6 Kohlenstoffatome auf. Ein oder mehrere Wasserstoffatome können durch ein Fluoratom ersetzt sein. Außerdem können ein oder mehrere der $CH_2$-Gruppen dieser Einheiten durch NR, O oder S ersetzt sein (R ist dabei ein Rest, der aus der Gruppe ausgewählt ist, die aus H und $C_{1-6}$-Alkyl besteht). Wenn eine oder mehrere der $CH_2$-Gruppen durch NR, O oder S ersetzt ist, ist es besonders bevorzugt, dass nur eine dieser Gruppen ersetzt ist. Beispielhaft können hierfür Ethinyl, Propinyl, Butinyl, Pentinyl, Hexinyl und Octinyl genannt werden.

Unter "$C_{1-12}$-Alkylen" versteht man in der vorliegenden Erfindung eine wie oben definierte lineare oder verzweigte Alkylgruppe mit vorzugsweise 1 bis 12, stärker bevorzugt 1 bis 6 und am stärksten bevorzugt 1 bis 3 Kohlenstoffatomen bei der ein Wasserstoffrest nicht vorhanden ist und an dieser Stelle eine weitere Bindung ist.

Unter "$C_{3-8}$-Cycloalkylen" versteht man in der vorliegenden Erfindung eine wie oben definierte cyclische Alkylgruppe mit vorzugsweise 3 bis 8, stärker bevorzugt 5 bis 8 und am stärksten bevorzugt 5 oder 6 Kohlenstoffatomen bei der ein Wasserstoffrest nicht vorhanden ist und an dieser Stelle eine weitere Bindung ist.

Unter "Mono-($C_{1-12}$-alkyl)-silylen" versteht man in der vorliegenden Erfindung eine ($SiH_3$)-, ($SiH_2$)- oder (SiH)-Einheit, die mit einer linearen oder verzweigten Alkylgruppe (wie oben definiert) mit 1 bzw. 3 bis 12 Kohlenstoffatomen, stärker bevorzugt 1 bzw. 3 bis 6 Kohlenstoffatomen verknüpft ist. Diese Gruppe ist eine bivalente Einheit, die über ein C-Atom einer Alkylgruppe und über das Si-Atom (dann $SiH_2$-Einheit) oder über zwei C-Atome einer oder zweier Alkylgruppen (dann $SiH_3$-Einheit) oder beide Male über das Si-Atom (dann SiH-Einheit) binden kann. Die oben in Verbindung "$C_{1-40}$-Alkyl" angegeben Beispiele gelten auch hier für die vorhandene Alkylgruppe.

Unter "Di-($C_{1-12}$-alkyl)-silylen" versteht man in der vorliegenden Erfindung eine ($SiH_2$)-, (SiH)- oder (Si)-Einheit, die mit zwei bei jedem Auftreten gleich oder verschiedenen linearen oder verzweigten Alkylgruppen (wie oben definiert) mit 1 bzw. 3 bis 12 Kohlenstoffatomen, stärker bevorzugt 1 bzw. 3 bis 6 Kohlenstoffatomen verknüpft ist. Diese Gruppe ist eine bivalente Einheit, die über ein C-Atom einer Alkylgruppe und über das Si-Atom (dann SiH-Einheit) oder über zwei C-Atome einer oder zweier Alkylgruppen (dann $SiH_2$-Einheit) oder beide Male über das Si-Atom (dann Si-Einheit) binden kann. Die oben in Verbindung "$C_{1-40}$-Alkyl" angegeben Beispiele gelten auch hier für die vorhandene Alkylgruppen.

Unter "Tri-($C_{1-12}$-alkyl)-silylen" versteht man in der vorliegenden Erfindung eine (SiH)- oder (Si)-Einheit, die mit drei bei jedem Auftreten gleich oder verschiedenen linearen oder verzweigten Alkylgruppen (wie oben definiert) mit 1 bzw. 3 bis 12 Kohlenstoffatomen, stärker bevorzugt 1 bzw. 3 bis 6 Kohlenstoffatomen verknüpft ist. Diese Gruppe ist eine bivalente Einheit, die über ein C-Atom einer Alkylgruppe und über das Si-Atom (dann Si-Einheit) oder über zwei C-Atome einer oder zweier Alkylgruppen (dann SiH-Einheit) binden kann. Die oben in Verbindung mit der Definition von "$C_{1-40}$-Alkyl" angegebenen Beispiele gelten auch hier für die vorhandene Alkylgruppen.

Unter einer Silylengruppe, die mit ein, zwei oder drei mono- oder polycyclischen aromatischen oder heteroaromatischen Ringsystemen mit 5 bis 60 aromatischen Ringatomen substituiert ist, versteht man eine $Si_1$- Silylgruppe, die mit einem, zwei oder drei mono- oder polycyclischen aromatischen oder heteroaromatischen Ringsystemen mit 5 bis 60 aromatischen Ringatomen substituiert ist. Diese Gruppe ist eine bivalente Gruppe, die entweder zwei Mal über das Si-Atom oder ein Mal über das Si- und ein Mal über ein Ringatom des Ringsystems oder beide Male über Ringatome des Ringsystems binden kann.

Unter "$Si_{1-5}$-silylen" versteht man in der vorliegenden Verbindung eine Silylgruppe mit 1 bzw. 3 bis 5 Siliciumatomen, die linear oder verzweigt ist. Es ist eine bivalente Einheit, die über das gleiche oder verschiedene Si-Atome bindet. Beispiele hierfür sind Monosilyl, Disilyl, Trisilyl, Tetrasilyl und Pentasilyl.

Unter einer $C_{1-40}$-Alkoxygruppe bzw. Thio-$C_{1-40}$-alkylgruppe versteht man eine wie oben definierte $C_{1-40}$-Alkylgruppe, die über eine O- oder S-Atom gebunden ist.

Bevorzugte Alkoxygruppen sind Methoxy, Trifluormethoxy, Ethoxy, n-Propoxy, i-Propoxy, n-Butoxy, i-Butoxy, s-Butoxy, t-Butoxy oder 2-Methylbutoxy.

Unter "$C_{1-12}$-Alkyl-oxy-$C_{1-12}$-alkylen" versteht man in der vorliegenden Erfindung eine bivalente Ethereinheit mit zwei linearen oder verzweigten Alkylgruppen mit 1 bzw. 3 bis 12, stärker bevorzugt 1 bzw. 3 bis 6 Kohlenstoffatomen, die über ein Sauerstoffatom gebunden sind. Die oben in Verbindung mit der Definition von "$C_{1-40}$-Alkyl" angegebenen Beispiele gelten auch hier für die vorhandenen Alkylgruppen. Die Einheit ist eine bivalente Einheit, die entweder über ein oder zwei C-Atome der gleichen Alkylgruppe oder über zwei C-Atome verschiedener Alkylgruppen binden kann.

Unter "$C_{1-12}$-Alkyl-thio-$C_{1-12}$-alkylen" versteht man in der vorliegenden Erfindung eine bivalente Thioethereinheit mit zwei linearen oder verzweigten Alkylgruppen mit 1 bzw. 3 bis 12, stärker bevorzugt 1 bzw. 3 bis 6 Kohlenstoffatomen, die über ein Schwefelatom gebunden sind. Die oben in Verbindung mit der Definition von "$C_{1-40}$-Alkyl" ange-

gebenen Beispiele gelten auch hier für die vorhandenen Alkylgruppen. Die Einheit ist eine bivalente Einheit, die entweder über ein oder zwei C-Atome der gleichen Alkylgruppe oder über zwei C-Atome verschiedener Alkylgruppen binden kann.

Unter "Aryl-$C_{1-12}$-alkyl-oxy-$C_{1-12}$-alkylen" versteht man in der vorliegenden Erfindung eine bivalente Einheit wie vorstehend für "$C_{1-12}$-Alkyl-oxy-$C_{1-12}$-alkylen" definiert, wobei eine Alkylgruppe mit einem Aryl substituiert ist, das ein mono- oder polycylisches aromatisches oder heteroaromatisches Ringsystem mit 5 bis 60 aromatischen Ringatomen wie nachstehend definiert darstellt.

Unter "Sulfon" wird in der vorliegenden Anmeldung eine bivalente Einheit $-S(=O)_2-$ verstanden.

Unter "$C_{1-12}$-Alkylensulfon" wird in der vorliegenden Erfindung eine Einheit $-S(=O)_2-$, die mit einer Alkylengruppe mit 1 bis 12 Kohlenstoffatomen substituiert ist. Es ist eine bivalente Einheit, die über ein C-Atom der Alkylengruppe und über das S-Atom binden kann. Die oben in Verbindung mit der Definition von "$C_{1-12}$-Alkylen" gemachte Offenbarung gilt auch für die hier bevorzugten Alkylengruppen.

Unter "Sulfoxid" wird in der vorliegenden Erfindung eine bivalente Einheit -S(=O)- verstanden.

Unter "$C_{1-12}$-Alkylensulfoxid" wird in der vorliegenden Erfindung eine Einheit -S(=O)-, die mit einer Alkylengruppe mit 1 bis 12 Kohlenstoff-atomen substituiert ist. Es ist eine bivalente Einheit, die über ein C-Atom der Alkylengruppe und über das S-Atom binden kann. Die oben in Verbindung mit der Definition von "$C_{1-12}$-Alkylen" gemachte Offenbarung gilt auch für die hier bevorzugten Alkylengruppen.

Ein mono- oder polycyclischer aromatischer oder heteroaromatischer Kohlenwasserstoffrest enthält vorzugsweise 5 bis 60, stärker bevorzugt 5 bis 20, am bevorzugtesten 5 oder 6 aromatische Ringatome. Ist die Einheit eine aromatische Einheit, so enthält sie vorzugsweise 6 bis 20, stärker bevorzugt 6 bis 10, am bevorzugtesten 6 Kohlenstoffatome als Ringatome. Ist die Einheit eine heteroaromatische Einheit enthält sie 5 bis 20, stärker bevorzugt 5 bis 10, am bevorzugtesten 5 aromatische Ringatome, von denen mindestens eines ein Heteroatom ist. Die Heteroatome sind bevorzugt ausgewählt aus N, O und/oder S. Dabei wird unter einer aromatischen bzw. heteroaromatischen Einheit entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, Benzothiophen, Benzofuran und Indol etc., verstanden.

Erfindungsgemäße Beispiele für die aromatischen oder heteroaromatischen Kohlenwasserstoffreste sind demgemäß: Benzol, Naphthalin, Anthracen, Phenanthren, Pyren, Chrysen, Benzanthracen, Perylen, Naphthacen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Unter einem mono- oder polycylischen aromatischen Ringsystem versteht man im Sinne dieser Erfindung vorzugsweise ein aromatisches Ringsystem mit 6 bis 60 Kohlenstoffatomen, bevorzugt 6 bis 30, besonders bevorzugt 6 bis 10 Kohlenstoffatomen. Unter einem aromatischen Ringsystem im Sinne der vorliegenden Erfindung soll ein System verstanden werden, das nicht notwendigerweise nur aromatische Gruppen enthält, sondern in dem auch mehrere aromatische durch eine kurze nicht-aromatische Einheit (< 10 % der von H verschiedenen Atome, vorzugsweise < 5 % der von H verschiedenen Atome), wie beispielsweise $sp^3$-hybridisierter C, O, N, etc., unterbrochen sein können. Diese aromatischen Ringsysteme können monocyclisch oder polycyclisch sein, d.h. sie können einen Ring (z.B. Phenyl) oder zwei oder mehr Ringe aufweisen, welche auch kondensiert (z.B. Naphthyl) oder kovalent verknüpft sein können (z.B. Biphenyl), oder eine Kombination von kondensierten und verknüpften Ringen beinhalten.

Bevorzugte aromatische Ringsysteme sind z.B. Phenyl, Biphenyl, Triphenyl, Naphthyl, Anthracyl, Binaphthyl, Phenanthryl, Dihydrophenanthryl, Pyren, Dihydropyren, Chrysen, Perylen, Tetracen, Pentacen, Benzpyren, Fluoren und Inden.

Unter einem mono- oder polycylischen heteroaromatischen Ringsystem versteht man im Sinne dieser Erfindung vorzugsweise ein heteroaromatisches Ringsystem mit 5 bis 60 Ringatomen, bevorzugt 5 bis 30, besonders bevorzugt 5 bis 14 Ringatomen. Das heteroaromatische Ringsystem enthält mindestens ein Heteroatom ausgewählt aus N, O und S (verbleibenden Atome sind Kohlenstoff). Unter einem heteroaromatischen Ringsystem soll zudem ein System verstanden werden, das nicht notwendigerweise nur aromatische oder heteroaromatische Gruppen enthält, sondern in dem auch mehrere aromatische bzw. heteroaromatische Gruppen durch eine kurze nicht-aromatische Einheit (< 10 % der von H verschiedenen Atome, vorzugsweise < 5 % der von H verschiedenen Atome), wie beispielsweise $sp^3$-hybridisierter C, O, N, etc., unterbrochen sein können. Diese heteroaromatischen Ringsysteme können monocyclisch oder polycyclisch sein, d.h. sie können einen Ring (z.B. Pyridyl) oder zwei oder mehr Ringe aufweisen, welche auch kondensiert oder

kovalent verknüpft sein können, oder eine Kombination von kondensierten und verknüpften Ringen beinhalten.

Bevorzugte heteroaromatische Ringsysteme sind z.B. 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder kondensierte Gruppen wie Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen. Besonders bevorzugt sind Imidazol, Benzimidazol und Pyridin.

Unter den allgemeinen Begriffen "Alkyl(en)", "Cycloalkyl(en)", "Alkylsilyl(en)", "Arylsilyl(en)", "Alkylalkoxyalkyl(en)", "Arylalkoxyalkyl(en)", "Alkylthioalkyl(en)", "Alkylensulfon", "Alkylensulfoxid" versteht man Gruppen, bei denen die Arylgruppe wie vorstehend definiert ist und die Alkylgruppen bzw. Alkylengruppen jeweils unabhängig voneinander 1 bis 12 C-Atome aufweist, wobei ein oder mehrere H-Atome durch F, Cl, Br, I, Alkyl oder Cycloalkyl, wobei ein oder mehrere $CH_2$ durch ein Heteroatom, wie NH, O oder S ersetzt sein können, oder einem aromatischen oder heteroaromatischen Kohlenwasserstoffrest mit 5 bis 20 aromatischen Ringatomen ersetzt sein können.

Eine mögliche Anwendung ist in einer Multilayer-Struktur, die eine Schicht, die eine erfindungsgemäße Verbindung der Formel (1) enthält, umfasst.

Unter eine Multilayer-Struktur versteht man eine Mehrschicht-Struktur aus zwei oder mehr Schichten, die nacheinander vorzugsweise auf einen Glasträger aufgebracht werden. Die Schichten können einzelne erfindungsgemäße Verbindungen enthalten. Es ist bevorzugt, dass die Schichten weitere Verbindungen bzw. Polymere oder Oligomere mit unterschiedlichen Eigenschaften umfassen.

Ein weiterer Gegenstand der vorliegenden Erfindung ist eine Formulierung, insbesondere eine Lösung, Dispersion oder Emulsion, enthaltend mindestens eine erfindungsgemäße Verbindung nach Formel (1) und mindestens ein Lösungsmittel. Als Lösungsmittel können alle denkbaren eingesetzt werden, die in der Lage sind die erfindungsgemäßen Verbindungen zu lösen oder mit ihnen eine Suspension zu bilden. Folgende organische Lösungsmittel sind hierbei - ohne auf die Erfindung beschränkend zu wirken - erfindungsgemäß bevorzugt: Dichlormethan, Trichlormethan, Monochlorbenzol, o-Dichlorbenzol, Tetrahydrofuran, Anisol, Morpholin, Toluol, o-Xylol, m-Xylol, p-Xylol, 1,4-Dioxan, Aceton, Methylethylketon, 1,2-Dichlorethan, 1,1,1-Trichlorethan, 1,1,2,2-Tetrachlorethan, Ethylacetat, n-Butylacetat, Dimethylformamid, Dimethylacetamid, Dimethylsulfoxid, Tetralin, Decalin, Indan und/oder Mischungen davon.

Die Konzentration der erfindungsgemäßen Verbindung der Formel (1) in der Lösung ist vorzugsweise 0,1 bis 10 Gew.-%, stärker bevorzugt 0,5 bis 5 Gew.-%, bezogen auf das Gesamtgewicht der Lösung. Optional umfasst die Lösung auch einen oder mehrere Bindemittel um die rheologischen Eigenschaften der Lösung entsprechend einzustellen, wie beispielsweise in der WO 2005/055248 A1 beschrieben.

Nach dem angemessenen Vermischen und Altern der Lösungen werden diese in eine der folgenden Kategorien eingeteilt: "Vollständige" Lösung, "grenzwertige" Lösung oder unlöslich. Die Grenzlinie zwischen diesen Kategorien wird anhand der Löslichkeitsparameter gezogen. Die entsprechenden Werte können aus der Literatur entnommen werden, wie beispielsweise aus "Crowley, J. D., Teague, G. S. Jr. und Lowe, J. W. Jr., Journal of Paint Technology, 38, No. 496, 296 (1966)".

Lösungsmittelmischungen können auch verwendet werden und werden so identifiziert, wie in "Solvents, W.H. Ellis, Federation of Societies for Coatings Technology, S. 9 bis 10, 1986" beschrieben. Solche Verfahren können zu einer Mischung von sogenannten "nicht"-Lösungsmitteln führen, die die Zusammensetzung lösen, obwohl es wünschenswert ist, wenigstens ein wirkliches Lösungsmittel in der Mischung zu haben.

Eine weitere bevorzugte Form der Formulierung ist eine Emulsion, und stärker bevorzugt eine Miniemulsion, die insbesondere als Heterophasensysteme hergestellt werden, in denen stabile Nanotröpfchen einer ersten Phase in einer zweiten kontinuierlichen Phase dispergiert werden. Die vorliegende Erfindung betrifft insbesondere eine Miniemulsion, worin die verschiedenen Komponenten der erfindungsgemäßen Verbindung entweder in der gleichen Phase oder in verschiedenen Phasen angeordnet sind. Bevorzugte Verteilungen sind die Folgenden:

1) Die Mehrzahl aller erfindungsgemäßen Verbindungen und die Mehrzahl aller funktionalen Verbindungen befinden sich in der kontinuierlichen Phase;
2) Die Mehrzahl aller erfindungsgemäßen Verbindungen befindet sich in Nanotröpfchen und die Mehrzahl aller weiteren funktionalen Verbindungen, wie zum Beispiel die Hostverbindung, befindet sich in der kontinuierlichen Phase.

Sowohl eine Miniemulsion, worin die kontinuierliche Phase eine polare Phase ist, als auch eine inverse Miniemulsion, worin die kontinuierliche Phase eine nicht polare Phase ist, können in der vorliegenden Erfindung verwendet werden. Die bevorzugte Form ist eine Miniemulsion. Um die kinetische Stabilität der Emulsion zu erhöhen, können auch Tenside beigemischt werden. Die Wahl der Lösungsmittel für zweiphasige Systeme, der Tenside und der Verarbeitung zu einer stabilen Miniemulsion sollten für einen Fachmann auf diesem Gebiet auf Basis seinen Fachwissens oder durch zahlreiche Veröffentlichungen bekannt sein, wie zum Beispiel ein umfassender Artikel von Landfester in Annu. Rev, Mater. Res. (06), 36, S. 231.

Zur Verwendung von sogenannten Dünnschichten in elektronischen oder optoelektronischen Vorrichtungen kann die erfindungsgemäße Verbindung oder eine Formulierung dieser durch ein entsprechend geeignetes Verfahren abgeschieden werden. Flüssigbeschichtung von Vorrichtungen, wie zum Beispiel von OLEDs, ist wünschenswerter als Vakuumabscheidungstechniken. Abscheidungsverfahren aus Lösung sind besonders bevorzugt. Bevorzugte Abscheidungstechniken schließen, ohne die Erfindung entsprechend einzuschränken, Tauchbeschichtung, Spin-coating, Tintenstrahl-Druck, "Letter-press"-Druck, "Screenprinting", "Doctor Blaid"-Beschichten, "Rollerprinting", "Reverse-Rollerprinting", Offset-Lithographie, flexographisches Drucken, "Webprinting", Sprühbeschichten, Pinselbeschichten oder "Padprinting" und "Slot-die coating" ein. Tintenstrahldruck ist besonders bevorzugt und es ermöglicht die Herstellung von hochauflösenden Displays.

Die erfindungsgemäßen Lösungen können auf vorgefertigte Vorrichtungssubstrate mithilfe von Tintenstrahldruck oder durch Mikroverabreichung aufgebracht werden. Bevorzugt werden hierzu industrielle piezoelektrische Druckköpfe, wie von Aprion, Hitachie-Koki, Inkjet Technology, On Target Technology, Picojet, Spectra, Trident, Xaar verwendet werden, um die organischen Halbleiterschichten auf ein Substrat aufzubringen. Zusätzlich können auch halbindustrielle Druckköpfe, wie solche von Brother, Epson, Konika, Seiko Instruments, Toshiba TEC oder eindüsige Mikroverabreichungsgeräten, wie sie zum Beispiel von Mikrodrop und Mikrofab hergestellt werden, verwendet werden.

Damit die erfindungsgemäße Verbindung durch Tintenstrahl-Druck oder Mikroverabreichung aufgebracht werden kann, sollte sie zunächst in einem geeigneten Lösungsmittel gelöst werden. Die Lösungsmittel müssen die oben genannten Anforderungen erfüllen und dürfen nicht irgendwelche nachteiligen Wirkungen auf den ausgewählten Druckkopf haben. Zusätzlich sollten die Lösungsmittel einen Siedepunkt von über 100°C, vorzugsweise über 140°C und stärker bevorzugt über 150°C haben, um Verarbeitungsprobleme zu vermeiden, die durch das Austrocken der Lösung im Inneren des Druckkopfes hervorgerufen werden. Neben den oben genannten Lösungsmitteln sind auch die folgenden Lösungsmittel geeignet: Substituierte und nicht substituierte Xylolderivate, Di-$C_{1-2}$- Alkylformamide, substituierte und nicht substituierte Anisole und andere Phenoletherderivate, substituierte Heterozyklen, wie substituierte Pyridine, Pyrapsine, Pyrimidine, Pyrrolidinone, substituierte und nicht substituierte N, N-Di-$C_{1-2}$-Alkylaniline und andere fluorierte oder chlorierte Aromaten.

Ein bevorzugtes Lösungsmittel für die Ablagerung der erfindungsgemäßen Verbindung durch Tintenstrahl-Druck umfasst ein Benzolderivat, das einen durch einen oder mehrere Substituenten substituierten Benzolring aufweist, worin die Gesamtzahl der Kohlenstoffatome des einen oder der mehreren Substituenten wenigstens drei ist. So kann zum Beispiel das Benzolderivat mit einer Propylgruppe oder drei Methylgruppen substituiert sein, wobei in jedem Fall die Gesamtanzahl der Kohlenstoffatome wenigstens drei sein muss. Ein solches Lösungsmittel ermöglicht die Bildung einer Tintenstrahl-Flüssigkeit, die das Lösungsmittel mit der erfindungsgemäßen Verbindung umfasst, und vermindert oder verhindert das Verkleben der Düsen und die Trennung der Komponenten während dem Aufsprühen. Das/die Lösungsmittel kann/können (ein) solche(s) sein, das/die aus der folgenden Beispielsliste ausgewählt wird/werden: Dodecylbenzol, 1-Methyl-4-tert-butylbenzol, Terpineollimonen, Isodurol, Terpinolen, Cymol und Dethylbenzol. Das Lösungsmittel kann auch eine Lösungsmittelmischung aus zwei oder mehr Lösungsmittel sein, wobei jedes der Lösungsmittel vorzugsweise einen Siedepunkt von größer 100 °C, stärker bevorzugt größer 140 °C aufweist. Solche Lösungsmittel fördern die Filmbildung der abgelagerten Schicht und vermindern Schichtfehler.

Die Tintenstrahl-Flüssigkeit, (das heißt eine Mischung vorzugsweise aus Lösungsmittel(n), Bindemittel und der erfindungsgemäßen Verbindung) weist vorzugsweise eine Viskosität bei 20°C von 1 bis 100 mPa·s, stärker bevorzugt 1 bis 50 mPa·s und am stärksten bevorzugt 1 bis 30 mPa·s auf.

Die erfindungsgemäße Verbindung oder Formulierung kann zusätzlich ein oder mehrere weitere Komponenten wie zum Beispiel oberflächenaktive Substanzen, Gleitmittel, Benetzungsmittel, Dispergiermittel, wasserabweisende Mittel, Haftmittel, Fließverbesserer, Antischäumungsmittel, Luftabscheidungsmittel, Verdünnungsmittel, die reaktive oder nicht reaktive Substanzen sein können, Hilfsmittel, Farbmittel, Farbstoffe oder Pigmente, Sensibilisatoren, Stabilisatoren oder Inhibitoren umfassen.

Ein weiterer Gegenstand der Erfindung ist die Verwendung der oben genannten erfindungsgemäßen Verbindungen in einer in Anspruch 10 genannten elektronischen oder optoelektronischen Vorrichtung. Möglich ist die Anwendung auch in einer organischen Elektrolumineszenzvorrichtung, insbesondere einer organischen Licht-emittierenden Diode. Die erfindungsgemäßen Verbindungen sind dabei bevorzugt als oder in einer Schicht ausgebildet. Eine Schicht wird vorzugsweise gebildet, indem eine erfindungsgemäße Formulierung auf einen Träger aufgebracht und anschließend das Lösungsmittel entfernt wird.

Ein weiterer Gegenstand der vorliegenden Erfindung ist eine elektronische Vorrichtung nach Anspruch 11 enthaltend ein(e) erfindungsgemäße Verbindung.

Geeignete Matrixmaterialien in elektronischen Vorrichtungen sind dem Fachmann bekannt und können entsprechend verwendet werden. Als geeignete Matrixmaterialien in elektronischen Vorrichtungen für Verbindungen der Formel (1) eignen sich bspw. CBP (N,N-Biscarbazolylbiphenyl), Carbazolderivate (z. B. gemäß WO 2005/039246, US 2005/0069729, JP 2004/288381, EP 1205527 oder WO 2008/086851), Azacarbazole (z. B. gemäß EP 1617710, EP 1617711, EP 1731584, JP 2005/347160), Ketone (z. B. gemäß WO 2004/093207 oder gemäß DE 102008033943), Phosphinoxide, Sulfoxide und Sulfone (z. B. gemäß WO 2005/003253), Oligophenylene, aromatische Amine (z. B. gemäß US 2005/0069729), bipolare Matrixmaterialien (z. B. gemäß WO 2007/137725), Silane (z. B. gemäß WO 2005/111172), 9,9-Diarylfluorenderivate (z. B. gemäß DE 102008017591), Azaborole oder Boronester (z. B. gemäß WO 2006/117052), Triazin-Derivate (z. B. gemäß DE 102008036982), Indolocarbazolderivate (z. B. gemäß WO 2007/063754 oder WO 2008/056746), Indenocarbazolderivate (z. B. gemäß der nicht offen gelegten Anmeldung DE 102009023155.2 und DE 102009031021.5), Diazaphospholderivate (z. B. gemäß der nicht offen gelegten Anmeldung DE 102009022858.6), Triazol-Derivate, Oxazole und Oxazol-Derivate, Imidazol-Derivate, Polyarylalkan-Derivate, Pyrazolin-Derivate, Pyrazolon-Derivate, Distyrylpyrazin-Derivate, Thiopyrandioxid-Derivate, Phenylendiamin-Derivate, tertiäre aromatische Amine, Styrylamine, Amino-substituierte Chalcon-Derivate, Indole, Hydrazon-Derivate, Stilben-Derivate, Silazan-Derivate, aromatische Dimethyliden-Verbindungen, Carbodiimid-Derivate, Metallkomplexe von 8-Hydroxychinolin-Derivaten wie z.B. $AlQ_3$, die 8-Hydroxychinolin-Komplexe können auch Triarylaminophenol-Liganden enthalten (US 2007/0134514 A1), Metallkomplex-Polysilan-Verbindungen sowie Thiophen-, Benzothiophen- und Dibenzothiophen-Derivate.

Die Materialien können als Reinmaterialien oder gedopt verwendet werden wie z.B. CBP intrinsisch oder gedopt mit BczVBi (= 4,4'-(Bis(9-ethyl-3-carbazovinylen)-1,1'-biphenyl).

Es ist weiterhin bevorzugt, Mischungen aus zwei oder mehreren der oben genannten Matrixmaterialien zu verwenden, insbesondere Mischungen aus einem elektronentransportierenden Material und einem lochtransportierenden Material.

Beispiele für bevorzugte Carbazolderivate sind mCP (= 1,3-N,N-dicarbazol-benzol (= 9,9'-(1,3-Phenylen)bis-9H-carbazol), Formel (295), US 2005/0249976), CDBP (= 9,9'-(2,2'-Dimethyl[1,1'-biphenyl]-4,4'-diyl)bis-9H-carbazol), 1,3-Bis(N,N'-dicarbazol)benzol (= 1,3-Bis(carbazol-9-yl)benzol), PVK (Polyvinylcarbazol), 3,5-Di(9H-carbazol-9-yl)biphenyl sowie die weiteren, unten abgebildeten Verbindungen mit den Formel (296) bis (299) (s. auch US 2007/0128467, US 2007/0128467).

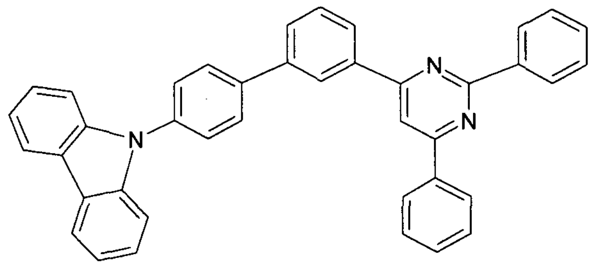

Formel (295)

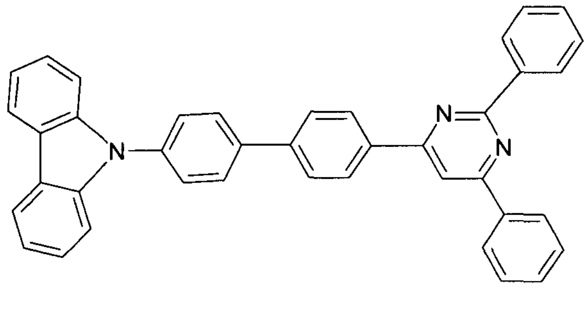

Formel (296)

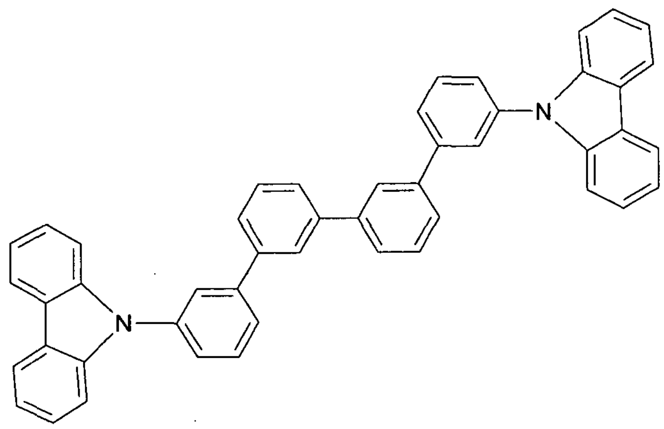

Formel (297)

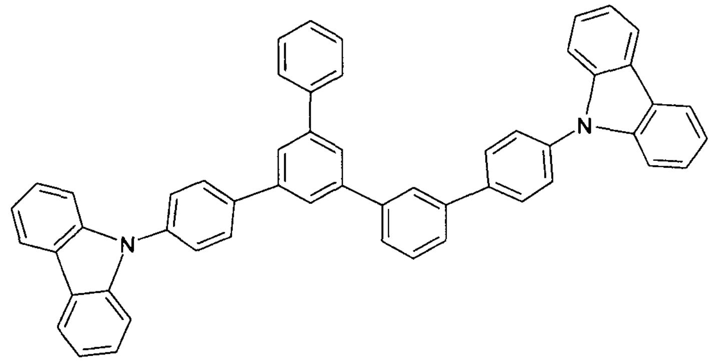

Formel (298)

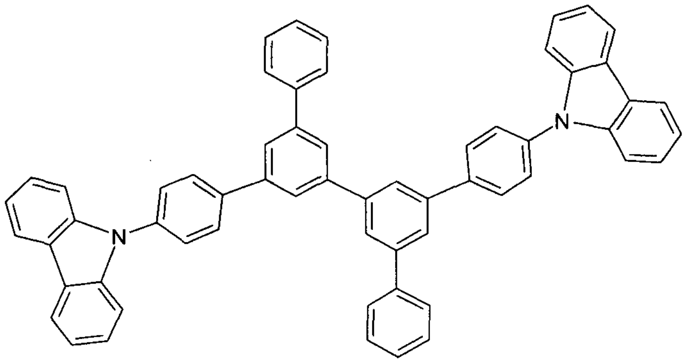

Formel (299)

Weitere bevorzugte Matrixmaterialien sind Si-Tetraarylewie sie bspw. in US 004/209115, US 2004/0209116 US 2007/0087219, US 2007/0087219 und H. Gilman, E.A. Zuech, Chemistry&Industry (London, United Kingdom), 1960, 120 offenbart sind, besonders bevorzugt hierbei sind die Verbindungen der Formeln (300) bis (307).

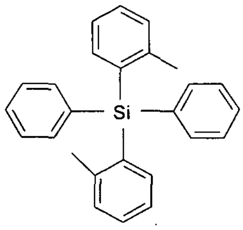

Formel (300)

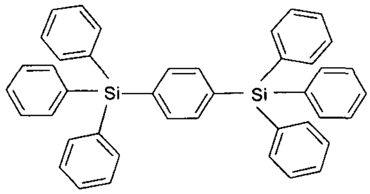

Formel (301)

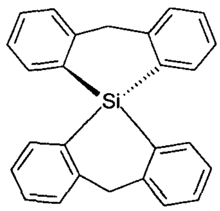

Formel (302)

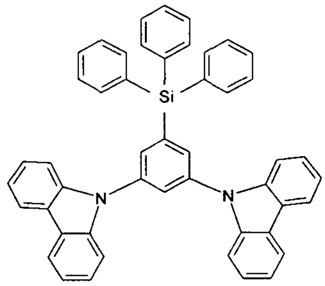

Formel (303)

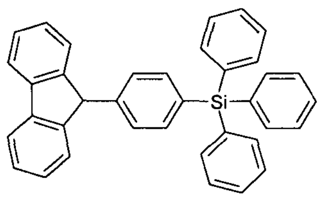

Formel (304)

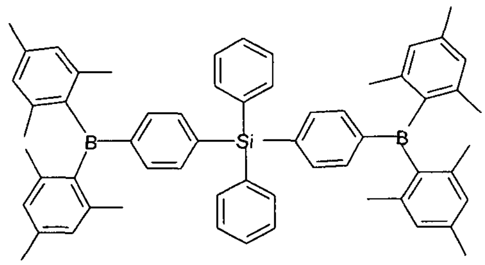

Formel (305)

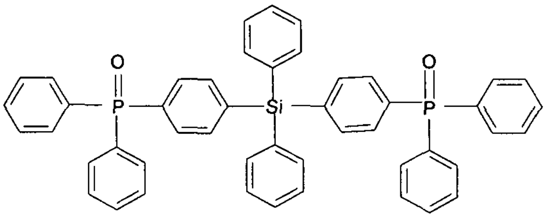

Formel (306)

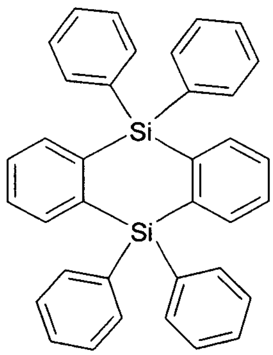

Formel (307)

Besonders bevorzugte Matrixmaterialien für phosphoreszierende Dotanden sind Verbindungen in EP 652273, DE 102009022858.6, DE 102009023155.2, WO 2007/063754 und WO 2008/056746, insbesondere die Verbindungen der Formeln (308) bis (311).

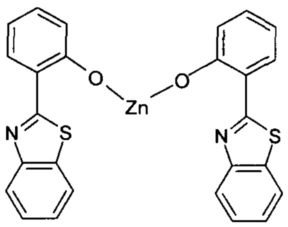

Formel (308)

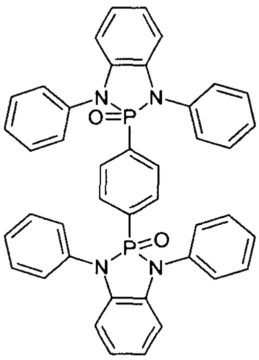

Formel (309)

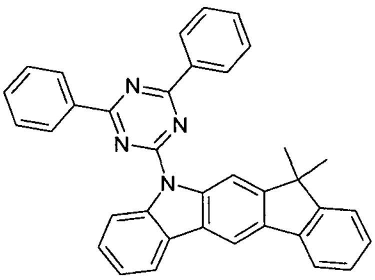

Formel (310)

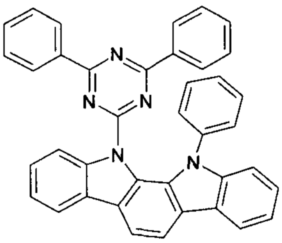

Formel (311)

Die elektronische Vorrichtung ist vorzugsweise eine organische Elektrolumineszenzvorrichtung, enthaltend vorzugsweise eine Kathode, eine Anode und mindestens eine organische Schicht, wobei die organische Schicht die Verbindung oder Formulierung enthält.

Wie eben ausgeführt ist die organische Schicht, die die Verbindung oder Formulierung enthält, vorzugsweise die emittierende Schicht. Die organische Elektrolumineszenzvorrichtung kann darüber hinaus weitere Schichten enthalten, ausgewählt aus jeweils einer oder mehrerer Lochinjektionsschichten, Lochtransportschichten, Lochblockierschichten, Elektronentransportschichten, Elektroneninjektionsschichten, Elektronenblockierschichten, Ladungserzeugungsschichten und/oder Schichten, welche organische oder anorganische P/N-Übergänge erzeugen. Die elektrolumineszierende Vorrichtung kann darüber hinaus weitere emittierende Schichten enthalten. Vorzugsweise sind zwischen zwei emittierenden Schichten sogenannte Interlayer eingebracht, welche beispielsweise eine Excitonen-blockierende Funktion aufweisen. Es sei aber darauf hingewiesen, dass nicht notwendigerweise jede dieser Schichten vorhanden sein muss.

Die organische Elektrolumineszenzvorrichtung weist vorzugsweise eine planare Form auf und/oder ist Faserförmig.

Unter einer Faser wird jede Form verstanden, in dem das Verhältnis zwischen Länge zu Durchmesser größer oder gleich 10:1, bevorzugt 100:1 ist, wobei es auf die Form des Querschnitts entlang der Längenachse nicht ankommt. Der Querschnitt entlang der Längenachse kann demnach bspw. rund, oval, dreieckig, viereckig oder polygonal sein. Lichtemittierende Fasern weisen bevorzugte Eigenschaften hinsichtlich ihrer Verwendung auf. So eignen sie sich u.a. für die Anwendung im Bereich der therapeutischen und/oder kosmetischen Phototherapie. Weitere Einzelheiten hierzu sind im Stand der Technik beschrieben (bspw. in US 6538375, US 2003/0099858, Brenndan O'Connor et al. (Adv. Mater. 2007, 19, 3897-3900 und der nicht offengelegten Patentanmeldung EP 10002558.4).

Wenn die organische Elektrolumineszenzvorrichtung mehrere emittierende Schichten enthält, weisen diese mehreren Schichten bevorzugt insgesamt mehrere Emissionsmaxima zwischen 380 nm und 750 nm auf, so dass insgesamt weiße Emission resultiert, d.h. in den emittierenden Schichten werden verschiedene emittierende Verbindungen verwendet, die fluoreszieren oder phosphoreszieren können. Insbesondere bevorzugt sind drei Schichtsysteme, wobei die drei Schichten blaue, grüne und orange oder rote Emission zeigen, für den prinzipiellen Aufbau siehe zum Beispiel WO 2005/011013.

Die verschiedenen Schichten können unterschiedlich aufgetragen werden. Beispielsweise kann in der Elektrolumineszenzvorrichtung eine oder mehrere Schichten aus Lösung sowie eine oder mehrere Schichten über ein Sublimationsverfahren aufgebracht werden. Dabei werden die Materialien in Vakuumsublimationsanlagen bei einem Druck kleiner als $10^{-5}$ mbar, bevorzugt kleiner als $10^{-6}$ mbar, besonders bevorzugt kleiner als $10^{-7}$ mbar aufgedampft. Ebenfalls

ist es möglich, eine oder mehrere Schichten mit OVPD-(Organic Vapor Phase Deposition)-Verfahren oder mit Hilfe einer Trägergassublimation aufzubringen. Dabei werden die Materialien bei einem Druck zwischen $10^{-5}$ mbar und 1 bar aufgebracht. Ein Spezialfall dieses Verfahrens ist das OVJP-(Organic Vapor Jet Printing)-Verfahren, bei dem die Materialien direkt durch eine Düse aufgebracht und so strukturiert werden (z.B. M. S. Arnold et al., Appl. Phys. Lett. 2008, 92, 053301).

Besonders bevorzugt ist jedoch, dass eine oder mehrere Schichten in der organischen Elektrolumineszenzvorrichtung aus Lösung aufgebracht werden, beispielsweise durch Spin-Coating oder mit einem beliebigen Druckverfahren, wie zum Beispiel Siebdruck, Flexodruck oder Offsetdruck. Besonders bevorzugt aber LITI (Laser Induced Thermal Imaging, Thermotransferdruck), oder Inkjet-Druck (Tintenstrahldruck). Diese Verfahren sind dem Fachmann generell bekannt und können von ihm ohne Probleme auf organische Elektrolumineszenzvorrichtungen angewandt werden.

Die Vorrichtung enthält gewöhnlich eine Kathode und eine Anode (Elektroden). Die Elektroden (Kathode, Anode) werden so gewählt, dass ihr Potential möglichst gut mit dem Potential der angrenzenden organischen Schicht übereinstimmt, um eine möglichst effiziente Elektronen- bzw. Lochinjektion zu gewährleisten.

Als Kathode sind Metallkomplexe, Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide in Frage (z.B. LiF, $Li_2O$, $BaF_2$, MgO, NaF, etc.). Die Schichtdicke dieser Schicht beträgt bevorzugt zwischen 1 und 10 nm, mehr bevorzugt zwischen 2 und 8 nm.

Als Anode sind Materialien mit hoher Austrittsarbeit bevorzugt. Bevorzugt weist die Anode ein Potential größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/$NiO_x$, Al/$PtO_x$) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere.

Die Vorrichtung wird in an sich bekannter Weise je nach Anwendung entsprechend strukturiert, kontaktiert und schließlich hermetisch versiegelt, da sich die Lebensdauer derartiger Vorrichtungen bei Anwesenheit von Wasser und/oder Luft drastisch verkürzt.

Die erfindungsgemäße organische elektronische Vorrichtung ist ausgewählt aus der Gruppe, bestehend aus Farbsofflichtempfindlichen Solarzellen (DSSCs) und organischen Solarzellen (O-SCs).

Der Aufbau von elektronischen Vorrichtungen ist einem Fachmann auf dem Gebiet von elektronischen Vorrichtungen bekannt. Nichtsdestotrotz werden im Folgenden einige Literaturstellen angegeben, die eine detaillierte Vorrichtungsstruktur offenbaren.

Eine organische Plasma-emittierende Vorrichtung ist vorzugsweise eine Vorrichtung wie sie von Koller et al., in Nature Photonics (08), 2, Seiten 684 bis 687 beschrieben wird. Das sogenannte OPED ist dem weiter oben beschriebenen OLED sehr ähnlich, abgesehen davon, dass zumindest die Anode oder Kathode in der Lage sein soll, das Oberflächenplasma auf der emittierenden Schicht zu verankern.

Ein organischer lichtemittierender Transistor (OLET) hat eine sehr ähnliche Struktur wie ein organischer Feldeffekttransistor, aber mit einem bipolaren Material als Aktivschicht zwischen der Quelle und dem Abfluss. Die kürzlich neueste Entwicklung kann aus einer Veröffentlichung von Muccini et al., in Nature Materials 9, 496 bis 503 (2010) entnommen werden.

Elektrophotographische Elemente umfassen ein Substrat, eine Elektrode und eine Ladungstransportschicht oberhalb der Elektrode, sowie optional eine Ladungserzeugungsschicht zwischen der Elektrode und der Ladungstransportschicht. Bezüglich diverser Details und Variationen solcher Vorrichtungen und Materialien, die hierin verwendet werden können, wird auf das Buch "Organic Photoreceptors for Xerography" von Marcel Dekker, Inc., Ed. by Paul M. Borsenberger & D. S. Weiss (1998) verwiesen.

Eine besonders bevorzugte organische Spintronic-Vorrichtung ist eine Drehventil-Vorrichtung, wie von Z. H. Xiong et al., in Nature 2004 Vol. 727, Seite 821 berichtet, die zwei ferromagnetische Elektroden und eine organische Schicht zwischen den zwei ferromagnetischen Elektroden umfasst, worin wenigstens eine der organischen Schichten, die eine Verbindung der Formel (1) und die ferromagnetische Elektrode umfasst, aus Cobalt, Nickel, Eisen oder einer Legierung davon zusammengesetzt ist, oder einem $ReMnO_3$ oder $CrO_2$, worin Re ein Seltenerdelement ist.

Organische lichtemittierende elektrochemische Zellen (OLECs) umfassen zwei Elektroden und eine Mischung aus Elektrode und fluoreszierender Spezies dazwischen, wie zuerst von Pei & Heeger in Science (95), 269, Seiten 1086

bis 1088 berichtet.

Farbstoffsensibilisierte Solarzellen (DSSCs) umfassen in der folgenden Abfolge eine Elektrode/einen farbstoffsensibilisierten $TiO_2$ porösen Dünnfilm/einen Elektrolyten /eine Gegenelektrode, wie zuerst von O'Regan & Grätzel in Nature (91), 353, Seiten 737 bis 740 berichtet. Die flüssige Elektrode kann durch eine feste Lochtransportschicht ersetzt werden, wie in Nature (98), 395, Seiten 583 bis 585 berichtet.

Organische Solarkonzentratoren (OSC) können wie in dem Bericht von Baldo et al., in Science 321, 226 (2008) verwendet werden. Ein OSC besteht aus einem Dünnfilm aus organischen Farbstoffen, die auf einem Glassubstrat mit einem hohen Brechungsindex abgeschieden sind. Der Farbstoff absorbiert einfallende Sonnenenergie und reemittiert diese bei niedriger Energie. Die Mehrzahl der reemittierten Photonen werden von einem Wellenleiter durch interne Totalreflektion voll umfänglich eingefangen. Dies geschieht durch eine Photovoltaik-Vorrichtung, die am Substratrand angeordnet ist.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit.ist jedes in der vorliegenden. Erfindung offenbartes Merkmal, sofern nichts anderes gesagt wurde, als Beispiel einer generischen Reihe oder als äquivalentes oder ähnliches Merkmal zu betrachten.

Alle Merkmale der vorliegenden Erfindung können in jeder Art miteinander kombiniert werden, es sei denn dass sich bestimmte Merkmale und/oder Schritte sich gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Die mit der vorliegenden Erfindung offengelegte Lehre zum technischen Handeln kann abstrahiert und mit anderen Beispielen kombiniert werden.

Die Erfindung wird durch die nachfolgenden Beispiele näher erläutert, ohne sie dadurch einschränken zu wollen.

**Synthese- und Beispiele:**

Die folgenden Materialen wurden in diesen Beispielen verwendet:

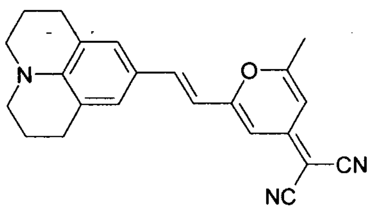

S1 (DCM)

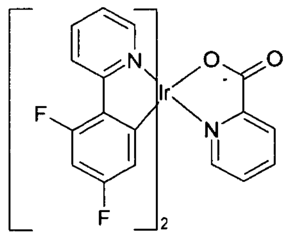

T1

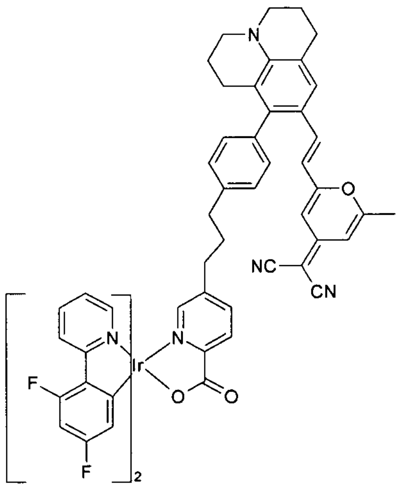

E1

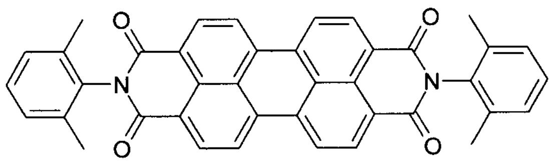

S2

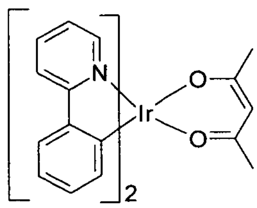

T2

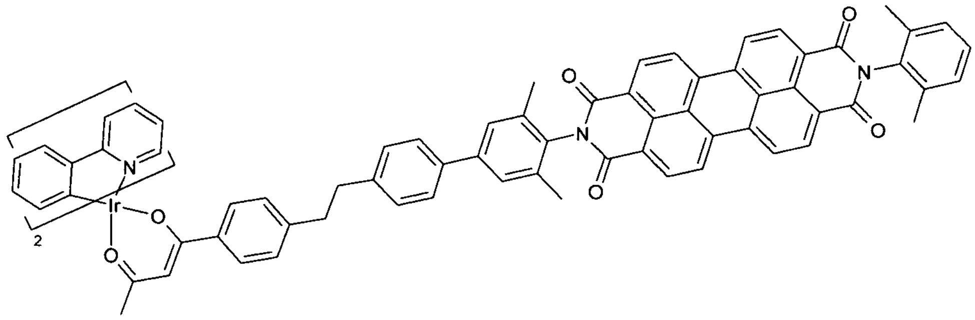

E2

S1 (DCM) ist ein Laser-Farbstoff, gekauft bei Lambda Physik AG, D-37079 Goettingen, Germany.

S2 (N,N'-Bis(2,6-dimethylphenyl)perylen-3,4,9,10-tetracarnsäurediimid) ist ein Farbstoff für Solarzellen und wurde bei Sigma-Aldrich mit Produkt-Nr. 14799 gekauft.

T1 (FIrpic) ist ein blauer Triplett-Emitter, und wurde bei Luminescence Technology Corp. Taiwan, R.O. China gekauft.

T2 ist ein grüner Triplett Emitter, und wurde nach J. Am. Chem Soc. Vol 123, 4304 (2001) synthetisiert.

TMM-080 und TMM-102 sind die Matrix-Materialen von Merck KGaA. Diese wurden 1:1 als Matrix gemischt.

**Beispiel 1:**

**Synthesen der Verbindungen E1 & E2**

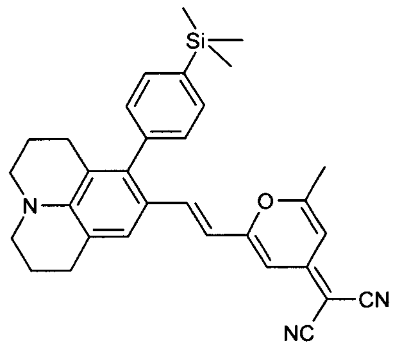

**(I)**

Verbindung (**I**) wird gemäß Patentschrift WO 2005/121274 synthetisiert

**2-(2-{(E)-2-[8-(4-Iodo-phenyl)-2,3,6,7-tetrahydro-1H,5H-pyrido[3,2,1-ij] quinolin-9-yl]-vinyl}-6-methyl-pyran-4-yliden)-malononitril 2**

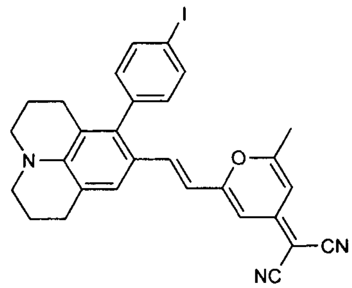

(II)

50 g (99 mmol) von Verbindung (I) werden in 500 ml Dichlormethan gelöst und auf 0°C abgekühlt und sorgfältig entgast. Die Reaktionsmischung wird anschließend mit 100 ml einer 1 M HCl-Lösung in Dichlormethan versetzt und für 2 h bei 0°C gerührt. Die Lösung wird auf Raumtemperatur erwärmt und vorsichtig mit einer gesättigten $Na_2S_2O_3$ versetzt bis die rötliche Färbung verschwunden ist. Anschließend werden die Phasen getrennt. Die wässrige Phase wird dreimal mit Dichlormethan extrahiert, anschließend die vereinigten organischen Phasen zweimal mit Wasser gewaschen, über Magnesiumsulfat getrocknet, filtriert und das Lösungsmittel im Vakuum abgezogen. Der Rückstand wird aus Isopropanol umkristallisiert.

Man erhält 52.6 g (94 mmol) (95%) eines roten Feststoffes in einer von Reinheit 99,7%.

**Iridiumkomplex (III)**

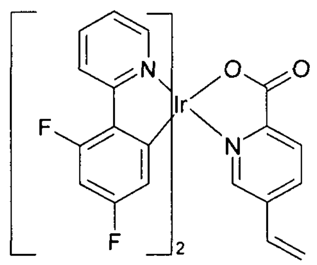

**(III)**

Verbindung (**III**) wird gemäß Patentschrift JP 2005/15508A synthetisiert.

**DCM - Iridiumdipehnylpyridinkomplex (E1)**

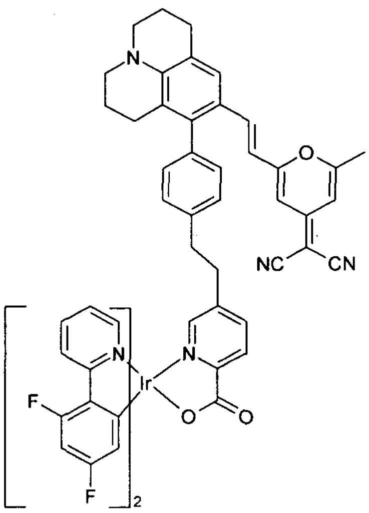

**E1**

8 g (11 mmol) Iridiumkomplex (**III**) und 2.7 g (11 mmol) 9-BBN-Dimer werden unter Schutzgas in 200 ml Toluol bei Raumtemperatur gelöst und für 20 h gerührt. Während der Reaktion löst sich die Suspension von 9-BBN langsam auf. Anschließend werden der Reaktionslösung 6.1 g (11 mmol) Iod-DCM-Komplex und 40 ml einer 1 M NaOH Lösung zugesetzt. Die Reaktionsmischung wird sorgfältig entgast und mit 50 mg Tetrakistriphenylphosphin-palladium versetzt und für 20 h unter Rückfluss erhitzt. Die Lösung wird auf Raumtemperatur abgekühlt und die Phasen getrennt. Die wässrige Phase wird dreimal mit Toluol extrahiert, anschließend die vereinigten organischen Phasen zweimal mit Wasser gewaschen, über Magnesiumsulfat getrocknet, filtriert und das Lösungsmittel im Vakuum abgezogen. Der Rückstand wird aus Ethanol/Toluol 3:1 umkristallisiert. Man erhält 7.2 g (6.3 mmol) (57%) eines weißen Feststoffes mit einer Reinheit von 99,8%.

**2-(2,6-Dimethyl-phenyl)-9-(4-iodo-2,6-dimethyl-phenyl)-anthra[2,1,9-def;6,5,10-d'e'f]diisoquinoline-1,3,8,10-tetraon 4**

Das Tetranon (**IV**) wird wie in Journal Phys. Chem. C 2007 111 4861 beschrieben über folgendem Weg erhalten:

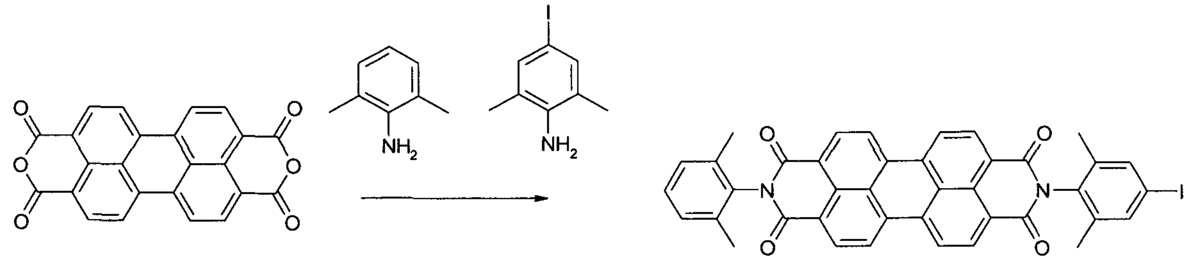

(IV)

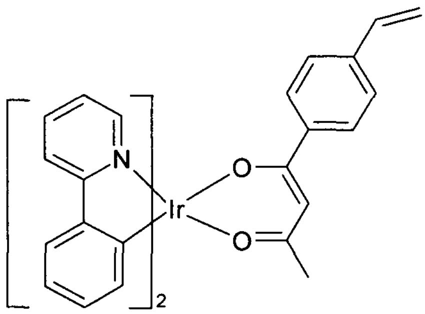

(V)

Verbindung (**V**) wird gemäß Patentschrift JP 2005/15508A synthetisiert.

**Perylen-Iridiumkomplex E2**

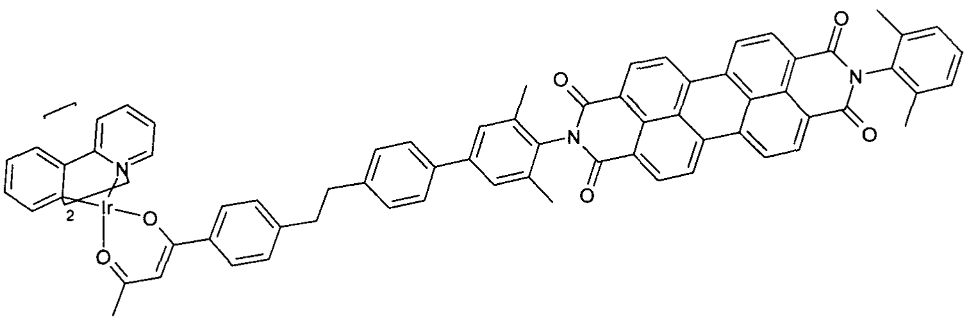

**E2**

5 g (7.2 mmol) Iridiumkomplex (**V**) und 1.8 g (7.2 mmol) 9-BBN-Dimer werden unter Schutzgas in 50 ml Toluol bei Raumtemperatur gelöst und für 20 h gerührt. Während der Reaktion löst sich die Suspension von 9-BBN langsam auf. Anschließend werden der Reaktionslösung 5.2 g (7.2 mmol) Iod-Tetraon (**IV**) und 20 ml einer 1 M NaOH Lösung zugesetzt. Die Reaktionsmischung wird sorgfältig entgast und mit 30 mg Tetrakistriphenylphosphin-palladium versetzt und für 20 h zum Rückfluss erhitzt. Die Lösung wird auf Raumtemperatur abgekühlt und die Phasen getrennt. Die wässrige Phase wird dreimal mit Toluol extrahiert, anschließend die vereinigten organischen Phasen zweimal mit Wasser gewaschen, über Magnesiumsulfat getrocknet, filtriert und das Lösungsmittel im Vakuum abgezogen. Der Rückstand wird aus Ethanol/Toluol 3:1 umkristallisiert. Man erhält 4.4 g (3.2 mmol) (45%) eines weißen Feststoffes mit einer Reinheit von 99,6%.

**Beispiel 2 (nicht beansprucht)**

**Herstellung und Charakterisierung von organischen Elektrolumineszenzvorrichtungen, enthaltend die erfindungsgemäße Verbindung E1**

Die Herstellung einer organischen Leuchtdiode aus Lösung ist in der Literatur bereits vielfach beschrieben (z.B. in der WO 2004/037887 A2). Um die vorliegende Erfindung beispielhaft zu erläutern, werden OLEDs mit verschiedenen Kombinationen von S1, T1 & E1 in Matrix durch Spincoating hergestellt. Eine typische OLED-Vorrichtung hat einen Schichtaufbau: ITO/HIL/Interlayer/EML/Kathode, wobei HIL auch Pufferschicht genannt wird.

Dazu werden Substrate der Firma Technoprint (Sodalimeglas) verwendet, auf welche die ITO-Struktur (Indium-Zinn-Oxid, eine transparente, leitfähige Anode) aufgebracht wird.

Die Substrate werden im Reinraum mit deionisiertem Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spincoater-Geometrie ab (typisch für 80 nm: 4500 rpm). Um Restwasser aus der Schicht zu entfernen, werden die Substrate für 10 Minuten bei 180°C auf einer Heizplatte ausgeheizt. Danach werden unter Inertgasatmosphäre (Stickstoff bzw. Argon) zunächst 20 nm einer Interlayer (typischerweise ein lochdominiertes Polymer, hier HIL-012 von Merck) und dann 80 nm der emittierenden Schichten (EML für Emissive Layer) aus Lösungen (Konzentration 24 g/l in Chlorbenzol, die Kompositionen für die verschiedene EMLs, und denen Konzentrationen sind in Tabelle 1 aufgelistet) aufgebracht. Alle EML Schichten werden bei 180°C mindestens 10 Minuten ausgeheizt. Danach wird die Ba/Al-Kathode aufgedampft (hochreine Metalle von Aldrich, besonders Barium 99,99% (Best-Nr. 474711); Aufdampfanlagen von Lesker o.a., typischer Vakuumlevel 5 x $10^6$ mbar). Um vor allem die Kathode vor Luft und Luftfeuchtigkeit zu schützen, wird die Vorrichtung abschließend verkapselt und dann charakterisiert.

Tabelle 1: Die EML Kompositionen in verschiedene OLEDs

| Device | EML Kompositionen [wt%] | EML Dicke | Konzentration [g/l] |
|---|---|---|---|
| OLED1 | 47.5%TMM-080:47.5%TMM-012:5%S1 | 80 nm | 24 |
| OLED2 | 47.5%TMM-080:47.5%TMM-012:5%T1 | 65 nm | 24 |
| OLED3 | 47.5%TMM-080:47.5%TMM-012:5%E1 | 80 nm | 24 |

Dazu werden die Devices in für die Substratgröße eigens angefertigte Halter eingespannt und mittels Federkontakten kontaktiert. Eine Photodiode mit Augenverlaufsfilter kann direkt auf den Messhalter aufgesetzt werden, um Einflüsse von Fremdlicht auszuschließen.

Typischerweise werden die Spannungen von 0 bis max. 20 V in 0,2 V-Schritten erhöht und wieder erniedrigt. Für jeden Messpunkt wird der Strom durch die Vorrichtung sowie der erhaltene Photostrom von der Photodiode gemessen. Auf diese Art und Weise erhält man die IVL-Daten der Testvorrichtungen. Wichtige Kenngrößen sind die gemessene maximale Effizienz ("Eff." in cd/A) und die für 100 cd/$m^2$ benötigte Spannung $U_{100}$.

Um außerdem die Farbe und das genaue Elektrolumineszenzspektrum der Testvorrichtungen zu kennen, wird nach der ersten Messung nochmals die für 100 cd/$m^2$ benötigte Spannung angelegt und die Photodiode durch einen Spektrum-Messkopf ersetzt. Dieser ist durch eine Lichtleitfaser mit einem Spektrometer (Ocean Optics) verbunden. Aus dem gemessenen Spektrum können die Farbkoordinaten (CIE: Commission International de l'éclairage, Normalbetrachter von 1931) abgeleitet werden.

Die Ergebnisse, die bei Verwendung der Emitter S1, T1 & E1 in OLEDs erhalten werden, sind in Tabelle 2 zusammengefasst.

Tabelle 2

| Device | Max. Eff. [cd/A] | U(100) [V] | CIE @ 100 cd/$m^2$ | EQE @ Max. Eff. |
|---|---|---|---|---|
| OLED1 | 1.26 | 6.4 | 0.61, 0.39 | 0.86% |
| OLED2 | 1.97 | 6.5 | 0.18,0.40 | 1.30% |
| OLED3 | 2.80 | 6.5 | 0.61, 0.39 | 1.90% |

Wie man aus den Ergebnissen erkennen kann, stellt die OLED3 eine deutliche Verbesserung gegenüber den

zwei Referenzen OLED1 & OLED2 hinsichtlich der Max Effizienz und EQE dar.

**Beispiel 3:**

**Solarzellen enthaltende S2 und E2.**

Die Herstellung, das Messen und die Charakterisierung einer organischen Solarzelle aus Lösung ist in der Literatur bereits vielfach beschrieben (z.B. in Appl. Phys. Lett., Vol. 84, No. 19, 10 May 2004, pp3906).

Die Solarzellen PV1 & PV2 werden ähnlich wie OLED1-3 hergestellt, außer:

1) Die Zwischenschicht wurde weggelassen;
2) Die EML wurde durch den wie in Tabelle 3 angezeigte aktive Schicht ersetzt;
3) Als Kathode wurde nur 150 nm Al verwendet.

Tabelle 3: Die Kompositionen in der aktiven Schicht in PVs

| Device | Kompositionen [wt%] | EML Dicke | Konzentration [g/l] | PCE (%) |
|---|---|---|---|---|
| PV1 | 40%HIL-012:40%PCBM:5%S2 | 200 nm | ca. 24 | 0.55% |
| PV2 | 40%HIL-012:40%PCBM:5%E2 | 200 nm | ca. 24 | 0.86% |

[6,6]-Phenyl C61 Buttersäuremethylester (PCBM) wurde von Sigma-Aldrich gekauft.

Photovoltaische Kennlinien von PV1 und PV2 werden unten Bestrahlung von AM1.5 (1000 W/$m^2$) gemessen. Die power conversion efficiency (PCE) wurde ausgerechnet und in Tabelle 3 aufgelistet. Durch Verwendung von E2, kann man die PCE von PV1 fast um 40% verbessern. Der mögliche Grund dafür ist, dass mit E2 auch Photonen im blauen Bereich genutzt werden können. Auf der Grundlage der vorliegenden erfindungsgemäßen technischen Lehre können weitere Optimierungen mittels unterschiedlicher Möglichkeiten realisiert werden ohne dabei erfinderisch zu sein. So kann eine weitere Optimierung bspw. durch die Verwendung andere Loch-Transportmaterialien oder gemischten Matricen in der gleichen oder einer anderen Konzentration erreicht werden.

**Patentansprüche**

**1.** Verbindung der allgemeinen Formel (1):

$$(S\text{-}A)_n\text{-}T \qquad \text{Formel (1),}$$

wobei die verwendeten Symbole und Indices die folgende Bedeutung haben:

S ist bei jedem Auftreten unabhängig voneinander eine monovalente Gruppe, die eine absorbierende Gruppe, die als Farbstoff wirkt, umfasst;
T ist eine n-valente Gruppe, die eine phosphoreszierende Emittereinheit umfasst;
A stellt bei jedem Auftreten unabhängig voneinander eine kovalente Einfachbindung oder eine bivalente Einheit dar;
n ist eine ganze Zahl, die größer oder gleich 1 ist,

wobei die absorbierende Gruppe vorzugsweise ausgewählt ist aus den folgenden Verbindungen der Formeln (237), (238) und (239)

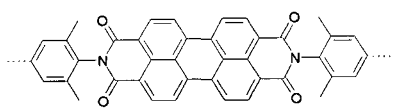

Formel (237)

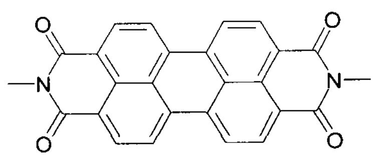

Formel (238)

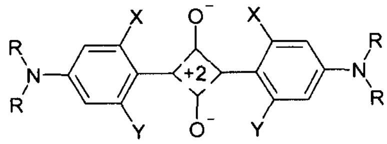

Formel (239)

wobei

R ist bei jedem Auftreten gleich oder verschieden aus der Gruppe ausgewählt, die aus Alkyl(en), Cycloalkyl(en), Alkylsilyl(en), Silyl(en), Arylsilyl(en), Alkylalkoxyalkyl(en), Arylalkoxyalkyl(en), Alkylthioalkyl(en), Phosphin, Phosphinoxid, Sulfon, Alkylensulfon, Sulfoxid und Alkylen-sulfoxid besteht, wobei die Alkyl(en)gruppe jeweils unabhängig voneinander 1 bis 12 C-Atome aufweist und wobei ein oder mehrere H-Atome durch F, Cl, Br, I, Alkyl oder Cycloalkyl, wobei ein oder mehrere $CH_2$ durch ein Heteroatom, wie NH, O oder S, ersetzt sein können, oder einem aromatischen oder heteroaromatischen Kohlenwasserstoffrest mit 5 bis 20 aromatischen Ringatomen ersetzt sein können;

X und Y bei jedem Auftreten gleich oder verschieden ein Rest ist, ausgewählt aus H, Halogen, Alkyl, Alkoxyalkyl, Alkylsilyl, Silyl, Alkylalkoxyalkyl Gruppen.

2. Verbindung nach Anspruch 1, **dadurch gekennzeichnet, dass** die phosphoreszierende Emittereinheit eine Metall-Ligand-Koordinationsverbindung ist.

3. Verbindung nach Anspruch 2, **dadurch gekennzeichnet, dass** die Metall-Ligand-Koordinationsverbindung ein Übergangsmetall-Atom oder ein Seltenerdmetall-Atom umfasst.

4. Verbindung nach Anspruch 2 oder 3, **dadurch gekennzeichnet, dass** die Metall-Ligand-Koordinationsverbindung ein Metall umfasst, das aus der Gruppe ausgewählt ist, die aus Ir, Zn, Cu, Os, Ru, Pd, Pt, Re, Au, Mo, W, Rh und Eu besteht.

5. Verbindung nach einem oder mehreren der Ansprüche 1 bis 4, **dadurch gekennzeichnet, dass** S ein substituiertes oder nichtsubstituiertes aromatisches oder heteroaromatisches Ringsystem ist.

6. Verbindung nach einem oder mehreren der Ansprüche 1 bis 5, **dadurch gekennzeichnet, dass** die bivalente Einheit eine konjugationsunterbrechende Einheit ist.

7. Verbindung nach Anspruch 6, **dadurch gekennzeichnet, dass** die konjugationsunterbrechende Einheit eine der folgenden bivalenten Einheiten ist:

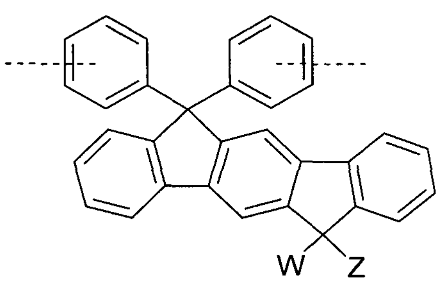

Formel (270)

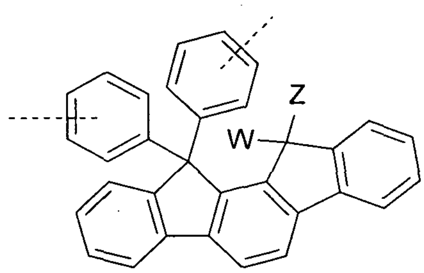

Formel (271)

worin die gestrichelten Linien Bindungen zu den Gruppen S und T darstellen und W und Z unabhängig voneinander aus der Gruppe ausgewählt sind, die aus H, F, $C_{1-40}$-Alkyl, $C_{2-40}$-Alkenyl, $C_{2-40}$-Alkinyl, einem substituierten oder unsubstituierten aromatischen oder heteroaromatischen Kohlenwasserstoffrest mit 5 bis 60 Ringatomen besteht.

8. Verbindung nach einem oder mehreren der Ansprüche 1 bis 7, **dadurch gekennzeichnet, dass** n gleich 1, 2 oder

3, bevorzugt 2 oder 1 und ganz besonders bevorzugt 1 ist.

9. Verbindung nach einem oder mehreren der Ansprüche 1 bis 8, **dadurch gekennzeichnet, dass** eine Emissionsbande der phosphoreszierenden Emittereinheit ein Emissionsmaximum im Wellenlängenbereich von 400 bis 600 nm aufweist.

10. Verwendung einer Verbindung gemäß einem oder mehreren der Ansprüche 1 bis 9 in einer elektronischen Vorrichtung, die ausgewählt ist aus den organischen Solarzellen (O-SCs), farbstoffsensibilisierten organischen Solarzellen (DSSCs).

11. Elektronische Vorrichtung enthaltend eine Verbindung gemäß einem der Ansprüche 1 bis 9, ausgewählt aus der Gruppe bestehend aus organischen Solarzellen (O-SCs) und farbstoffsensibilisierten organischen Solarzellen (DSSCs).

12. Formulierung, insbesondere eine Lösung, Dispersion oder Emulsion, enthaltend mindestens eine Verbindung nach einem oder mehreren der Ansprüche 1 bis 9 und mindestens ein Lösungsmittel.

## Claims

1. Compound of the general formula (1):

$$(S\text{-}A)_n\text{-}T \qquad \text{formula (1),}$$

where the symbols and indices used have the following meaning:

S is on each occurrence, independently of one another, a monovalent group which contains an absorbing group which acts as dye;
T is an n-valent group which contains a phosphorescent emitter unit;
A represents on each occurrence, independently of one another, a single covalent bond or a divalent unit;
n is an integer which is greater than or equal to 1,

where the absorbing group is preferably selected from the following compounds of the formulae (237), (238) and (239)

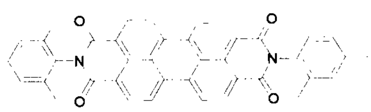

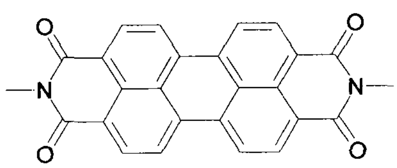

formula (237) formula (238)

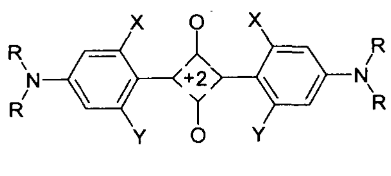

formula (239)

where where

R is selected on each occurrence, identically or differently, from the group consisting of alkyl(ene), cycloalkyl(ene), alkylsilyl-(ene), silyl(ene), arylsilyl(ene), alkylalkoxyalkyl(ene), arylalkoxyalkyl(ene), alkylthioalkyl(ene), phosphine, phosphine oxide, sulfone, alkylene sulfone, sulfoxide and alkylene sulfoxide, where the

alkyl(ene) group in each case, independently of one another, has 1 to 12 C atoms and where one or more H atoms may be replaced by F, Cl, Br, I, alkyl or cycloalkyl, where one or more $CH_2$ may be replaced by a heteroatom, such as NH, O or S, or may be replaced by an aromatic or heteroaromatic hydrocarbon radical having 5 to 20 aromatic ring atoms;
X and Y are on each occurrence, identically or differently, a radical selected from H, halogen, alkyl, alkoxyalkyl, alkylsilyl, silyl, alkylalkoxyalkyl groups.

**2.** Compound according to Claim 1, **characterised in that** the phosphorescent emitter unit is a metal-ligand coordination compound.

**3.** Compound according to Claim 2, **characterised in that** the metal-ligand coordination compound contains a transition-metal atom or a rare-earth metal atom.

**4.** Compound according to Claim 2 or 3, **characterised in that** the metal-ligand coordination compound contains a metal selected from the group consisting of Ir, Zn, Cu, Os, Ru, Pd, Pt, Re, Au, Mo, W, Rh and Eu.

**5.** Compound according to one or more of Claims 1 to 4, **characterised in that** S is a substituted or unsubstituted aromatic or heteroaromatic ring system.

**6.** Compound according to one or more of Claims 1 to 5, **characterised in that** the divalent unit is a conjugation-interrupting unit.

**7.** Compound according to Claim 6, **characterised in that** the conjugation-interrupting unit is one of the following divalent units:

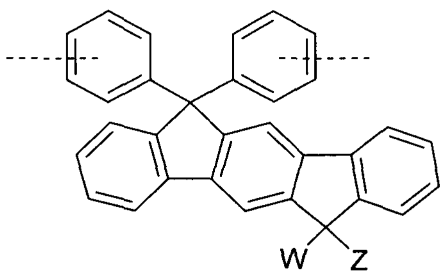

formula (270)

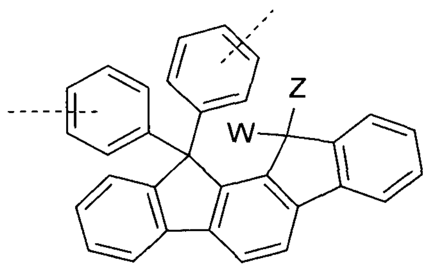

formula (271)

in which the dashed lines represent bonds to the groups S and T, and W and Z are selected, independently of one another, from the group consisting of H, F, $C_{1-40}$-alkyl, $C_{2-40}$-alkenyl, $C_{2-40}$-alkynyl, a substituted or unsubstituted aromatic or heteroaromatic hydrocarbon radical having 5 to 60 ring atoms.

**8.** Compound according to one or more of Claims 1 to 7, **characterised in that** n is equal to 1, 2 or 3, preferably 2 or 1 and very particularly preferably 1.

**9.** Compound according to one or more of Claims 1 to 8, **characterised in that** an emission band of the phosphorescent emitter unit has an emission maximum in the wavelength range from 400 to 600 nm.

**10.** Use of a compound according to one or more of Claims 1 to 9 in an electronic device which is selected from organic solar cells (O-SCs) and dye-sensitised organic solar cells (DSSCs).

**11.** Electronic device containing a compound according to one of Claims 1 to 9, selected from the group consisting of organic solar cells (O-SCs) and dye-sensitised organic solar cells (DSSCs).

**12.** Formulation, in particular a solution, dispersion or emulsion, comprising at least one compound according to one or more of Claims 1 to 9 and at least one solvent.

## Revendications

**1.** Composé de la formule générale (1) :

$(S\text{-}A)_n\text{-}T$ formule (1),

formule dans laquelle les symboles et indices qui sont utilisés présentent la signification qui suit :

S est pour chaque occurrence, indépendamment les unes des autres, un groupe monovalent qui contient un groupe absorbant qui joue le rôle de colorant ;
T est un groupe de valence n qui contient une unité d'émetteur phosphorescente ;
A représente pour chaque occurrence, indépendamment les unes des autres, une unique liaison covalente ou une unité divalente ;
n est un entier qui est supérieur ou égal à 1,

dans lequel le groupe absorbant est de préférence sélectionné parmi les composés qui suivent des formules (237), (238) et (239) :

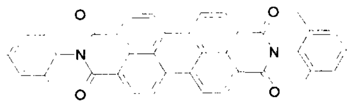

formule (237)

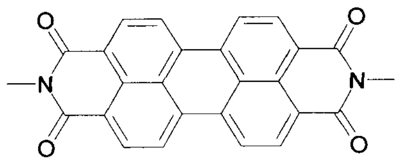

formule (238)

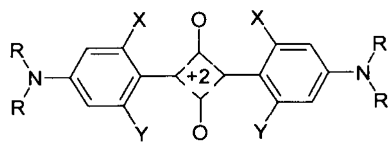

formule (239)

formules dans lesquelles :

R est sélectionné pour chaque occurrence, de manière identique ou différente, parmi le groupe qui est constitué par alkyle/alkylène, cycloalkyle/cycloalkylène, alkylsilyle/alkylsilylène, silyle/silylène, arylsilyle/arylsilylène, alkylalcoxyalkyle/alkylalcoxyalkylène, arylalcoxyalkyle/arylalcoxyalkylène, alkylthioalkyle/alkylthioalkylène, phosphine, oxyde de phosphine, sulfone, alkylène sulfone, sulfoxyde et alkylène sulfoxyde, où le groupe alkyle/alkylène, dans chaque cas, indépendamment des autres, comporte 1 à 12 atome(s) de C et où un ou plusieurs atome(s) de H peut/peuvent être remplacé(s) par F, Cl, Br, I, alkyle ou cycloalkyle, où un ou plusieurs groupe(s) $CH_2$ peut/peuvent être remplacé(s) par un hétéroatome, tel que NH, O ou S, ou peut/peuvent être remplacé(s) par un radical hydrocarbone aromatique ou hétéroaromatique qui comporte 5 à 20 atomes de cycle aromatique ;
X et Y sont pour chaque occurrence, de manière identique ou différente, un radical qui est sélectionné parmi H, des groupes halogène, alkyle, alcoxyalkyle, alkylsilyle, silyle, alkylalcoxyalkyle.

**2.** Composé selon la revendication 1, **caractérisé en ce que** l'unité d'émetteur phosphorescente est un composé de coordination métal-ligand.

**3.** Composé selon la revendication 2, **caractérisé en ce que** le composé de coordination métal-ligand contient un atome de métal de transition ou un atome de métal des terres rares.

**4.** Composé selon la revendication 2 ou 3, **caractérisé en ce que** le composé de coordination métal-ligand contient

un métal qui est sélectionné parmi le groupe qui est constitué par Ir, Zn, Cu, Os, Ru, Pd, Pt, Re, Au, Mo, W, Rh et Eu.

5. Composé selon une ou plusieurs des revendications 1 à 4, **caractérisé en ce que** S est un système de cycle aromatique ou hétéroaromatique substitué ou non substitué.

6. Composé selon une ou plusieurs des revendications 1 à 5, **caractérisé en ce que** l'unité divalente est une unité induisant une interruption de la conjugaison.

7. Composé selon la revendication 6, **caractérisé en ce que** l'unité induisant une interruption de la conjugaison est l'une des unités divalentes qui suivent :

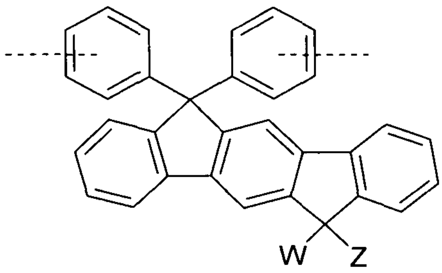

formule (270)

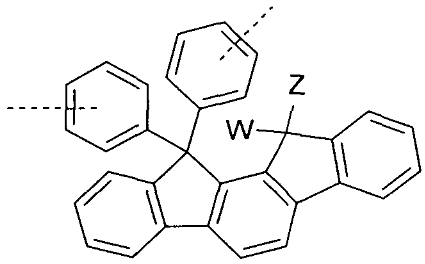

formule (271)

formules dans lesquelles les lignes en pointillés représentent des liaisons sur les groupes S et T, et W et Z sont sélectionnés, indépendamment l'un de l'autre, parmi le groupe qui est constitué par H, F, $C_{1-40}$-alkyle, $C_{2-40}$-alkényle, $C_{2-40}$-alkynyle, un radical hydrocarbone aromatique ou hétéroaromatique substitué ou non substitué qui comporte 5 à 60 atomes de cycle.

8. Composé selon une ou plusieurs des revendications 1 à 7, **caractérisé en ce que** n est égal à 1, 2 ou 3, de préférence 2 ou 1 et de façon très particulièrement préférable 1.

9. Composé selon une ou plusieurs des revendications 1 à 8, **caractérisé en ce qu'**une bande d'émission de l'unité d'émetteur phosphorescente présente un maximum d'émission dans la plage de longueurs d'onde de 400 à 600 nm.

10. Utilisation d'un composé selon une ou plusieurs des revendications 1 à 9 dans un dispositif électronique qui est sélectionné parmi les cellules solaires organiques (O-SC) et les cellules solaires organiques sensibilisées par colorant(s) (DSSC).

11. Dispositif électronique contenant un composé selon l'une des revendications 1 à 9, sélectionné parmi le groupe qui est constitué par les cellules solaires organiques (O-SC) et les cellules solaires organiques sensibilisées par colorant(s) (DSSC).

12. Formulation, en particulier une solution, une dispersion ou une émulsion, comprenant au moins un composé selon une ou plusieurs des revendications 1 à 9 et au moins un solvant.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 9013148 A1
- US 2010133992 A1
- WO 007065 A
- WO 0141512 A
- WO 0202714 A
- WO 0215645 A
- EP 1191613 A
- EP 1191612 A
- EP 1191614 A
- WO 05033244 A
- US 2009000658 A
- WO 2009107100 A
- WO 2009098643 A
- US 6245988 B
- WO 2010055471 A
- JP 2010084003 A
- EP 1622178 A
- WO 9850393 A
- WO 9529924 A
- WO 9404497 A
- WO 9214741 A
- WO 9116719 A
- US 20060222886 A
- US 5121029 A
- US 5130603 A
- US 20070092753 A1
- WO 2006122630 A
- WO 2008006449 A
- WO 2007140847 A
- WO 2006000388 A
- WO 2006058737 A
- WO 2006000389 A
- WO 2007065549 A
- WO 2007115610 A
- US 20070122656 A1
- US 7250532 B2
- DE 102005058557 A1
- CN 1583691 A
- JP 08053397 A
- US 6251531 B1
- US 2006210830 A
- EP 1957606 A1
- US 20080113101 A1
- US 20070252517 A1
- US 4769292 A
- US 6020078 A
- JP 6001973 A
- WO 2004047499 A
- WO 2006098080 A
- WO 2007065678 A
- US 20050260442 A
- WO 2004092111 A
- DE 102009023156
- WO 2005055248 A1
- WO 2005039246 A
- US 20050069729 A
- JP 2004288381 A
- EP 1205527 A
- WO 2008086851 A
- EP 1617710 A
- EP 1617711 A
- EP 1731584 A
- JP 2005347160 A
- WO 2004093207 A
- DE 102008033943
- WO 2005003253 A
- WO 2007137725 A
- WO 2005111172 A
- DE 102008017591
- WO 2006117052 A
- DE 102008036982
- WO 2007063754 A
- WO 2008056746 A
- DE 102009023155
- DE 102009031021
- DE 102009022858
- US 20070134514 A1
- US 20050249976 A
- US 20070128467 A
- US 004209115 A
- US 20040209116 A
- US 20070087219 A
- EP 652273 A
- US 6538375 B
- US 20030099858 A
- EP 10002558 A
- WO 2005011013 A
- WO 2005121274 A
- JP 2005015508 A
- WO 2004037887 A2

**In der Beschreibung aufgeführte Nicht-Patentliteratur**


- **FORREST.** *Nature,* 1998, vol. 395, 151
- **FORREST et al.** *Nature,* 2000, vol. 403 (6771), 750-753
- **T. FÖRSTER.** Zwischenmolekulare Energiewanderung und Fluoreszenz. *Ann. Physic.,* 1948, vol. 437, 55
- **D. L. DEXTER.** *J. Chem. Phys.,* 1953, vol. 21, 836
- *J. Phys. Chem. C,* vol. 09 (113), 2966-2973
- **C.H. CHEN et al.** Recent developments in organic electroluminescent materials. *Macromol. Symp.,* 1997, vol. 125, 1-48
- Recent progress of molecular organic electroluminescent materials and devices. *Mat. Sci. and Eng. R,* 2002, vol. 39, 143-222
- **CROWLEY, J. D. ; TEAGUE, G. S. JR. ; LOWE, J. W. JR.** *Journal of Paint Technology,* 1966, vol. 38 (496), 296
- **SOLVENTS, W.H. ELLIS.** *Federation of Societies for Coatings Technology,* 1986, 9-10
- **H. GILMAN ; E.A. ZUECH.** *Chemistry&Industry,* 1960, 120
- **BRENNDAN O'CONNOR et al.** *Adv. Mater.,* 2007, vol. 19, 3897-3900
- **M. S. ARNOLD et al.** *Appl. Phys. Lett.,* 2008, vol. 92, 053301
- **KOLLER et al.** *Nature Photonics,* vol. 08 (2), 684-687
- **MUCCINI et al.** *Nature Materials,* 2010, vol. 9, 496-503
- Organic Photoreceptors for Xerography. Marcel Dekker, Inc, 1998
- **Z. H. XIONG et al.** *Nature,* 2004, vol. 727, 821
- *Pei & Heeger in Science,* vol. 95 (269), 1086-1088
- **O'REGAN ; GRÄTZEL.** *Nature,* vol. 91 (353), 737-740
- *Nature,* vol. 98 (395), 583-585
- **BALDO et al.** *Science,* 2008, vol. 321, 226
- *J. Am. Chem Soc.,* 2001, vol. 123, 4304
- *Journal Phys. Chem. C,* 2007, vol. 111, 4861
- *Appl. Phys. Lett.,* 10. Mai 2004, vol. 84 (19), 3906